(19) Europäisches Patentamt
European Patent Office
Office européen des brevets

(11) EP 2 858 099 A1

(12) EUROPEAN PATENT APPLICATION
published in accordance with Art. 153(4) EPC

(43) Date of publication:
**08.04.2015 Bulletin 2015/15**

(21) Application number: **13797955.5**

(22) Date of filing: **30.05.2013**

(51) Int Cl.:
***H01L 21/368*** *(2006.01)* ***H01L 21/336*** *(2006.01)*
***H01L 29/786*** *(2006.01)* ***H01L 51/42*** *(2006.01)*

(86) International application number:
**PCT/JP2013/065078**

(87) International publication number:
**WO 2013/180230 (05.12.2013 Gazette 2013/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.06.2012 JP 2012126227**
**27.09.2012 JP 2012214659**

(71) Applicant: **Mitsubishi Chemical Corporation**
**Chiyoda-ku**
**Tokyo 100-8251 (JP)**

(72) Inventors:
- **OTSUBO Saika**
  **Yokohama-shi, Kanagawa 227-8502 (JP)**
- **ARAMAKI Shinji**
  **Yokohama-shi, Kanagawa 227-8502 (JP)**
- **YAMAZAKI Masanori**
  **Yokohama-shi, Kanagawa 227-8502 (JP)**
- **YAMAUCHI Ritsuko**
  **Yokohama-shi, Kanagawa 227-8502 (JP)**
- **TAKEI Izuru**
  **Yokohama-shi, Kanagawa 227-8502 (JP)**
- **YOKOYAMA Takamichi**
  **Yokohama-shi, Kanagawa 227-8502 (JP)**
- **SATO Yoshiharu**
  **Yokohama-shi, Kanagawa 227-8502 (JP)**

(74) Representative: **Ter Meer Steinmeister & Partner**
**Patentanwälte mbB**
**Mauerkircherstrasse 45**
**81679 München (DE)**

# (54) METHOD FOR PRODUCING METAL OXIDE-CONTAINING SEMICONDUCTOR LAYER AND ELECTRONIC DEVICE

(57) A method for producing a semiconductor layer containing a metal oxide, which comprises: coating an ink containing a metal salt of unsaturated carboxylic acid represented by the formula (I) on a base material; and conducting a heat treatment after the coating (In the formula (I), $R^1$, $R^2$ and $R^3$ are each independently hydrogen atom or an arbitrary substituent, M is an m-valent metal atom, and m is an integer of 2 to 5, and m "$CR^1R^2=CR^3-COO^-$ "s may be the same as or different from each other).

[Chem. 1]

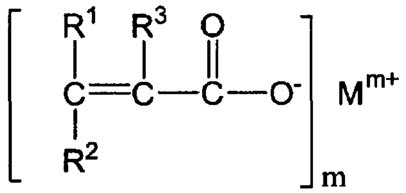

(I)

EP 2 858 099 A1

[Fig. 1]

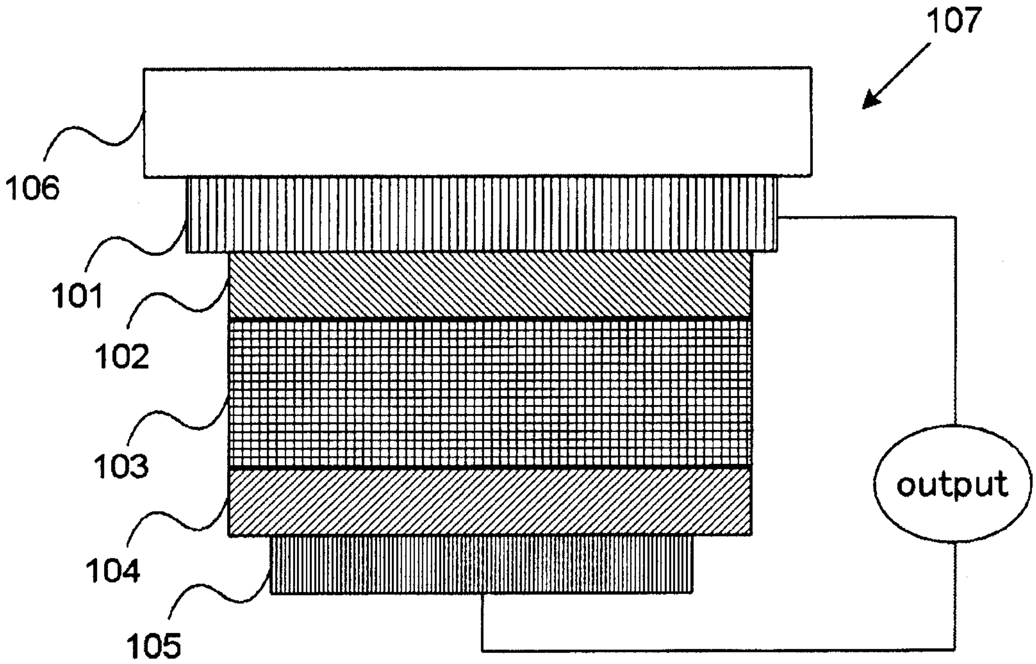

## Description

Technical Field

The present invention relates to a method for producing a semiconductor layer containing a metal oxide and an electronic device.

Background Art

Recently, an electronic device using a metal oxide has been developed widely as the next generation device of the electronic device using silicon. Especially, a field effect transistor and a solar cell have been developed widely. An electronic device using a metal oxide generally contains a semiconductor layer containing a metal oxide. Improvement of the properties of such a semiconductor layer containing a metal oxide is advantageous to improve the properties of the electronic device. Moreover, in order to cut the production costs of the electronic device, it is effective that the semiconductor layer containing a metal oxide can be produced more easily.

NPL 1, for example, describes a field effect transistor (FET) obtained using a metal oxide as the material for the semiconductor layer. In NPL 1, the oxide semiconductor layer is formed by a sol gel method using an ink containing zinc acetate. In this method, heating at 300°C to 500°C is required.

An organic photovoltaic (OPV) cell using an organic semiconductor, which has been developed as the next generation solar cell of the solar cell, generally has a structure in which an active layer has been interposed between a pair of electrodes, but a buffer layer is sometimes further provided between the electrode and the active layer. A buffer layer is generally classified into an electron extraction layer and a hole extraction layer. Especially, OPV using a metal oxide such as zinc oxide (ZnO) as the material for the electron extraction layer is reported.

For example, NPL 2 to NPL 4 describe OPV using a zinc oxide (ZnO) layer as the electron extraction layer. As methods for forming the zinc oxide layer, NPL 2 describes a sol gel method in which the zinc oxide layer is formed through zinc hydroxide from zinc acetate as the raw material and a method in which a dispersion of zinc oxide suspended in acetone is coated. As a method for forming the zinc oxide layer, NPL 3 describes a method in which zinc oxide dispersed with 2-methoxyethoxy acetic acid (MEA) is coated. In addition, NPL 4 describes a method for forming the zinc oxide layer by converting a zinc acetylacetonate complex into zinc oxide.

Furthermore, a dye-sensitized solar cell in which a metal oxide layer produced from a metal monocarboxylate has been interposed between an electrode and an oxide semiconductor layer is described in PTL 1. Heating at 500°C is required for forming the metal oxide layer. In addition, although PTL 2 describes that an n-type metal oxide semiconductor is formed by the decomposition of a metal salt of an aliphatic acid, heating at 300 to 400°C is required also for the production method thereof.

Moreover, NPL 5 describes that particles of zinc oxide are synthesized from zinc diacrylate and a film containing zinc oxide can be produced from a paste containing the zinc oxide particles.

Citation List

Patent Literature

PTL 1: JP-A-2008-071585

PTL 2: WO2012/046326

Non Patent Literature

NPL 1: IEEE Electron Device Letters 2010, 31, 311.
NPL 2: Appl. Phys. Lett. 2008, 92, 253301.
NPL 3: Sol. Energy Mater. Sol. Cells 2010, 94, 2018.
NPL 4: Org. Electronics 2012, 13, 1136.
NPL 5: J. Mater. Res. 2004, 19, 651.

Summary of Invention

Technical Problem

According to the study of the present inventors, it was found to be difficult to produce a metal oxide layer by the sol gel method described in NPL 1 or 2 in an industrial production process. That is, the sol gel method using zinc acetate requires heating at high temperature of 300°C or higher and thus it is difficult to apply this method to a more practical production process, such as a roll-to-roll method, which requires the use of a flexible base material with low heat resistance. In addition, the metal organic compound decomposition (MOD) method for producing a metal oxide film from a metal monocarboxylate described in PTL 1 or 2 generally requires heating at high temperature of 300°C or higher and thus it is difficult to apply this method to an industrial production process.

Here, in order to improve the properties of an electronic device, it is generally required to make the thickness of the semiconductor layer even. However, the conventional sol gel method and MOD method require heating at high temperature and thus have their drawbacks of the evenness inferior to that of a vacuum film-forming method such as a sputtering method.

A vacuum film-forming method such as a sputtering method also has its drawback in view of its high cost and the generation of a polycrystalline material with strong c-axis orientation in case of zinc oxide.

Moreover, when a more practical production process such as a roll-to-roll method is used, a semiconductor layer with high hardness is preferable because the semiconductor layer is less likely to receive mechanical damage and the yield is likely to be improved.

However, the metal oxide layer formed by the method in which a zinc oxide dispersion is coated, which is described in NPL 2 or 3, has its drawback because the evenness and hardness of the film are insufficient. Furthermore, even by the method of NPL 4, in which a zinc acetylacetonate complex with relatively-low decomposition temperature of about 120°C is used, it is still difficult to produce a metal oxide film with high evenness and hardness. In addition, the method of NPL 5, in which a paste containing zinc oxide particles synthesized from zinc diacrylate is used, also has its drawback because the evenness and hardness of the obtained film are insufficient as in the method in which a zinc oxide dispersion is coated.

An object of the invention is to produce a semiconductor layer containing a metal oxide with high evenness, high mechanical strength and excellent properties by a practical method.

Solution to Problem

As a result of the intensive study in view of the above circumstances, the inventors found that it is possible to produce a semiconductor layer which contains a metal oxide as the main component and which is moderately hard and excellent in the evenness of the film, by using an ink containing a specific metal salt of unsaturated carboxylic acid. The inventors also found that an electronic device with both high mechanical strength and excellent properties can be produced easily at low temperature in a short time, by using the semiconductor layer, and thus completed the invention.

That is, the gist of the invention is as follows.

[1] A method for producing a semiconductor layer containing a metal oxide, which comprises: coating an ink containing a metal salt of unsaturated carboxylic acid represented by the formula (I) on a base material; and conducting a heat treatment after the coating.

[Chem. 1]

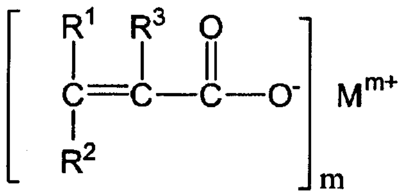

(I)

(In the formula (I), $R^1$, $R^2$ and $R^3$ are each independently hydrogen atom or an arbitrary substituent, M is an m-valent metal atom, and m is an integer of 2 to 5, and m "$CR^1R^2=CR^3-COO^-$"s may be the same as or different from each other.)

[2] The method for producing a semiconductor layer containing a metal oxide according to [1], wherein the number of the carbon atoms forming the metal salt of unsaturated carboxylic acid is 3 to 12.

[3] The method for producing a semiconductor layer containing a metal oxide according to [1] or [2], wherein the boiling point of the unsaturated carboxylic acid constituting the metal salt of unsaturated carboxylic acid is 139°C or higher and lower than 300°C.
[4] The method for producing a semiconductor layer containing a metal oxide according to any one of [1] to [3], wherein $R^1$, $R^2$ and $R^3$ in the formula (I) are each independently hydrogen atom or an alkyl group which may be substituted.
[5] The method for producing a semiconductor layer containing a metal oxide according to any one of [1] to [4], wherein $R^1$, $R^2$ and $R^3$ in the formula (I) are each hydrogen atom.
[6] The method for producing a semiconductor layer containing a metal oxide according to any one of [1] to [5], wherein M in the formula (I) is a transition metal atom selected from the elements in group 4 in the periodic table, or a metal atom selected from the elements in group 12 in the periodic table, the elements in group 13 in the periodic table and the elements in group 14 in the periodic table.
[7] The method for producing a semiconductor layer containing a metal oxide according to any one of [1] to [6], wherein M in the formula (I) is zinc atom.
[8] The method for producing a semiconductor layer containing a metal oxide according to any one of [1] to [7], wherein the heat treatment is conducted at 100°C or higher and lower than 300°C.
[9] The method for producing a semiconductor layer containing a metal oxide according to any one of [1] to [8], wherein the base material is a resin base material.
[10] The method for producing a semiconductor layer containing a metal oxide according to any one of [1] to [9], wherein the heat treatment step is conducted under an atmosphere in which the humidity is more than 1% and 80% or less when the temperature is set at 25°C.
[11] An electronic device which comprises the semiconductor layer containing a metal oxide obtained by the production method described in any one of [1] to [10].
[12] A field effect transistor which comprises the semiconductor layer containing a metal oxide obtained by the production method described in any one of [1] to [10].
[13] A photoelectric conversion element which comprises the semiconductor layer containing a metal oxide obtained by the production method described in any one of [1] to [10].
[14] A photoelectric conversion element for a solar cell, which comprises the semiconductor layer containing a metal oxide obtained by the production method described in any one of [1] to [10].
[15] A photoelectric conversion element which comprises at least a pair of electrodes, an active layer interposed between the electrodes, and a buffer layer interposed between the active layer and one of the electrodes, wherein the buffer layer contains the semiconductor layer containing a metal oxide obtained by the production method described in any one of [1] to [10].
[16] The photoelectric conversion element according to [15], wherein the buffer layer is an electron extraction layer.
[17] A solar cell which comprises the photoelectric conversion element described in any one of [13] to [16].
[18] A solar cell module which comprises the solar cell described in [17].
[19] A semiconductor layer containing zinc oxide, which has an average roughness relative to the thickness of less than 10%, and a half-width of the 2θ peak corresponding to the (002) plane in a thin-film X-ray diffraction (XRD) method (an out of plane measurement) of 1° or more.

Advantageous Effects of Invention

According to the invention, it is possible to produce a semiconductor layer containing a metal oxide with high evenness, high mechanical strength and excellent properties by a practical method suitable as an industrial process.

Brief Description of Drawings

[Fig. 1] Fig. 1 is a cross-sectional figure schematically showing the structure of a photoelectric conversion element as an embodiment of the invention.
[Fig. 2] Fig. 2 is a cross-sectional figure schematically showing the structure of a solar cell as an embodiment of the invention.
[Fig. 3] Fig. 3 is a cross-sectional figure schematically showing the structure of a solar cell module as an embodiment of the invention.
[Fig. 4] Fig. 4 (A) to (D) are cross-sectional figures schematically showing structures of a field effect transistor as an embodiment of the invention.
[Fig. 5] Fig. 5 shows the thin-film X-ray diffraction (XRD) spectra of the semiconductor films containing zinc oxide

measured in Example 1-1 and Comparative Examples 1-1 to 1-3.

[Fig. 6] Fig. 6 shows the thin-film X-ray diffraction (XRD) spectrum of the semiconductor film containing zinc oxide measured in Example 1-1.

[Fig. 7] Fig. 7 shows the thin-film X-ray diffraction (XRD) spectrum of the semiconductor film containing zinc oxide measured in Comparative Example 1-3.

Description of Embodiments

Embodiments of the invention are explained in detail below. The explanations for the constituent features described below are examples (representative examples) of the embodiments of the invention and the invention is not limited to these contents as long as it does not go beyond its gist.

In the present specification, "% by mass" is synonymous with "% by weight".

<1. Semiconductor layer containing metal oxide>

The semiconductor layer containing a metal oxide of the invention (hereinafter sometimes referred to as the semiconductor layer of the invention) is produced by a production method (hereinafter sometimes referred to as the method for producing the semiconductor layer containing a metal oxide of the invention) containing a coating step for coating an ink containing the metal salt of unsaturated carboxylic acid represented by the general formula (I) ((hereinafter sometimes referred to as the metal salt of unsaturated carboxylic acid of the invention).

[Chem. 2]

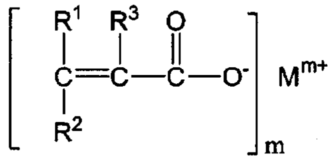

(I)

(In the formula (I), $R^1$, $R^2$ and $R^3$ are independently hydrogen atom or an arbitrary substituent; M is an m-valent metal atom; and m is an integer of 2 to 5. m $CR^1R^2=CR^3-COO^-$ molecules may be the same as or different from each other.)

<1.1. Metal salt of unsaturated carboxylic acid>

The metal salt of unsaturated carboxylic acid represented by the formula (I) is a metal salt of an α,β-unsaturated carboxylic acid, and is a metal dicarboxylate (m=2), a metal tricarboxylate (m=3), a metal tetracarboxylate (m=4) or a metal pentacarboxylate (m=5).

According to the method of the invention, the semiconductor layer containing a metal oxide is obtained from the metal salt of unsaturated carboxylic acid. Because the metal oxide is thought to contribute to the semiconducting properties of the semiconductor layer, the ratio of the metal atom in the metal salt of unsaturated carboxylic acid is preferably high and specifically, m is preferably 3 or smaller. On the other hand, m is preferably 2 or larger, in order that the metal salt of unsaturated carboxylic acid would be converted into the metal oxide at not-too-high temperature, because the bond between the carboxylic acid and the metal atom becomes weak. Thus, the metal salt of unsaturated carboxylic acid is preferably a metal dicarboxylate or a metal tricarboxylate, and is particularly preferably a metal dicarboxylate because the conversion at adequate temperature is possible.

In the formula (I), M is a divalent to pentavalent metal atom. Specifically, as the divalent metal atom, a divalent transition metal atom such as titanium(II) atom, vanadium(II) atom, chromium(II) atom, manganese(II) atom, iron(II) atom, cobalt(II) atom, nickel(II) atom and copper(II) atom; and a divalent main group metal atom such as zinc(II) atom, tin(II) atom and lead(II) atom are mentioned. As the trivalent metal atom, a trivalent transition metal atom such as scandium(III) atom, titanium(III) atom, chromium(III) atom, manganese(III) atom, iron(III) atom and cobalt(III) atom; and a trivalent main group metal atom such as aluminum(III) atom, gallium(III) atom and indium(III) atom are mentioned. As the tetravalent metal atom, titanium(IV) atom, tin(IV) atom, lead(IV) atom and the like are mentioned. As the pentavalent metal atom, vanadium(V) atom and the like are mentioned.

In the specification, the main group metal atoms mean the atoms of the metal elements in groups 12 to 18 in the periodic table. The transition metal atoms mean the atoms of the metal elements in groups 3 to 11 in the periodic table. In the specification, the periodic table means the periodic table of the recommendations of IUPAC 2005.

Among them, M is preferably a divalent or trivalent metal atom, because the metal salt of unsaturated carboxylic acid

acid represented by the formula (I) can be a metal dicarboxylate or a metal tricarboxylate. It is preferable that M is a divalent metal atom because the metal salt of unsaturated carboxylic acid represented by the formula (I) can be a metal dicarboxylate.

A preferable example of M is an atom which easily forms a metal carboxylate in particular. Specifically, a transition metal atom selected from the elements in group 4 in the periodic table, or a metal atom selected from the elements in group 12 in the periodic table, the elements in group 13 in the periodic table and the elements in group 14 in the periodic table is mentioned. As the metal atom selected from the elements in group 4 in the periodic table, scandium atom, titanium atom, vanadium atom, chromium atom, manganese atom, iron atom, cobalt atom, nickel atom or copper atom is preferably mentioned. As the metal atom selected from the elements in group 12 in the periodic table, zinc atom is preferably mentioned. As the metal atom selected from the elements in group 13 in the periodic table, indium atom, gallium atom or aluminum atom is preferably mentioned. As the metal atom selected from the elements in group 14 in the periodic table, tin atom, lead atom or the like is preferably mentioned. M is preferably titanium atom, vanadium atom, iron atom, nickel atom, copper atom, zinc atom, indium atom, gallium atom, aluminum atom or tin atom, because the carrier mobility of the corresponding metal oxide is high. Among them, titanium atom, nickel atom, copper atom, zinc atom, indium atom or tin atom is more preferable, and zinc atom is particularly preferable. Zinc atom is particularly preferable: because the solubility of a zinc unsaturated carboxylate is high, the film obtained by coating and film-forming an ink containing a zinc unsaturated carboxylate is highly even, and a zinc oxide film has excellent physical properties and high carrier mobility. In the specification, the carrier mobility means either the electron mobility or the hole mobility as described below.

$R^1$, $R^2$ and $R^3$ in the formula (I) are independently hydrogen atom or an arbitrary substituent. $R^1$, $R^2$ and $R^3$ are not particularly limited as long as the semiconductor layer of the invention has semiconducting properties. A preferable example thereof is a halogen atom, hydroxyl group, cyano group, nitrile group, amino group, a silyl group, a boryl group, an alkyl group, an alkenyl group, an alkynyl group, an alkoxy group, an aromatic hydrocarbon group or an aromatic heterocyclic group. The amino group, silyl group, boryl group, alkyl group, alkenyl group, alkynyl group, alkoxy group, aromatic hydrocarbon group or aromatic heterocyclic group may be substituted.

The halogen atom is preferably fluorine atom.

For example, the amino group is an aromatic substituted amino group such as diphenylamino group, ditolylamino group or carbazolyl group.

The silyl group is preferably a group having 2 to 20 carbon atoms, and for example is trimethylsilyl group or triphenylsilyl group.

For example, the boryl group is an aromatic substituted boryl group such as dimesitylboryl group.

The alkyl group is preferably a group having 1 to 20 carbon atoms and for example is methyl group, ethyl group, i-propyl group, t-butyl group or cyclohexyl group.

The alkenyl group is preferably a group having 2 to 20 carbon atoms and for example is vinyl group, styryl group or diphenylvinyl group.

The alkynyl group is preferably a group having 2 to 20 carbon atoms and for example is methylethynyl group, phenylethynyl group or trimethylsilylethynyl group.

The alkoxy group is preferably a group having 2 to 20 carbon atoms and for example is a linear or branched alkoxy group such as methoxy group, ethoxy group, n-propoxy group, i-propoxy group, n-butoxy group, i-butoxy group, ethylhexyloxy group, benzyloxy group or t-butoxy group.

The aromatic hydrocarbon group is preferably a group having 6 to 20 carbon atoms. The aromatic hydrocarbon group is any of a monocyclic aromatic hydrocarbon group, a condensed polycyclic aromatic hydrocarbon group and a linked-ring aromatic hydrocarbon group. For example, the monocyclic aromatic hydrocarbon group is phenyl group. For example, the condensed polycyclic aromatic hydrocarbon group is biphenyl group, phenanthryl group, naphthyl group, anthryl group, fluorenyl group, pyrenyl group or perylenyl group. For example, the linked-ring aromatic hydrocarbon group is biphenyl group or terphenyl group. Among them, phenyl group or naphthyl group is preferable.

The aromatic heterocyclic group is preferably a group having 2 to 20 carbon atoms. For example, pyridyl group, thienyl group, furyl group, oxazolyl group, thiazolyl group, oxadiazolyl group, benzothienyl group, dibenzofuryl group, dibenzothienyl group, pyradinyl group, pyrimidinyl group, pyrazolyl group, imidazolyl group or phenylcarbazolyl group is mentioned. Among them, pyridyl group, thienyl group, benzothienyl group, dibenzofuryl group, dibenzothienyl group or phenanthryl group is preferable.

In particular, because the strength of the bond between the unsaturated carboxylic acid ion and the metal atom becomes adequate and the formation of the semiconductor layer containing a metal oxide progresses smoothly, it is preferable that $R^3$ is hydrogen atom, and it is also preferable that at least one of $R^1$ and $R^2$ is hydrogen atom. It is also preferable that all of $R^1$, $R^2$ and $R^3$ are hydrogen atom. In addition, it is preferable that $R^1$ and $R^2$ are hydrogen atom or an alkyl group because a compound which may damage the semiconductor layer during the formation of the semiconductor layer containing a metal oxide is unlikely to be generated.

The unsaturated carboxylic acid constituting the metal salt of unsaturated carboxylic acid of the invention is

not particularly limited as long as it is an α,β-unsaturated carboxylic acid, namely a carboxylic acid in which a carboxyl group is directly bonded to one of the carbon atoms forming the carbon-carbon double bond (C=C). Specific Examples are unsaturated carboxylic acids such as acrylic acid, methacrylic acid, ethacrylic acid, itaconic acid, crotonic acid, isocrotonic acid, angelic acid, tiglic acid, 2-pentenoic acid, 2-hexenoic acid, 2-heptenoic acid, 2-octenoic acid, 2-nonenoic acid, 2-decenoic acid, 2-undecenoic acid, 2-dodecenoic acid, fumaric acid, maleic acid, citraconic acid, monomethyl maleate, monoethyl maleate, monobutyl maleate, monooctyl maleate, monomethyl itaconate, monoethyl itaconate, monobutyl itaconate, monooctyl itaconate, monomethyl fumarate, monoethyl fumarate, monobutyl fumarate, monooctyl fumarate, monomethyl citraconate, monoethyl citraconate, monobutyl citraconate and monooctyl citraconate. The unsaturated carboxylic acid having a carboxyl group bonded to the carbon atom forming the carbon-carbon double bond (C=C) has properties to easily cause thermal decomposition reaction such as decarbonation reaction at relatively-low temperature, and thus is suitable for obtaining the semiconductor layer of the invention efficiently at low temperature.

Among them, as described below, in order to make the reversible reaction of the formation of the metal carboxylate accompanied by dehydration and hydrolysis to proceed in the direction of hydrolysis, an α,β-unsaturated carboxylic acid with a boiling point lower than 300°C is preferable. An α,β-unsaturated carboxylic acid with a boiling point lower than 250°C is more preferable and an α,β-unsaturated carboxylic acid with a boiling point lower than 200°C is further preferable. The lower limit for the boiling point is preferably not less than the boiling point of acrylic acid (139°C), which is the simplest and smallest unsaturated carboxylic acid having one carbon-carbon double bond (C=C) and one carboxyl group.

One molecule of the metal salt of unsaturated carboxylic acid is constituted by m unsaturated carboxylic acid molecules. The m unsaturated carboxylic acid molecules may be the same as or different from each other. That is, the m $CR^1R^2{=}CR^3\text{-}COO^-$ molecules may be the same as or different from each other. Here, m represents an integer of 2 to 5.

In this regard, as it is seen from the above formula (I), the carbon number of the unsaturated carboxylic acid of the invention is 3 or larger, and the semiconductor layer containing a metal oxide is obtained from the metal salt of unsaturated carboxylic acid according to the method of the invention. If unreacted substances of the metal salt of unsaturated carboxylic acid remain too much in the film, the semiconducting properties of the semiconductor layer containing a metal oxide are thought to be influenced. Thus, in order that the reaction would progress with less energy, the number of the atoms forming the unsaturated carboxylic acid is as small as possible. From this viewpoint, the carbon number of the unsaturated carboxylic acid is preferably 12 or smaller and more preferably 6 or smaller and further preferably 4 or smaller. Specifically, a preferable unsaturated carboxylic acid is acrylic acid, methacrylic acid, ethacrylic acid, crotonic acid, itaconic acid, fumaric acid or maleic acid, and acrylic acid is particularly preferable. Acrylic acid is particularly preferable because it is the simplest and smallest unsaturated carboxylic acid having one carbon-carbon double bond (C=C) and one carboxyl group.

<1.2. Synthesis of metal salt of unsaturated carboxylic acid>

The metal salt of unsaturated carboxylic acid of the invention can be synthesized by the reaction of a metal compound and the unsaturated carboxylic acid, as described in a known document (JP-A-2010-001395) for example.

The metal compound used for the reaction is not particularly limited but a metal oxide, a metal hydroxide, a metal acetate and the like are mentioned. Among them, because the by-product is water, which is harmless, it is preferable to synthesize the metal salt of unsaturated carboxylic acid by neutralization reaction of the unsaturated carboxylic acid and a metal oxide or a metal hydroxide, and it is more preferable to use a metal oxide as the metal compound. In addition, in view of the easiness of the synthesis, it is also preferable to synthesize the metal salt of unsaturated carboxylic acid by ion exchange between a metal carboxylate such as a metal acetate and the unsaturated carboxylic acid.

The metal oxide is not particularly limited but scandium oxide, titanium oxide, vanadium oxide, chromium oxide, manganese oxide, iron oxide, cobalt oxide, nickel oxide, copper oxide, zinc oxide, indium oxide, gallium oxide, aluminum oxide, tin oxide or lead oxide is mentioned. Among them, titanium oxide, nickel oxide, copper oxide, zinc oxide, indium oxide or tin oxide is more preferable and zinc oxide is particularly preferable because a zinc unsaturated carboxylate is likely to be generated.

The metal oxide may be doped with another metal. For example, it is also possible to use aluminum-doped zinc oxide, gallium-doped zinc oxide, indium-doped zinc oxide, indium/gallium-doped zinc oxide, cesium-doped titanium oxide or the like. A kind of the metal oxides may be used or two or more kinds may be used together.

The metal compound used may be in the form of a powder or a dispersion. When the metal compound is a powder, the average primary particle diameter can be measured by a dynamic light-scattering particle diameter measuring device, a transmission electron microscope (TEM) or the like, but the average primary particle diameter is not particularly limited as long as the metal compound can be used as the raw material for synthesizing the metal salt of unsaturated carboxylic acid.

It is not necessary that the metal compound used has been subjected to surface treatment, but the metal compound may have been subjected to surface treatment by a surface treatment agent. The surface treatment agent

is not particularly limited as long as the metal salt of unsaturated carboxylic acid is obtained, but the following agents are mentioned: a polysiloxane compound or a salt thereof such as methylhydrogenpolysiloxane, polymethoxysilane, dimethylpolysiloxane and dimethicone PEG-7 succinate; an organic silicon compound such as methyldimethoxysilane, dimethyldimethoxysilane, methyltrimethoxysilane, phenyltrimethoxysilane, 3-aminopropyltriethoxysilane and 3-carboxypropyltrimethyl trimethoxysilane; a carboxylic acid compound such as formic acid, acetic acid, lauric acid, stearic acid and 6-hydroxyhexanoic acid; an organophosphorus compound such as lauryl ether phosphate and trioctylphosphine; an amine compound such as dimethylamine, tributylamine, trimethylamine, cyclohexylamine and ethylenediamine; a binder resin such as polyimine, polyester, polyamide, polyurethane and polyurea; and the like. A kind of the surface treatment agents may be used or two or more kinds may be used together.

When the metal compound used is a dispersion, the solvent used for the dispersion is not particularly limited as long as the metal salt of unsaturated carboxylic acid is obtained, but examples thereof are as follows: water; aliphatic hydrocarbons such as hexane, heptane, octane, isooctane, nonane and decane; aromatic hydrocarbons such as toluene, xylene, chlorobenzene and ortho-dichlorobenzene; alcohols such as methanol, ethanol, isopropanol, 2-methoxyethanol, 2-butoxyethanol, ethylene glycol and propylene glycol monomethyl ether (PGME); ketones such as acetone, methyl ethyl ketone, cyclopentanone, cyclohexanone and N-methylpyrrolidone (NMP); esters such as ethyl acetate, butyl acetate and methyl lactate; halogenated hydrocarbons such as chloroform, methylene chloride, dichloroethane, trichloroethane and trichloroethylene; ethers such as propylene glycol monomethyl ether acetate (PGMEA), ethyl ether, tetrahydrofuran and dioxane; amides such as N,N-dimethylformamide (DMF) and N,N-dimethylacetamide (DMA); amines such as ethanolamine, diethylamine and triethylamine; and sulfoxides such as dimethyl sulfoxide (DMSO). Among them, preferable examples are water; alcohols such as methanol, ethanol, isopropanol, 2-methoxyethanol, 2-butoxyethanol, ethylene glycol and propylene glycol monomethyl ether (PGME); ketones such as acetone, methyl ethyl ketone, cyclopentanone, cyclohexanone and N-methylpyrrolidone (NMP); ethers such as propylene glycol monomethyl ether acetate (PGMEA), ethyl ether, tetrahydrofuran and dioxane; amides such as N,N-dimethylformamide (DMF) and N,N-dimethylacetamide (DMA); or sulfoxides such as dimethyl sulfoxide (DMSO). Further preferable examples are water; or alcohols such as methanol, ethanol, isopropanol, 2-methoxyethanol, 2-butoxyethanol, ethylene glycol and propylene glycol monomethyl ether (PGME). A kind of the solvents may be used or any combination of two or more kinds in any ratio may be used. As long as the metal salt of unsaturated carboxylic acid is obtained, the boiling point of the solvent is not particularly limited.

Specific examples of the metal oxide as a powder are Nanozinc 60 (manufactured by The Honjo Chemical Corporation, zinc oxide), Nanozinc 100 (manufactured by The Honjo Chemical Corporation, zinc oxide), FINEX-30 (manufactured by Sakai Chemical Industry Co., Ltd., zinc oxide), ZINCOX SUPER F-2 (manufactured by Hakusuitech Co., Ltd., zinc oxide), Pazet 23K (manufactured by Hakusuitech Co., Ltd., aluminum-doped zinc oxide) and Pazet GK40 (manufactured by Hakusuitech Co., Ltd., gallium-doped zinc oxide). Specific examples as a dispersion are a zinc oxide dispersion manufactured by Sigma-Aldrich Co. LLC (product number: 721085) and Pazet GK dispersion (manufactured by Hakusuitech Co., Ltd., gallium-doped zinc oxide dispersion).

<1.3. Coating step for coating ink containing metal salt of unsaturated carboxylic acid>

As described above, the semiconductor layer containing a metal oxide of the invention is produced by the production method containing a coating step for coating an ink containing the metal salt of unsaturated carboxylic acid represented by the general formula (I). The coating step for coating an ink containing the metal salt of unsaturated carboxylic acid is explained below.

The ink containing the metal salt of unsaturated carboxylic acid contains the metal salt of unsaturated carboxylic acid of the invention and a solvent. Such an ink can be obtained by mixing the metal salt of unsaturated carboxylic acid of the invention and a solvent. As another method, such an ink can be obtained by reacting the metal compound and the unsaturated carboxylic acid as described above in a solvent.

As the metal salt of unsaturated carboxylic acid that the ink contains, a kind of metal salt of unsaturated carboxylic acid may be used or two or more kinds of metal salt of unsaturated carboxylic acid may be used. In addition, the ink may contain only a kind of metal atom or two or more kinds of metal atom. Furthermore, the valences of the metal atoms contained in the ink are not necessarily the same and metal atoms with different valences may be mixed. Moreover, in the ink, the metal salt of unsaturated carboxylic acid does not necessarily exist individually, but the metal salt of unsaturated carboxylic acid may form a complex with the solvent or the like or from a multimeric complex.

The solvent that the ink containing the metal salt of unsaturated carboxylic acid contains is not particularly limited but examples are as follows: water; aliphatic hydrocarbons such as hexane, heptane, octane, isooctane, nonane and decane; aromatic hydrocarbons such as toluene, xylene, chlorobenzene and ortho-dichlorobenzene; alcohols such as methanol, ethanol, isopropanol, 2-methoxyethanol, 2-butoxyethanol, ethylene glycol and propylene glycol monomethyl ether (PGME); ketones such as acetone, methyl ethyl ketone, cyclopentanone, cyclohexanone and N-methylpyrrolidone (NMP); esters such as ethyl acetate, butyl acetate and methyl lactate; halogenated hydrocarbons such as chloroform, methylene chloride, dichloroethane, trichloroethane and trichloroethylene; ethers such as propylene glycol monomethyl

ether acetate (PGMEA), ethyl ether, tetrahydrofuran and dioxane; amides such as N,N-dimethylformamide (DMF) and N,N-dimethylacetamide (DMA); amines such as ethanolamine, diethylamine and triethylamine; and sulfoxides such as dimethyl sulfoxide (DMSO). Among them, preferable examples are water; alcohols such as methanol, ethanol, isopropanol, 2-methoxyethanol, 2-butoxyethanol, ethylene glycol and propylene glycol monomethyl ether (PGME); ketones such as acetone, methyl ethyl ketone, cyclopentanone, cyclohexanone and N-methylpyrrolidone (NMP); ethers such as propylene glycol monomethyl ether acetate (PGMEA), ethyl ether, tetrahydrofuran and dioxane; amides such as N,N-dimethylformamide (DMF) and N,N-dimethylacetamide (DMA); and sulfoxides such as dimethyl sulfoxide (DMSO). Further preferable examples are water; and alcohols such as methanol, ethanol, isopropanol, 2-methoxyethanol, 2-butoxyethanol, ethylene glycol and propylene glycol monomethyl ether (PGME). A kind of the solvents may be used or any combination of two or more kinds in any ratio may be used. Because the solvent may remain in the semiconductor layer as long as the semiconducting properties are not greatly diminished, the boiling point of the solvent is not particularly limited.

Although the concentration of the metal salt of unsaturated carboxylic acid in the ink is not particularly limited, the concentration is generally 0.1% by mass or more, preferably 0.5% by mass or more and more preferably 1% by mass or more, and is generally 100% by mass or less, preferably 50% by mass or less and more preferably 20% by mass or less. The concentration of the metal salt of unsaturated carboxylic acid in the ink within the above range is preferable because the metal salt of unsaturated carboxylic acid can be coated evenly and an even semiconductor layer can be obtained.

The ink containing the metal salt of unsaturated carboxylic acid may further contain a metal oxide as long as an even film is obtained. The metal oxide which the ink further contains may work as a catalyst promoting the formation reaction of the semiconductor layer, or may become a seed crystal for the crystal growth of the metal oxide.

The viscosity of the ink containing the metal salt of unsaturated carboxylic acid can be adjusted by adding an additive. The additive is not particularly limited as long as it does not remarkably suppress the semiconducting properties of the resulting semiconductor layer. Examples thereof are the surface treatment agent for the metal oxide above, the doping material described below or the like.

The viscosity of the ink can be measured by a rotary viscometer method (described in "Handbook for Physicochemical Experiment" (edited by Ginya Adachi, Yasutaka Ishii and Satohiro Yoshida, Kagaku-Dojin Publishing Company, INC (1993)) and specifically, the viscosity can be measured using RE85 viscometer (manufactured by Toki Sangyo Co., Ltd.). The preferable viscosity of the ink is not particularly limited and may vary with the kind of the coating method. A relatively-low viscosity is preferable when a spray coating method is used and a relatively-high viscosity is preferable when a wire-bar bar coating method is used.

The method for coating the ink may be an optional method. For example, a spin coating method, a gravure coating method, a kiss coating method, a roll brushing method, a spray coating method, an air-knife coating method, a wire-bar bar coating method, a pipe doctor method, an impregnation/coating method, a curtain coating method and the like are mentioned. A kind of the coating methods may be used or two or more methods may be used as a combination.

<1.4. Heat treatment step for conducting heat treatment>

Next, a heat treatment step for conducting heat treatment after coating the ink is explained. In the invention, the semiconductor layer containing a metal oxide can be produced by the generation reaction of the metal oxide or the like using the metal salt of unsaturated carboxylic acid as a raw material.

The generation reaction can be carried out by applying external stimuli such as water and heat. Although the full mechanism is not known yet, hydrolysis of the metal salt of unsaturated carboxylic acid is thought to be the main reaction of the generation reaction of the invention and thus the generation reaction is promoted by the heat treatment. The heat treatment is preferable because the operation is simple.

The temperature of the heat treatment is lower than 300°C, preferably lower than 250°C and more preferably lower than 200°C. The temperature lower than 300°C is preferable, because the temperature can be also applied to a production process using a flexible base material, such as a roll-to-roll method.

On the other hand, the lower limit is not particularly limited, but the temperature is preferably 100°C or higher. The reason why 100°C or higher is preferable is that the temperature at which water turns into water vapor with a high degree of freedom is 100°C or higher. Although the full mechanism of the generation reaction of the metal oxide is not known yet, water vapor may play a role of a reactant in the hydrolysis reaction in which the metal salt of unsaturated carboxylic acid becomes the metal oxide, and/or a role of a reaction catalyst in the thermal decomposition reaction explained below. Thus, because of water vapor, the conversion from the metal salt of unsaturated carboxylic acid into the metal oxide is thought to be promoted and the time for the heat treatment can be shortened.

It is advantageous to conduct the heat treatment at temperature as low as possible, also because it allows the use of a flexible base material using a composite material obtained by adding insulating property to a resin base material such as polyethylene terephthalate or a metal foil such as copper. In particular, with regard to a flexible electronic device,

the construction of a process which enables the formation of a metal oxide thin film with high density and excellent properties at low temperature is said to be a problem which should be solved soon (Applied Physics, 2012,81,728.). In this regard, according to the method for producing the semiconductor layer containing a metal oxide of the invention, a semiconductor layer containing a metal oxide with excellent properties can be produced at low temperature.

The heating time is not particularly limited as long as the generation reaction progresses, but is generally 30 seconds or longer, preferably one minute or longer, more preferably two minutes or longer and further preferably three minutes or longer. The time is generally 180 minutes or shorter, preferably 60 minutes or shorter, more preferably 30 minutes or shorter and further preferably 15 minutes or shorter. The heating time within the above range is preferable, because the generation reaction progresses sufficiently and the generation reaction can progress smoothly even in a practical production process such as a roll-to-roll method. In this regard, when the heating temperature is high within the range lower than 300°C, the generation reaction from the metal salt of unsaturated carboxylic acid into the metal oxide tends to progress and thus a semiconductor layer containing a metal oxide with high hardness, high peel strength and excellent semiconducting properties can be produced by short heating. On the other hand, even if the heating temperature is low, a semiconductor layer containing a metal oxide with high hardness, high peel strength and excellent semiconducting properties can be produced by prolonging the heating time. Accordingly, the heating time and the heating temperature may be appropriately determined depending on the base material used or the like.

According to the method of the invention, a semiconductor containing a metal oxide which contains the metal oxide as the main component can be obtained from the metal salt of unsaturated carboxylic acid as the raw material. Although the full mechanism of the generation reaction is not known yet, it is thought that the metal oxide is obtained thorough (i) a pathway in which the metal salt of unsaturated carboxylic acid is hydrolyzed to produce a metal hydroxide by reacting with water in the air and is finally converted into the metal oxide, (ii) a pathway in which a pure metal is generated by the thermal decomposition of the unsaturated carboxylic acid constituting the metal salt of unsaturated carboxylic acid and the pure metal bonds to oxygen in the air to finally produce the metal oxide, or the like.

[Chem. 3]

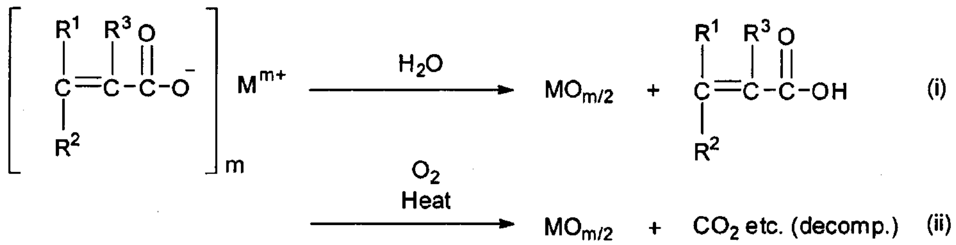


In the heat treatment step, it is sufficient that the semiconductor containing a metal oxide is produced, and it is not necessary that the whole amount of the metal salt of unsaturated carboxylic acid is converted into the metal oxide. Specifically, in order to achieve the semiconducting properties, it is sufficient that generally 60% or more, preferably 70% or more and more preferably 80% or more of the metal salt of unsaturated carboxylic acid is changed into the metal oxide.

The proportion of the metal salt of unsaturated carboxylic acid of the invention changed into the metal oxide to the metal salt of unsaturated carboxylic acid can be measured by infrared spectroscopic analysis (IR). In addition, the proportion of the metal oxide in the product can be measured by X-ray photoelectron spectroscopy (XPS or ESCA).

Although the full mechanism of the generation reaction of the metal oxide is not known yet, it is possible that the surroundings in the air such as the oxygen concentration and water concentration (humidity) also influence the semiconductor containing a metal oxide.

Specifically, the oxygen concentration in the atmosphere for carrying out the heat treatment is generally 0.1% by volume or more, preferably 0.5% by volume or more and more preferably 1% by volume or more. The concentration is generally 50% by volume or less, preferably 30% by volume or less and more preferably 25% by volume or less. When the oxygen concentration is within the above range, an even semiconductor layer with better semiconducting properties can be obtained. For example, when the oxygen concentration is 0.1% by volume or more, the generation of the metal oxide from the metal salt of unsaturated carboxylic acid can be carried out stably at low temperature. In addition, when the oxygen concentration is 50% by volume or less, the production of unstable by-products such as a peroxide due to excessive amount of oxygen can be prevented.

On the other hand, the water concentration in the atmosphere for carrying out the heat treatment greatly influences the generation of the metal oxide from the metal salt of unsaturated carboxylic acid. This is because water is important as the reactant in the hydrolysis reaction. The specific concentration of water is generally more than 1%,

as the humidity at 25°C, preferably 5% or more, more preferably 10% or more and further preferably 30% or more. The concentration is generally 80% or less, preferably 75% or less and more preferably 70% or less. When the water concentration is within this range, an even semiconductor layer with better semiconducting properties can be obtained. For example, when the humidity exceeds 1%, the generation of the metal oxide from the metal salt of unsaturated carboxylic acid can be carried out stably at low temperature. In addition, the humidity of 80% or less can prevent the ink containing the metal salt of unsaturated carboxylic acid from being unevenly coated on the base material. In the specification, the humidity at 25°C means the relative humidity with the atmosphere controlled at 25°C.

<1.5. Constitution of semiconductor layer containing metal oxide>

The semiconductor layer containing a metal oxide obtained by the production method of the invention can be used as the semiconductor layer of an electronic device as described below. In this case, the thickness of the whole semiconductor layer containing a metal oxide is not particularly limited but is generally 0.5 nm or more, preferably 1 nm or more, more preferably 5 nm or more and particularly preferably 10 nm or more. The thickness is generally 1 $\mu$m or less, preferably 700 nm or less, more preferably 400 nm or less and particularly preferably 200 nm or less. When the thickness of the semiconductor layer is within the above range, even coating becomes easier and the semiconducting properties appear better. In this regard, the semiconductor layer containing a metal oxide is preferably a semiconductor containing zinc oxide. The semiconductor layer containing a metal oxide may be doped with impurities. The impurities are the following doping materials or compounds derived from the metal salt of unsaturated carboxylic acid of the invention.

The average roughness relative to the thickness of the semiconductor layer containing a metal oxide obtained in the invention is preferably as close to zero as possible, also in order to prevent the resistance loss of the semiconducting properties at the interface. Specifically, the average roughness relative to the thickness is generally less than 10%, preferably less than 9% and more preferably less than 8%. When the roughness relative to the thickness is less than 10%, the semiconducting properties are achieved well.

In addition, it is preferable that the metal oxide contained in the semiconductor layer containing a metal oxide obtained in the invention does not extremely have a certain crystal orientation. When the layer is a thin film, the metal oxide is generally a polycrystal but not a single crystal. For example, zinc oxide is likely to have a Wurtzite-type crystalline structure and tends to form a polycrystal with strong c-axis orientation by a vacuum film-forming method such as a sputtering method or an electrolysis method. However, a polycrystal with strong c-axis orientation has its drawback because the durability in the surroundings in the air such as heat and humidity is low although the electron mobility is high. In this regard, with a polycrystal which does not extremely have a certain crystal orientation, the durability in the surroundings in the air may improve.

Specifically, the half-width of the $2\theta$ peak corresponding to the (002) plane in a thin-film X-ray diffraction (XRD) method (out of plane measurement) of a zinc oxide film is preferably 1° or more, more preferably 1.1° or more and further preferably 1.2° or more, and is generally 5° or less, preferably 4° or less and further preferably 3.5° or less. Within the above range, both high electron mobility and durability in the surroundings in the air can be attained.

When the electronic device is produced industrially, for example, when roll-to-roll process is used, the film surface may be damaged especially while rolling the film, and thus the semiconductor layer preferably has adequate hardness. If the semiconductor layer is physically damaged, desirable semiconducting properties may not be attained.

The hardness of the semiconductor layer of the invention can be determined by a pencil scratch hardness test (for example, JIS K5600-5-4(1999)), a scratch hardness test by a cantilever stylus using a contact-type thickness measuring device (for example stylus surface profiler Dektak 150 (manufactured by Ulvac Inc.)) or the like.

The stylus resistant pressure of the semiconductor layer of the invention measured by a scratch hardness test by a cantilever stylus using a contact-type thickness measuring device (stylus surface profiler Dektak 150) is generally 5.0 mg or more, preferably 10.0 mg or more and more preferably 15.0 mg or more. When the measured value obtained using another measuring device is converted to the stylus resistant pressure by Dektak 150 cantilever stylus, the stylus resistant pressure of the semiconductor layer of the invention is generally 10000 mg or less and preferably 5000 mg or less. The stylus resistant pressure within the above range is preferable because both hardness which will be suitable for an industrial production method using a roll-to-roll process or the like and desirable semiconducting properties can be attained at the same time.

The concentration of the metal atom in the semiconductor layer of the invention is not particularly limited as long as semiconducting properties can be achieved but is generally 1% by mass or more, preferably 3% by mass or more and particularly preferably 5% by mass or more. The concentration is generally 99% by mass or less, preferably 95% by mass or less and particularly preferably 90% by mass or less. When the metal atom is contained in the concentration in the above range, both excellent semiconducting properties and high mechanical strength can be attained.

The semiconductor layer of the invention may contain another compound in addition to the metal oxide generated from the metal salt of unsaturated carboxylic acid of the invention. The percentage of the metal oxide of the invention in the semiconductor layer is generally 10% by mass or more, preferably 20% by mass or more, more preferably 40%

by mass or more, more preferably 60% by mass or more, further preferably 70% by mass or more and particularly preferably 80% by mass or more. Another compound which the semiconductor layer may contain is the decomposed material of the unsaturated carboxylic acid constituting the metal salt of unsaturated carboxylic acid, a polymer thereof or the like.

<2. Electronic device>

Next, the electronic device and the production method thereof using the method for producing the semiconductor layer containing a metal oxide of the invention are explained. The electronic device of the invention has the semiconductor layer containing a metal oxide which has been formed in accordance with the method for producing the semiconductor layer containing a metal oxide of the invention. Such an electronic device can be produced by a production method containing a step for forming the semiconductor layer containing a metal oxide in accordance with the method for producing the semiconductor layer containing a metal oxide of the invention. The base material on which the semiconductor layer containing a metal oxide is formed may be a base material on which another structure such as an electrode has been formed.

The electronic device in the specification is a device having two or more electrodes and controlling the current flowing between the electrodes and the voltage generated between the electrodes with electricity, light, magnetism, a chemical substance or the like, or a device which generates light, electric field, or magnetic field due to the applied voltage or current. Examples thereof are an element which controls current or voltage by applying voltage or current, an element which controls voltage or current by applying magnetic field, an element which controls voltage or current by reacting a chemical substance and the like. The controlling here is rectification, switching, amplification, oscillation or the like.

Corresponding devices which are currently produced from silicon or the like are a resistor, a rectifier (diode), a switching element (transistor or thyristor), an amplifier (transistor), a memory element, a chemical sensor and the like, or a combination of these elements or a device in which these elements are integrated. In addition, a photoelectric conversion element and a solar cell generating electromotive force by light, a photonic device causing photocurrent, such as a photodiode or a phototransistor are also mentioned.

The semiconductor layer of the invention can be used as the semiconductor layer in these electronic devices. Among them, the electronic device of the invention is preferably a field effect transistor, a solar cell or an electroluminescent device. In this regard, when the semiconductor layer of the invention is used as the semiconductor layer of the electronic device, a semiconductor other than the semiconductor layer of the invention may be used together.

The semiconductor layer of the invention may be used for applications other than the semiconductor in the electronic device. For example, it is possible to form the semiconductor layer of the invention at a desired position in the electronic device, and use the layer as a wire, or an insulating layer in a condenser or FET by controlling the conductivity of the layer by the molecular structure, doping or the like.

More specific examples of the electronic device are those described in written by S. M. Sze, Physics of Semiconductor Devices, 2nd Edition (Wiley Interscience 1981).

The term "semiconductor" in the specification is defined by the degree of carrier mobility in the solid state. As it is known, the carrier mobility is an index showing how fast (or slow) a charge (electron or hole) can move. Specifically, it is desirable that the "semiconductor" in the specification has carrier mobility at room temperature of $1.0\times10^{-7}$ $cm^2/V.s$ or more, preferably $1.0\times10^{-6}$ $cm^2/V\cdot s$ or more and more preferably $1.0\times10^{-5}$ $cm^2/V\cdot s$ or more. In this regard, the carrier mobility can be measured for example by measuring the IV properties of a field effect transistor, by a time-of-flight method or the like. In addition, as the properties of the semiconductor layer of the invention, it is desirable that the carrier mobility at room temperature is $1.0\times10^{-7}$ $cm^2/V\cdot s$ or more, preferably $1.0\times10^{-6}$ $cm^2/V\cdot s$ or more and more preferably $1.0\times10^{-5}$ $cm^2/V\cdot s$ or more.

<2.1. Base material treatment>

The material for the base material is not particularly limited as long as the effects of the invention are not greatly diminished. Preferable examples of the material for the base material are inorganic materials such as quartz, glass, sapphire or titania, or a flexible base material. In the invention, the flexible base material generally has a curvature radius of 0.1 mm or more and 10000 mm or less. Specifically, the curvature radius can be determined by measuring the base material which is bent to an extent which does not break (for example warps or cracks) the base material using a general confocal microscope. Specifically, the curvature radius can be measured using laser microscope VK-X200 (manufactured by Keyence Corporation). In this regard, when a flexible electronic device is produced, in order to achieve both flexibility and properties as a support, the curvature radius is preferably 0.3 mm or more and further preferably 1 mm or more, and preferably 3000 mm or less and further preferably 1000 mm or less. Although it is not limited, specific examples of the flexible base material are as follows: polyolefins such as polyethylene terephthalate, polyethylene naphthalate,

polyethersulfone, polyimide, nylon, polystyrene, polyvinyl alcohol, an ethylene vinyl alcohol copolymer, a fluorine resin film, vinyl chloride or polyethylene; organic materials (resin base materials) such as cellulose, polyvinylidene chloride, aramid, polyphenylene sulfide, polyurethane, polycarbonate, polyarylate, polynorbornene or an epoxy resin; paper materials such as paper or synthetic paper; and composite materials, for example, a metal foil such as stainless steel, titanium or aluminum with a coated or laminated surface to achieve insulating properties.

The method for producing the semiconductor layer containing a metal oxide of the invention is particularly effective when the flexible base material is used among the base materials described above. For example, when the semiconductor layer containing a metal oxide is produced by a conventional method, a high-temperature process is required and it is thus extremely difficult to use a resin base material with low glass transition temperature. On the other hand, the invention enables the production of the semiconductor layer containing a metal oxide by a low-temperature process and thus can be applied to a resin base material with low glass transition temperature. Also when the composite material of a metal foil with insulating properties, which is described above, is used as the base material, the thickness thereof is quite small and thus the base material would warp if the semiconductor layer containing a metal oxide is produced by a conventional high-temperature process. Accordingly, also when the composite material of a metal foil with insulating properties is used as the base material, the invention is quite effective. In addition, in the invention, the flexible base material can be used as described above and thus the production of the electronic device by a roll-to-roll method is possible, resulting in the improvement of productivity.

The electronic device of the invention is formed on the base material and the properties of the electronic device can be improved by subjecting the base material to base-material treatment. The principle thereof is supposed to be as follows: the properties of the film obtained by the film formation can be improved by controlling the hydrophilic/hydrophobic property of the base material, and especially, the properties at the interface of the base material and the semiconductor layer can be improved. As such base-material treatment, hydrophobizing treatment using hexamethyldisilazane, cyclohexene, octadecyltrichlorosilane or the like, treatment using an acid such as hydrochloric acid, sulfuric acid or acetic acid or alkali treatment using sodium hydroxide, potassium hydroxide, calcium hydroxide, ammonia or the like, ozone treatment, fluorination treatment, plasma treatment using oxygen, argon or the like, treatment for forming a Langmuir Blodgett film, treatment for forming a thin film of an insulator or a semiconductor, and the like are mentioned.

<2.2. Film thickness>

For the electronic device of the invention, the semiconductor layer containing a metal oxide formed by the method for producing the semiconductor layer containing a metal oxide of the invention is used, and this semiconductor layer is formed on the base material. When the layer formed as a film is used for a thin film electronic device, a thin film may not allow sufficient light absorption or often cause a short circuit. A thick film often increases the resistance in the thickness direction and deteriorates the properties. From these points, the preferable thickness is 0.5 nm to 1 $\mu$m and more preferably 10 nm to 200 nm.

<2.3. Mixing>

The semiconductor layer formed from the metal salt of unsaturated carboxylic acid of the invention may be used as a semiconductor alone, or may be used after adding another compound. In addition, a laminate of the semiconductor layer of the invention and a layer of another compound may be used for the electronic device.

<2.4. Film formation>

As described above, by coating the ink containing the metal salt of unsaturated carboxylic acid and conducting the heat treatment and the like, the electronic device containing the semiconductor layer of the invention can be produced. As the coating method, it is possible to use coating methods such as a cast method, a spin coating method, a dip coating method, a blade coating method, a wire-bar bar coating method and a spray coating method, printing methods such as inkjet printing, screen printing, offset printing and relief printing, soft lithography methods such as a micro-contact printing method, and the like, and a combination of these methods. In addition, as the technique similar to coating, the following methods are also mentioned: a Langmuir Blodgett method in which a monomolecular film formed on water surface is transferred to a substrate and laminated, a method for interposing liquid crystal or a molten-liquid compound between two substrates, a method for introducing liquid crystal or a molten-liquid compound between substrates by capillary action, and the like.

In addition, the produced semiconductor layer can be subjected to posttreatment to improve its properties. For example, the warp of the film caused during the film formation can be relaxed by further heat treatment, resulting in the improvement of the device properties and the stabilization of the device properties. Moreover, the exposure of the semiconductor layer to a oxidizing or reducing gas or liquid such as oxygen or hydrogen can induce the change of the

properties due to the oxidation or reduction. This can be used for the purpose of increasing or reducing the carrier density in the semiconductor film for example.

Furthermore, a technique called doping can be also used. That is, the device properties can be changed to desirable properties by adding a tiny amount of atoms, an atomic group, molecules, a polymer or the like. For example, Bronsted acids such as oxygen, hydrogen, hydrochloric acid, sulfuric acid and sulfonic acid, Lewis acids such as $PF_6$, $AsF_5$ and $FeCl_3$, halogen atoms such as iodine, metal atoms such as lithium, sodium, potassium and cesium and the like can be used as the doping materials. Among them, alkali metal atoms such as lithium, sodium, potassium and cesium are preferable because the properties of the semiconductor device can improve. By the doping treatment, change of the electric conductivity, change of the carrier polarity (p-type and n-type), change of the Fermi level and the like are caused due to the increase or decrease in the carrier density, and thus the doping treatment is often used for producing a semiconductor device. The doping treatment can be carried out when various electronic devices including a field effect transistor (FET) are produced.

The doping treatment can be achieved by contacting the object with the gases, immersing it in the solutions, or conducting electrochemical treatment. The doping treatment may not be always after the formation of the film. For example, the doping material may be added when the metal salt of unsaturated carboxylic acid is synthesized. The doping material may be added to the ink containing the metal salt of unsaturated carboxylic acid. Specifically, when an alkali metal atom is used as the doping material, an alkali metal salt such as acetate or carbonate can be added to the ink.

<2.5. Electrodes, wires and protective layer>

For the electrodes and wires for producing the electronic device containing a photoelectric conversion element and FET, metals such as gold, aluminum, copper, chromium, nickel, cobalt, titanium and platinum, conductive polymers such as polyaniline, polypyrrole, polythiophene, polyacetylene and polydiacetylene which may be doped, semiconductor materials such as silicon, germanium and gallium arsenide which may be doped, carbon materials such as fullerene, carbon nanotube and graphite, and the like can be used. As the method for forming the electrodes and the wires, a vacuum vapor deposition method, a sputtering method, a coating method, a printing method, a plating method, a sol gel method and the like can be used. When the electrodes and wires are formed by patterning, photolithography methods in which patterning of a photoresist and etching using an etching liquid or reactive plasma are combined, printing methods such as inkjet printing, screen printing, offset printing and relief printing, soft lithography methods such as a micro-contact printing method, a combination of these methods and the like can be used. In addition, by applying energy rays such as laser or electron ray, and removing the material or changing the conductivity of the material, the pattern can be formed directly.

A protective film can be formed on the electronic device in order to improve the semiconducting properties or minimizing the influence of the air. As the protective film, polymer films including a styrene resin, an epoxy resin, an acrylic resin, a polyurethane resin, a polyimide resin, a polyvinyl alcohol resin, a polyvinylidene chloride resin, a polycarbonate resin and the like, inorganic oxide films or inorganic nitride films such as silicon oxide, silicon nitride and aluminum oxide, and the like are mentioned. As the method for forming the polymer film, a method in which a solution of the polymer material is coated and dried, and a method in which a monomer is coated or vaporized and then polymerized are mentioned. In addition, it is also possible to subject the polymer film to cross-linking treatment or form a multi-layer film. As the method for forming the inorganic material film, a method using vacuum process such as a sputtering method and a vapor deposition method, a method using a solution process as represented by a sol gel method and the like can be used. In order to improve the semiconducting properties, the material of the polymer film contacting the semiconductor is preferably those containing an aromatic ring such as polystyrene, polyvinyl naphthalene, polybenzyl methacrylate, polyacenaphthylene and polycarbonate. It is preferable to further laminate a film having gas barrier property such as an inorganic film of silicon nitride, silicon oxide or the like and a metal film of aluminum, chromium or the like on the polymer film contacting the semiconductor. Depending on the use or the like, a layer or a part other than those described above may be provided in the electronic device.

<3. Field effect transistor (FET)>

A preferable example of the electronic device using the semiconductor layer containing a metal oxide produced from the metal salt of unsaturated carboxylic acid of the invention is a field effect transistor (FET) element.

The FET of the invention is explained in detail below. Fig. 4 shows schematic views of examples of the structure of the FET of the invention. In Fig. 4, 51 is a semiconductor layer, 52 is an insulator layer, 53 and 54 are a source electrode and a drain electrode, 55 is a gate electrode, and 56 is a base material. Each of Fig. 4(A) to (D) shows an example of the structure of the FET of the invention. These examples of the FET of the invention are explained below.

For each electrode of the source electrode, the drain electrode and the gate electrode, for example, conductive materials such as conductive oxides such as $In_2O_3$, $SnO_2$ and ITO, conductive polymers such as polyaniline, polypyrrole,

polythiophene and polyacetylene, materials obtained by adding to the conductive polymer above a dopant, for example, a Brønsted acid such as hydrochloric acid, sulfuric acid and sulfonic acid, a Lewis acid such as $PF_6$, $AsF_5$ and $FeCl_3$, a halogen atom such as iodine, or a metal atom such as sodium and potassium, conductive composite materials in which carbon black, metal particles or the like is dispersed, as well as metals such as platinum, gold, aluminum, chromium, nickel, copper, titanium, magnesium, calcium, barium and sodium are used.

In addition, examples of the material used for the insulator layer are polymers such as polymethyl methacrylate, polystyrene, polyvinyl phenol, polyimide, polycarbonate, polyester, polyvinyl alcohol, polyvinyl acetate, polyurethane, polysulfone, an epoxy resin and a phenolic resin, and copolymers thereof, oxides such as silicon dioxide, aluminum oxide and titanium oxide, nitrides such as silicon nitride, ferroelectric oxides such as strontium titanate and barium titanate, and polymers in which particles of these oxides, nitrides, ferroelectric oxides and the like are dispersed.

In general, when the capacitance of an insulating film becomes larger, driving with a lower gate voltage is possible and this is advantageous. This can be attained by using an insulating material with a large permittivity or making the insulator layer thin. The insulator layer can be produced by a method suitable for the properties of the materials, for example a coating method (a spin coating method or a blade coating method), a vapor deposition method, a sputtering method, a printing method such as screen printing or inkjet, or a method in which an oxide film is formed on a metal such as alumite on aluminum.

The FET is generally formed on a base material. The material of the base material is not particularly limited as long as the effects of the invention are not greatly diminished. Preferable examples of the material for the base material are inorganic materials such as quartz, glass, sapphire or titania, or a flexible base material. As the flexible base material, the following materials are mentioned: polyolefins such as polyethylene terephthalate, polyethylene naphthalate, polyethersulfone, polyimide, nylon, polystyrene, polyvinyl alcohol, an ethylene vinyl alcohol copolymer, a fluorine resin film, vinyl chloride or polyethylene; organic materials such as cellulose, polyvinylidene chloride, aramid, polyphenylene sulfide, polyurethane, polycarbonate, polyarylate, polynorbornene or an epoxy resin; paper materials such as paper or synthetic paper; composite materials, for example, a metal foil such as stainless steel, titanium or aluminum with a coated or laminated surface to achieve insulating properties; and the likes. The method for producing the semiconductor layer containing a metal oxide of the invention is particularly effective when the flexible base material is used as described above. The application is possible. In addition, by treating the base material, the properties of the FET can be improved. This is supposed to be because the film properties of the formed semiconductor layer are improved by controlling the hydrophilic/hydrophobic property of the base material, and especially, the properties at the interface of the base material and the semiconductor layer are improved. As such base-material treatment, hydrophobizing treatment using hexamethyldisilazane, cyclohexene, octadecyltrichlorosilane or the like, acid treatment using an acid such as hydrochloric acid, sulfuric acid and acetic acid, alkali treatment using sodium hydroxide, potassium hydroxide, calcium hydroxide, ammonia and the like, ozone treatment, fluorination treatment, plasma treatment using oxygen, argon or the like, treatment for forming a Langmuir Blodgett film, treatment for forming a thin film of an insulator or a semiconductor, and the like are mentioned.

The semiconductor layer in the FET of the invention is formed by forming a film of a semiconductor on the base material directly or through another layer. In the FET of the invention, the semiconductor layer 51 is the semiconductor layer containing a metal oxide formed according to the method for producing the semiconductor layer containing a metal oxide of the invention. Such an FET can be produced by a method containing a step for forming a semiconductor layer containing a metal oxide according to the method for producing the semiconductor layer containing a metal oxide of the invention.

The semiconductor layer 51 thus contains the metal oxide generated from the metal salt of unsaturated carboxylic acid of the invention, though another compound (another semiconductor or the like) may be added to the semiconductor layer 51 in addition to the metal oxide. In addition, the semiconductor layer 51 may have a laminate structure formed from layers containing different materials or having different components.

The thickness of the semiconductor layer 51 is not limited, and in a horizontal field effect transistor for example, the properties of the element do not depend on the thickness of the semiconductor layer 51 as long as the thickness is a certain level or more. However, because the leakage current often increases if the thickness is too large, the thickness of the semiconductor layer is generally 0.5 nm or more and preferably 10 nm or more, and generally 1 $\mu$m or less and preferably 200 nm or less in view of the cost.

<4. Photoelectric conversion element>

The photoelectric conversion element of the invention has at least a pair of electrodes, an active layer interposed between the electrodes, and a buffer layer interposed between the active layer and one of the electrodes. Furthermore, the photoelectric conversion element of the invention has the semiconductor layer containing a metal oxide formed according to the method for producing the semiconductor layer containing a metal oxide of the invention. Such a photoelectric conversion element can be produced by a method containing a step for forming a semiconductor layer containing

a metal oxide according to the method for producing the semiconductor layer containing a metal oxide of the invention.

Fig. 1 shows an embodiment of the photoelectric conversion element of the invention. The photoelectric conversion element shown in Fig. 1 is a photoelectric conversion element which is used for a general organic photovoltaic cell, but the photoelectric conversion element of the invention is not limited to the one shown in Fig. 1. The photoelectric conversion element 107 as an embodiment of the invention has a layer structure in which a base material 106, a cathode 101, an electron extraction layer 102, an active layer 103 (a layer containing a p-type semiconductor compound and an n-type semiconductor material), a hole extraction layer 104 and an anode 105 have been formed in this order.

<4-1. Buffer layer (102, 104)>

The photoelectric conversion element 107 has the electron extraction layer 102 between the cathode 101 and the active layer 103. The photoelectric conversion element 107 also has the hole extraction layer 104 between the active layer 103 and the anode 105. However, the photoelectric conversion element of the invention does not necessarily have both of the electron extraction layer 102 and the hole extraction layer 104.

The electron extraction layer 102 and the hole extraction layer 104 are preferably provided between the pair of electrodes (101 and 105) and interposing the active layer 103. That is, when the photoelectric conversion element 107 contains both of the electron extraction layer 102 and the hole extraction layer 104, it is possible to provide the electrode 105, the hole extraction layer 104, the active layer 103, the electron extraction layer 102 and the electrode 101 in this order. When the photoelectric conversion element 107 contains the electron extraction layer 102 but does not contain the hole extraction layer 104, it is possible to provide the electrode 105, the active layer 103, the electron extraction layer 102 and the electrode 101 in this order. The electron extraction layer 102 and the hole extraction layer 104 may be laminated in reverse order, and at least one of the electron extraction layer 102 and the hole extraction layer 104 may be constituted by plurality of different films.

<4-1-1. Electron extraction layer (102)>

The electron extraction layer 102 is not particularly limited and the material is not particularly limited as long as it can improve the electron extraction efficiency from the active layer 103 to the cathode 101. Specifically, an inorganic compound or an organic compound is mentioned. As the material of the inorganic compound, a salt of an alkali metal such as Li, Na, K or Cs; and a metal oxide with n-type semiconducting properties such as zinc oxide, titanium oxide, aluminum oxide or indium oxide are mentioned. The metal oxide with n-type semiconducting properties is preferably zinc oxide, titanium oxide or indium oxide, and particularly preferably zinc oxide. As the material of the organic compound, bathocuproine (BCP), bathophenanthrene (Bphen), (8-hydroxyquinolinato)aluminum (Alq3), a boron compound, an oxadiazole compound, a benzimidazole compound, naphthalenetetracarboxylic anhydride (NTCDA), perylenetetracarboxylic anhydride (PTCDA), or a phosphine compound having a double bond and containing an element in group 16 in the periodic table such as a phosphine oxide compound or a phosphine sulfide compound is specifically mentioned.

Especially, the electron extraction layer 102 in the invention preferably has the semiconductor layer containing a metal oxide formed according to the method for producing the semiconductor layer containing a metal oxide of the invention. When the electron extraction layer 102 is constituted by plurality of layers, it is sufficient that at least one of the layers is the semiconductor layer containing a metal oxide formed according to the method for producing the semiconductor layer containing a metal oxide of the invention.

The semiconductor layer containing a metal oxide formed according to the method for producing the semiconductor layer containing a metal oxide of the invention is preferably used as the electron extraction layer 102, in view of its adequate hardness and excellent evenness, and the ability to improve the photoelectric conversion efficiency of the photoelectric conversion element of the invention. It is thought that, because the film can be coated evenly by the coating method using the ink containing the metal salt of unsaturated carboxylic acid and the metal oxide having high hardness and excellent semiconducting properties is the main component of the formed film, excellent charge (especially electron) transporting function can be achieved.

The method for forming the electron extraction layer 102 is not limited. For example, the layer can be formed by a vacuum vapor deposition method or the like when a sublimable material is used. When a material soluble in a solvent is used for example, the layer can be formed by a wet coating method such as a spin coating method or an inkjet method or the like. Among them, when the electron extraction layer 102 is formed according to the method for producing the semiconductor layer containing a metal oxide of the invention, a wet coating method using the ink containing the metal salt of unsaturated carboxylic acid of the invention is used. The electron extraction layer 102 can be formed by coating the ink containing the metal salt of unsaturated carboxylic acid of the invention on a base material to form a film and then heat treating the film.

The method for coating the ink may be an optional method. Examples thereof are a spin coating method, a gravure coating method, a kiss coating method, a roll brushing method, a spray coating method, an air-knife coating

method, a wire-bar bar coating method, a pipe doctor method, an impregnation/coating method and a curtain coating method. A kind of the coating methods may be used or two or more methods may be used as a combination.

The thickness of the whole electron extraction layer 102 is not particularly limited but is generally 0.5 nm or more, preferably 1 nm or more, more preferably 5 nm or more and particularly preferably 10 nm or more. The thickness is generally 1 μm or less, preferably 700 nm or less, more preferably 400 nm or less and particularly preferably 200 nm or less. When the thickness of the electron extraction layer 102 is within the above range, it becomes easy to coat evenly and the electron extraction function is also achieved well.

<4-1-2. Hole extraction layer (104)>

The material of the hole extraction layer 104 is not particularly limited as long as it can improve the hole extraction efficiency from the active layer 103 to the anode 105. Specifically, conductive polymers in which polythiophene, polypyrrole, polyacetylene, triphenylenediamine, polyaniline or the like is doped with at least one of sulfonic acid and iodine or the like, a polythiophene derivative having sulfonyl group as a substituent, conductive organic compounds such as arylamine, Nafion, the p-type semiconductor compounds described below, metal oxides such as copper oxide, nickel oxide, manganese oxide, molybdenum oxide, vanadium oxide or tungsten oxide, are mentioned. The hole extraction layer 104 may be the semiconductor layer containing a metal oxide of the invention. Among them, the hole extraction layer 104 is preferably a conductive polymer doped with sulfonic acid, and more preferably (3,4-ethylenedioxythiophene) poly(styrenesulfonate) (PEDOT:PSS) obtained by doping a polythiophene derivative with polystyrene sulfonic acid. In addition, a thin film of a metal such as gold, indium, silver or palladium or the like can be also used. The thin film of a metal or the like may be formed individually or used with the organic materials above.

The thickness of the hole extraction layer 104 is not particularly limited but is generally 0.5 nm or more. The thickness is generally 400 nm or less and preferably 200 nm or less. When the thickness of the hole extraction layer 104 is 0.5 nm or more, the function as a buffer material is attained; and when the thickness of the hole extraction layer 104 is 400 nm or less, the holes become easier to extract and the photoelectric conversion efficiency may improve.

The method for forming the hole extraction layer 104 is not limited. For example, the layer can be formed by a vacuum vapor deposition method or the like when a sublimable material is used. When a material soluble in a solvent is used for example, the layer can be formed by a wet coating method such as a spin coating method or an inkjet method or the like. When a semiconductor material is used for the hole extraction layer 104, it is possible to form a layer using a precursor and then convert the precursor into a semiconductor compound, as for the low-molecular organic semiconductor compound of the organic active layer described below.

Among them, when PEDOT:PSS is used as the material of the hole extraction layer 104, it is preferable to form the hole extraction layer 104 by a method in which a dispersion is coated. As the PEDOT:PSS dispersion, the CLEVIOS (registered trademark) series manufactured by Heraeus Materials Technology, the ORGACON (registered trademark) series manufactured by Agfa Specialty Products and the like are mentioned.

When the hole extraction layer 104 is formed by a coating method, a surfactant may be further contained in the coating solution. Use of a surfactant prevents the generation of at least either of dents due to fine bubbles or attached foreign materials and coating unevenness during a drying step, or the like. As the surfactant, known surfactants (cationic surfactants, anionic surfactants or non-ionic surfactants) may be used. Among them, a silicon surfactant, an acetylenediol surfactant or a fluorine surfactant is preferable. A kind of the surfactants may be used or any combination of two or more kinds in any ratio may be used.

<4-2. Active layer (103)>

The active layer 103 means the layer at which the photoelectric conversion occurs, and generally contains a p-type semiconductor compound and an n-type semiconductor compound. The p-type semiconductor compound is a compound functioning as a p-type semiconductor material, and the n-type semiconductor compound is a compound functioning as an n-type semiconductor material. When the photoelectric conversion element 107 receives light, the light is absorbed by the active layer 103, and electricity is generated at the interface of the p-type semiconductor compound and the n-type semiconductor compound. The electricity is extracted from the electrodes 101 and 105.

As the material of the active layer 103, ether an inorganic compound or an organic compound may be used, but the layer is preferably a layer which can be formed by a simple coating process. A semiconductor layer containing a metal oxide formed according to the method for producing the semiconductor layer containing a metal oxide of the invention may be used. Because the photoelectric conversion efficiency is high, the active layer 103 of the invention is preferably an organic active layer made of an organic compound. The following explanation is made supposing that the active layer 103 is an organic active layer.

As the layer structure of the active layer 103, a thin-film laminate type in which a p-type semiconductor compound layer and an n-type semiconductor compound layer are laminated, a bulk heterojunction type having a layer in which

the p-type semiconductor compound and the n-type semiconductor compound are mixed, a laminate obtained by laminating a p-type semiconductor compound layer, a layer in which the p-type semiconductor compound and the n-type semiconductor compound are mixed (i layer) and an n-type semiconductor compound layer, and the like are mentioned. Among them, the bulk heterojunction type having a layer in which the p-type semiconductor compound and the n-type semiconductor compound are mixed is preferable.

The thickness of the active layer 103 is not particularly limited but generally 10 nm or more and preferably 50 nm or more. The thickness is generally 1000 nm or less, preferably 500 nm or less and more preferably 200 nm or less. The thickness of the active layer 103 of 10 nm or more is preferable because the evenness of the film is maintained and a short circuit is unlikely to occur. The thickness of the active layer 103 of 1000 nm or less is preferable because the internal resistance becomes smaller and the distance between the electrodes (the cathode 101 and the anode 105) is not too long resulting in excellent dispersion of charges.

The method for forming the active layer 103 is not particularly limited but a coating method is preferable. The coating method may be an optional method, but for example, a spin coating method, a reverse roll coating method, a gravure coating method, a kiss coating method, a roll brushing method, a spray coating method, an air-knife coating method, a wire-bar bar coating method, a pipe doctor method, an impregnation/coating method, a curtain coating method and the like are mentioned.

For example, the p-type semiconductor compound layer and the n-type semiconductor compound layer can be produced by coating a coating solution containing the p-type semiconductor compound or the n-type semiconductor compound. The layer in which the p-type semiconductor compound and the n-type semiconductor compound are mixed can be produced by coating a coating solution containing the p-type semiconductor compound and the n-type semiconductor compound. As described below, it is also possible to coat a coating solution containing a semiconductor compound precursor and then convert the semiconductor compound precursor into the semiconductor compound.

<4-2-1. p-Type semiconductor compound>

The p-type semiconductor compound which the active layer 103 contains is not particularly limited but a low-molecular organic semiconductor compound and a high-molecular organic semiconductor compound are mentioned.

<4-2-1-1. Low-molecular organic semiconductor compound>

Both upper limit and lower limit for the molecular weight of the low-molecular organic semiconductor compound are not particularly limited, but the molecular weight is generally 5000 or less and preferably 2000 or less, and generally 100 or more and preferably 200 or more.

The low-molecular organic semiconductor compound is preferably a crystalline compound. The interaction between the molecules of a crystalline p-type semiconductor compound is strong and the holes generated at the interface of the p-type semiconductor compound and the n-type semiconductor compound in the active layer 103 can be transported to the anode 105 efficiently. The crystalline property in the specification is a compound's property for taking a three-dimensional periodic arrangement which is well-ordered due to the interaction between the molecules and the like. As the method for measuring the crystalline property, an X-ray diffraction (XRD) method, a method for measuring field effect mobility or the like is mentioned. In particular, in the measurement of the field effect mobility, the hole mobility is preferably $1.0 \times 10^{-5}$ $cm^2/Vs$ or more and more preferably $1.0 \times 10^{-4}$ $cm^2/Vs$ or more. The hole mobility is generally preferably $1.0 \times 10^{4}$ $cm^2/Vs$ or less, more preferably $1.0 \times 10^{3}$ $cm^2/Vs$ or less and further preferably $1.0 \times 10^{2}$ $cm^2/Vs$ or less.

The low-molecular organic semiconductor compound is not particularly limited as long as it functions as a p-type semiconductor material, but specifically, condensed aromatic hydrocarbons such as naphthacene, pentacene or pyrene; oligothiophenes containing four or more thiophene rings such as $\alpha$-sexithiophene; compounds which contain at least one of thiophene ring, benzene ring, fluorene ring, naphthalene ring, anthracene ring, thiazole ring, thiadiazole ring and benzothiazole ring and in which four or more rings in total are linked; macrocyclic compounds such as phthalocyanine compounds and metal complexes thereof, or porphyrin compounds such as tetrabenzoporphyrin and metal complexes thereof, and the like are mentioned. Preferably, phthalocyanine compounds and metal complexes thereof, or porphyrin compounds and metal complexes thereof are mentioned.

Examples of the porphyrin compounds and metal complexes thereof ($Z^1$ is CH in the following formulae), and phthalocyanine compounds and metal complexes thereof ($Z^1$ is N in the following formulae) are compounds having the following structures.

[Chem. 4]

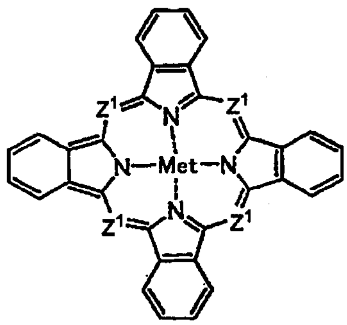

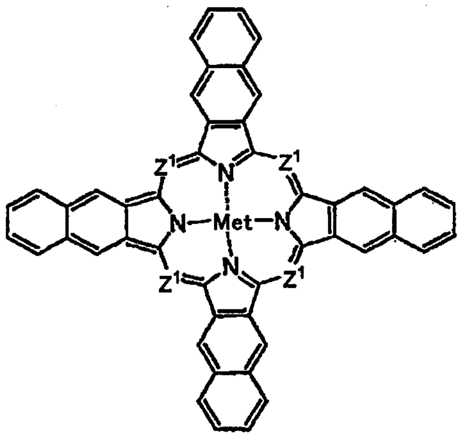

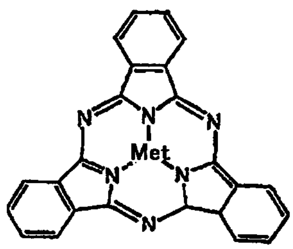

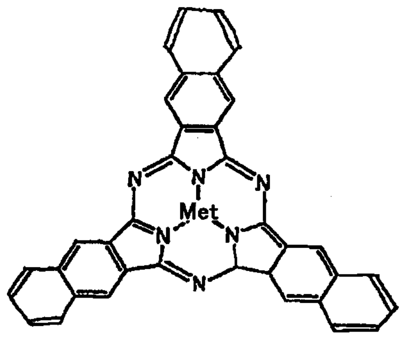

[Chem. 5]

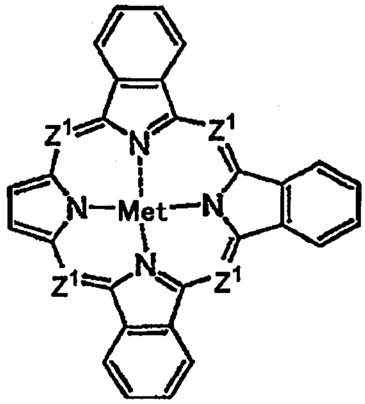

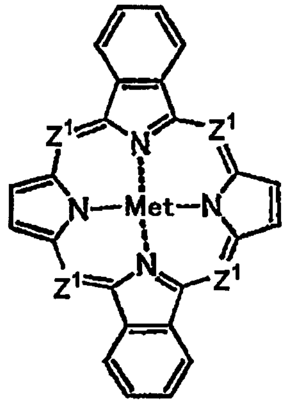

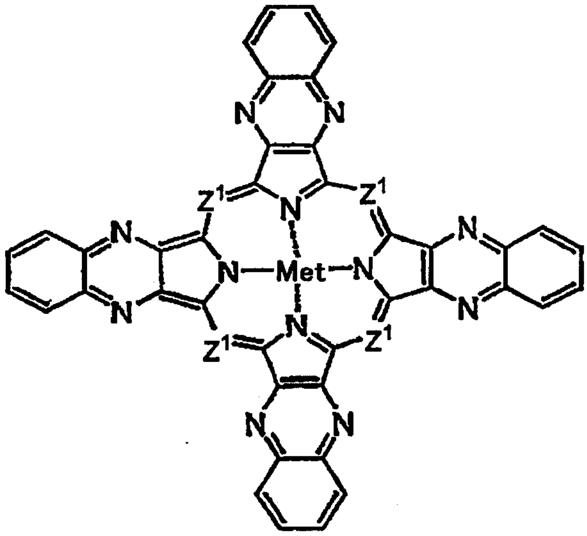

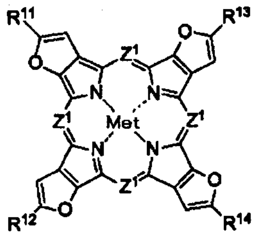

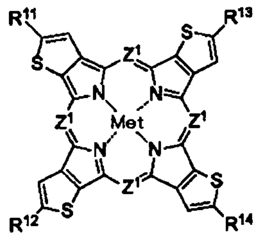

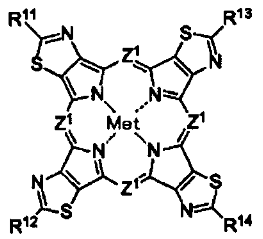

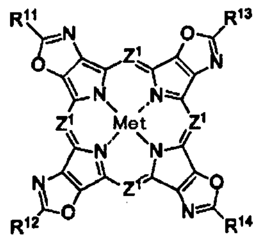

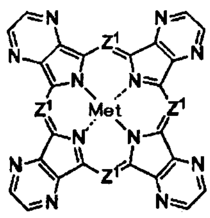

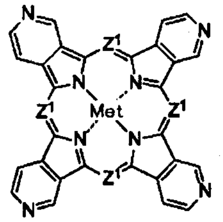

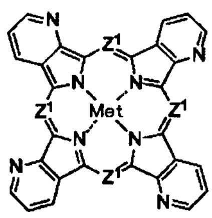

Here, Met means a metal or two hydrogen atoms. As the metal, tri- or higher-valent metals with an axial ligand such as TiO, VO, $SnCl_2$, AlCl, InCl or $Si(OH)_2$ are mentioned in addition to divalent metals such as Cu, Zn, Pb, Mg, Pd, Ag, Co or Ni.

$Z^1$ is CH or N.

$R^{11}$ to $R^{14}$ are independently hydrogen atom or an alkyl group having 1 to 24 carbon atoms. The alkyl group having 1 to 24 carbon atoms is a saturated or unsaturated chain hydrocarbon group having 1 to 24 carbon atoms, or a saturated or unsaturated cyclic hydrocarbon having 3 to 24 carbon atoms. Among them, a saturated or unsaturated chain hydrocarbon group having 1 to 12 carbon atoms, or a saturated or unsaturated cyclic hydrocarbon having 3 to 12

carbon atoms is preferable.

Among the phthalocyanine compounds and metal complexes thereof, 29H,31H-phthalocyanine, a copper phthalocyanine complex, a zinc phthalocyanine complex, a titanium phthalocyanine oxide complex, a magnesium phthalocyanine complex, a lead phthalocyanine complex or copper 4,4',4",4"'-tetraaza-29H,31H-phthalocyanine complex is preferable, and 29H,31H-phthalocyanine or a copper phthalocyanine complex is more preferable. A kind of the above compounds may be used or a mixture of two or more of the compounds may be used.

Among the porphyrin compounds and metal complexes thereof, 5,10,15,20-tetraphenyl-21H,23H-porphine, 5,10,15,20-tetraphenyl-21H,23H-porphine cobalt(II), 5,10,15,20-tetraphenyl-21H,23H-porphine copper(II), 5,10,15,20-tetraphenyl-21 H,23H-porphine zinc(II), 5,10,15,20-tetraphenyl-21H,23H-porphine nickel(II), 5,10,15,20-tetraphenyl-21H,23H-porphine vanadium(IV) oxide, 5,10,15,20-tetra(4-pyridyl)-21H,23H-porphine, 29H,31H-tetrabenzo[b,g,l,q]porphine, 29H,31H-tetrabenzo[b,g,l,q]porphine cobalt(II), 29H,31H-tetrabenzo[b,g,l,q]porphine copper(II), 29H,31H-tetrabenzo[b,g,l,q]porphine zinc(II), 29H,31H-tetrabenzo[b,g,l,q]porphine nickel(II) or 29H,31H-tetrabenzo[b,g,l,q]porphine vanadium(IV) oxide is preferable, and 5,10,15,20-tetraphenyl-21H,23H-porphine or 29H,31H-tetrabenzo[b,g,l,q]porphine is preferable. A kind of the above compounds may be used or a mixture of two or more of the compounds may be used.

As the method for forming a film of the low-molecular organic semiconductor compound, a vapor deposition method and a coating method are mentioned. In view of the advantages of the process that the film formation by coating is possible, the latter method is preferable. When a coating method is used, there is a method in which a precursor of the low-molecular organic semiconductor compound is coated and then converted into the low-molecular organic semiconductor compound. Because the film formation by coating is easier, the method in which a semiconductor compound precursor is used is more preferable.

(Precursor of low-molecular organic semiconductor compound)

The precursor of the low-molecular organic semiconductor compound is a compound which is converted into the low-molecular organic semiconductor compound due to the change of the chemical structure caused by external stimuli such as heat and light irradiation. It is preferable that the film formability of the precursor of the low-molecular organic semiconductor compound is excellent. In particular, in order that a coating method can be applied, it is preferable that the precursor itself is a liquid and can be coated, or the precursor is highly soluble in a solvent and can be coated as a solution. Therefore, the solubility of the precursor of the low-molecular organic semiconductor compound in a solvent is generally 0.1% by mass or more, preferably 0.5% by mass or more and more preferably 1% by mass or more. The upper limit thereof is not particularly limited, but the solubility is generally 50% by mass or less and preferably 40% by mass or less.

The kind of the solvent is not particularly limited as long as the semiconductor precursor compound can be dissolved or dispersed homogeneously. Examples thereof are aliphatic hydrocarbons such as hexane, heptane, octane, isooctane, nonane or decane; aromatic hydrocarbons such as toluene, xylene, cyclohexylbenzene, chlorobenzene or ortho-dichlorobenzene; alcohols such as methanol, ethanol or propanol; ketones such as acetone, methyl ethyl ketone, cyclopentanone or cyclohexanone; esters such as ethyl acetate, butyl acetate or methyl lactate; halogenated hydrocarbons such as chloroform, methylene chloride, dichloroethane, trichloroethane or trichloroethylene; ethers such as ethyl ether, tetrahydrofuran or dioxane; and amides such as dimethylformamide or dimethylacetamide. Among them, aromatic hydrocarbons such as toluene, xylene, cyclohexylbenzene, chlorobenzene or ortho-dichlorobenzene; ketones such as acetone, methyl ethyl ketone, cyclopentanone or cyclohexanone; halogenated hydrocarbons such as chloroform, methylene chloride, dichloroethane, trichloroethane or trichloroethylene; and ethers such as ethyl ether, tetrahydrofuran or dioxane are preferable. Non-halogenated aromatic hydrocarbons such as toluene, xylene or cyclohexylbenzene; non-halogenated ketones such as cyclopentanone or cyclohexanone; and non-halogenated aliphatic ethers such as tetrahydrofuran or 1,4-dioxane are more preferable. Non-halogenated aromatic hydrocarbons such as toluene, xylene or cyclohexylbenzene are particularly preferable. A kind of the solvents may be used alone or any combination of two or more kinds of the solvents in any ratio may be used.

In addition, the precursor of the low-molecular organic semiconductor compound can be preferably converted easily into the semiconductor compound. In the conversion step from the precursor of the low-molecular organic semiconductor compound into the semiconductor compound, which is described below, it is optionally determined what external stimuli are applied to the semiconductor precursor, but in general, heat treatment, light treatment or the like is conducted. Preferably, heat treatment is conducted. In this case, the precursor of the low-molecular organic semiconductor compound preferably has, as a part of the skeleton structure, a group which can leave by the retro-Diels-Alder reaction and which has affinity for the specific solvent.

Moreover, the precursor of the low-molecular organic semiconductor compound is preferably converted into the semiconductor compound in high yield through the conversion step. In this regard, the yield of the semiconductor compound obtained by the conversion of the precursor of the low-molecular organic semiconductor compound is any

degree as long as the properties of the photoelectric conversion element are not diminished, but the yield of the low-molecular organic semiconductor compound obtained from the precursor of the low-molecular organic semiconductor compound is generally 90% by mol or more, preferably 95% by mol or more and more preferably 99% by mol or more.

The precursor of the low-molecular organic semiconductor compound is not particularly limited as long as it has the above characteristics, but specifically, the compounds described in JP-A-2007-324587 and the like can be used. Among them, the compound represented by the following formula is mentioned as a preferable example.

[Chem. 6]

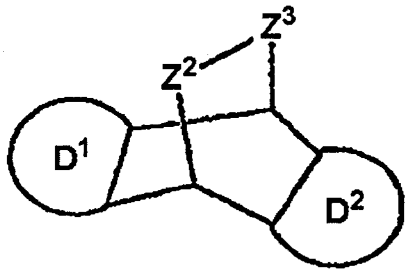

In the above formula, at least one of $D^1$ and $D^2$ means a group forming a π-conjugated divalent aromatic ring. $Z^2$-$Z^3$ means a group which can leave by heat or light, and the π-conjugated compound obtained when $Z^2$-$Z^3$ leaves is the low-molecular organic semiconductor compound. One of $D^1$ and $D^2$ which does not form a π-conjugated divalent aromatic ring, if any, means a substituted or unsubstituted ethenylene group.

As shown in the chemical reaction formula below, the compound represented by the above formula produces a π-conjugated compound with high degree of flatness after $Z^2$-$Z^3$ leaves by heat or light. The produced π-conjugated compound is the low-molecular organic semiconductor compound. This low-molecular organic semiconductor compound is used as the material having p-type semiconducting properties.

[Chem. 7]

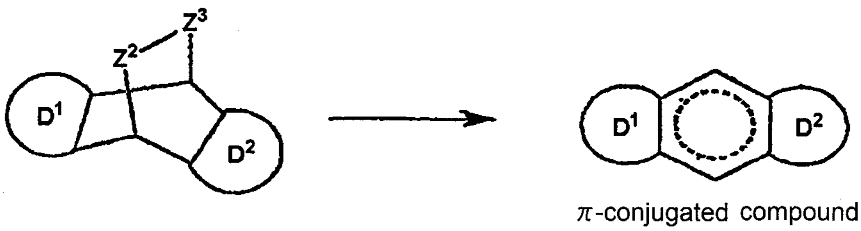

π-conjugated compound

Following compounds are mentioned as examples of the precursor of the low-molecular organic semiconductor compound. In the following formulae, t-Bu means t-butyl group and Met is the same as explained for the porphyrin and phthalocyanine.

[Chem. 8]

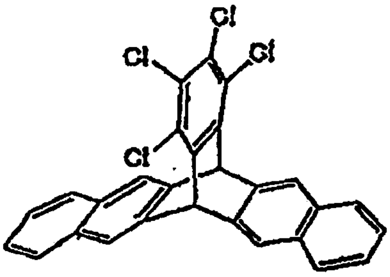

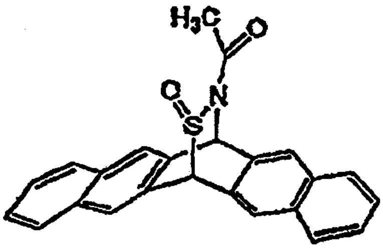

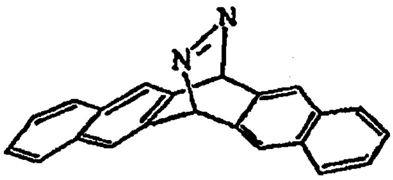

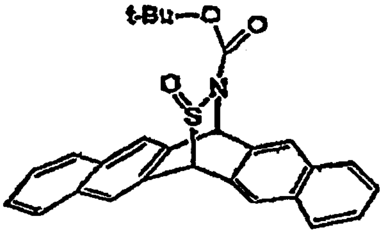

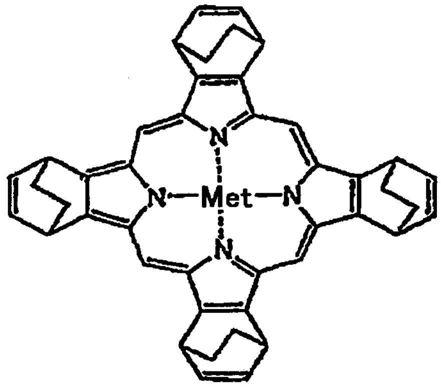

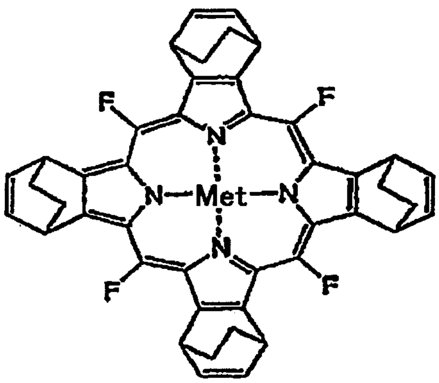

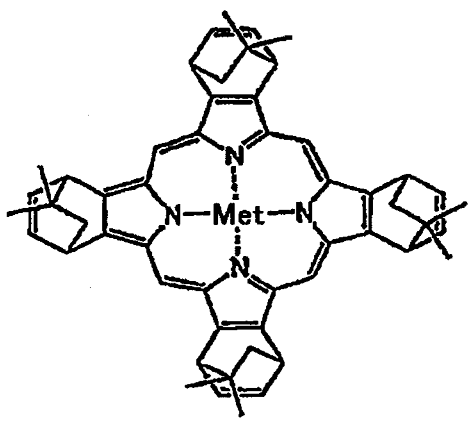

[Chem. 9]

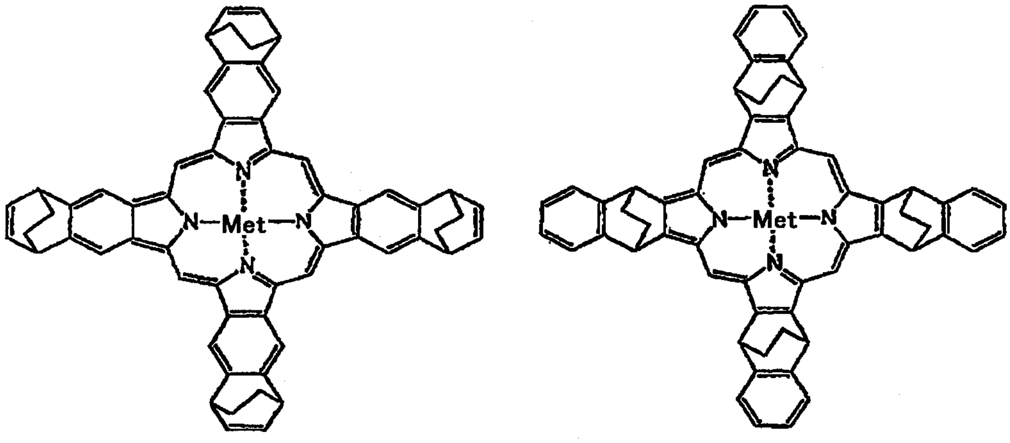

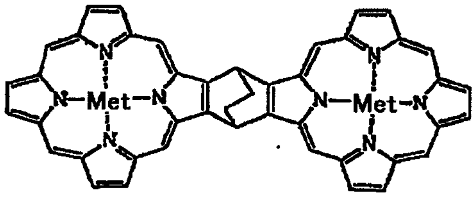

Specific examples of the conversion from the precursor of the low-molecular organic semiconductor compound into the low-molecular organic semiconductor compound are as follows.

[Chem. 10]

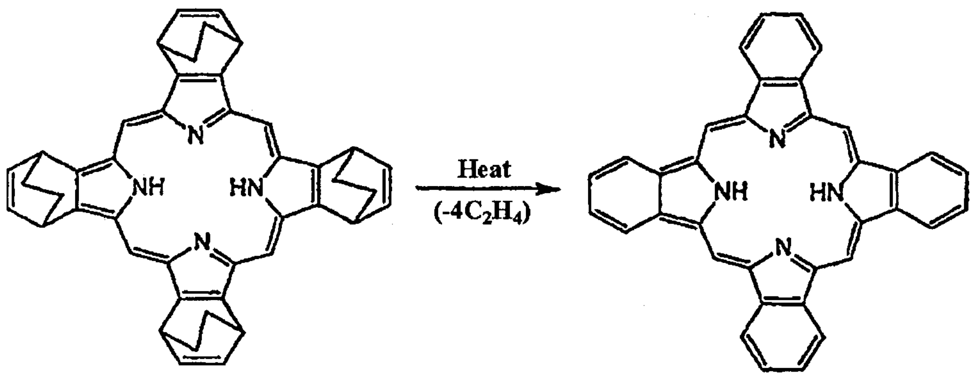


[Chem. 11]

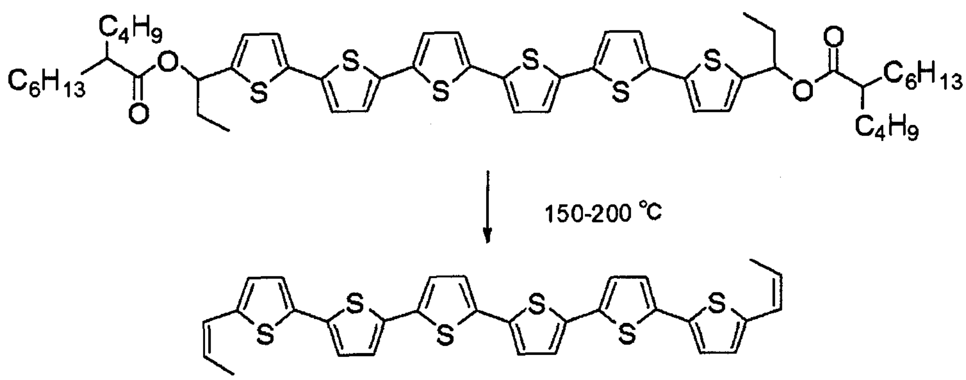

[Chem. 12]

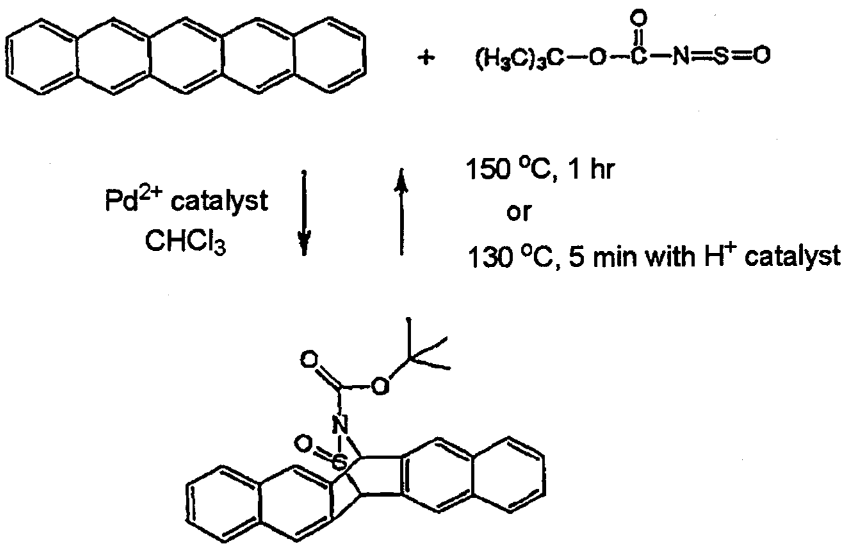


[Chem. 13]

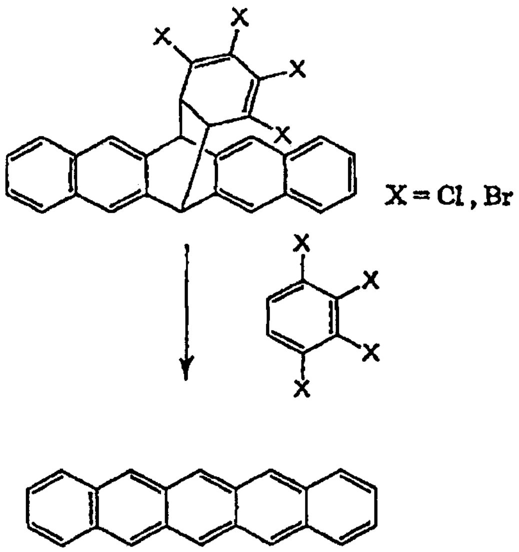


The precursor of the low-molecular organic semiconductor compound may have a structure with positional isomers, and may be a mixture of two or more positional isomers in this case. A mixture of positional isomers is preferable because, as compared with the precursor of the low-molecular organic semiconductor compound containing a single positional isomer component, the solubility in a solvent improves and the film formation by coating is easier. Although the full mechanism as to why the solubility of a mixture of positional isomers is high is not known yet, it is supposed that while the crystalline property of the compound itself is potentially maintained, the three-dimensional regular interaction between the molecules becomes difficult when two or more positional isomers are mixed in a solution. The solubility of the mixture of positional isomers in a non-halogen solvent is generally 0.1% by mass or more, preferably 1% by mass or more and more preferably 5% by mass or more. The upper limit is not limited but the solubility is generally 50% by mass or less and more preferably 40% by mass or less.

<4-2-1-2. High-molecular organic semiconductor compound>

The high-molecular organic semiconductor compound is not particularly limited, but conjugated polymer semiconductors such as polythiophene, polyfluorene, polyphenylenevinylene, polythienylenevinylene, polyacetylene or polyaniline; polymer semiconductors such as oligothiophenes substituted with an alkyl group or another substituent; and the like are mentioned. In addition, semiconductor polymers obtained by copolymerizing two or more kinds of monomer unit are also mentioned. Examples of the conjugated polymers are the polymers and the derivatives thereof described in known documents such as Handbook of Conducting Polymers, 3rd Ed. (two volumes in total), 2007; Materials Science and Engineering, 2001, 32, 1-40; Pure Appl. Chem. 2002, 74, 2031-3044; and Handbook of THIOPHENE-BASED MATERIALS (two volumes in total), 2009: and polymers which can be synthesized from a combination of described monomers. The high-molecular organic semiconductor compound used as the p-type semiconductor compound may be a single compound or a mixture of compounds.

The monomer skeletons and the substituents of the monomers of the high-molecular organic semiconductor compound can be determined to control the solubility, crystalline property, film formability, HOMO energy level, LUMO energy level and the like. In addition, it is preferable that the high-molecular organic semiconductor compound is soluble in an organic solvent because the active layer 103 can be formed by a coating method during the production of the photoelectric conversion element. Although the following compounds can be mentioned as specific examples of the high-molecular organic semiconductor compound, the compound is not limited to these compounds.

[Chem. 14]

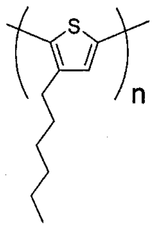

P3HT

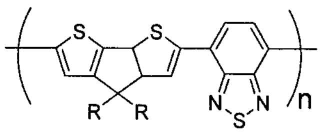

R = 2-ethylhexyl

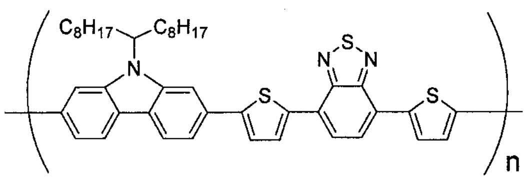

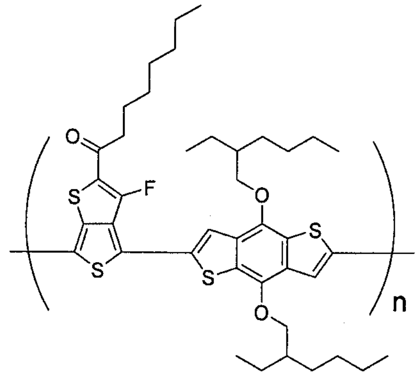

PBDTTT-CF

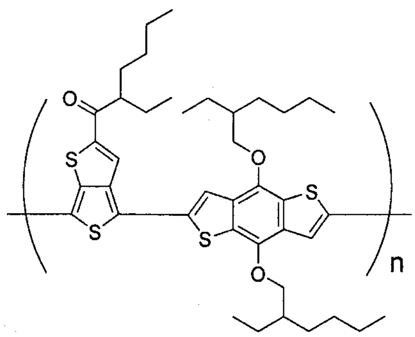

PBDTTT-C

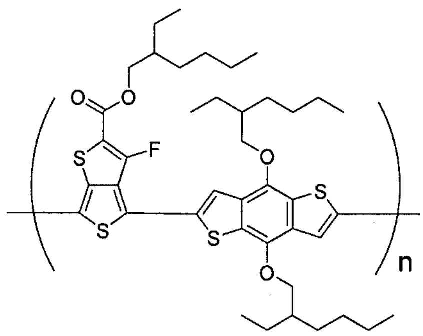

PTB7

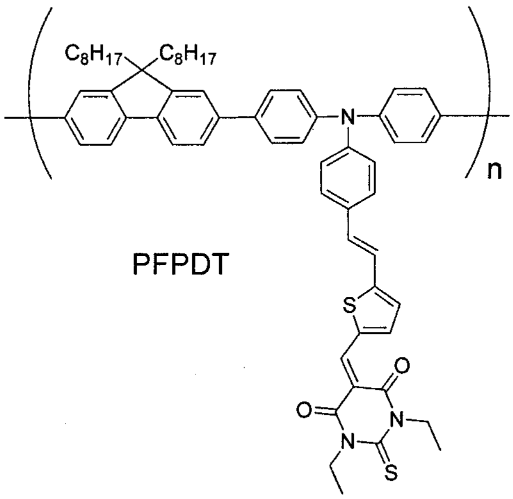

PFPDT

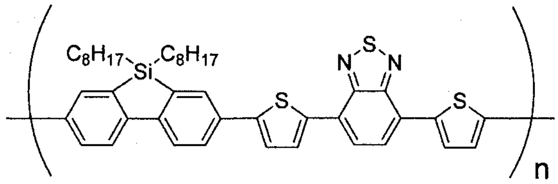

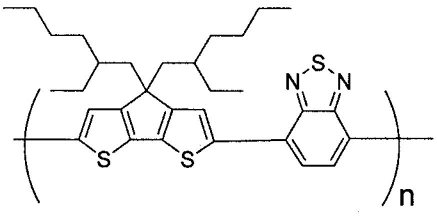

PCPDTBT

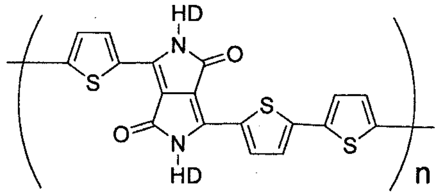

PDPP3T

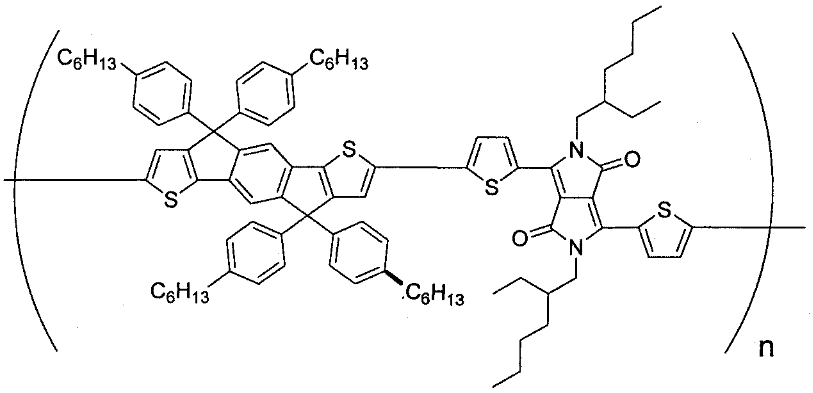

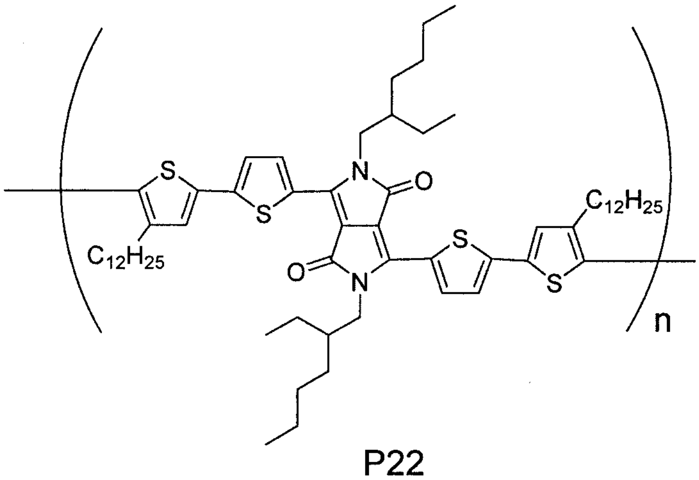

P22

[Chem. 15]

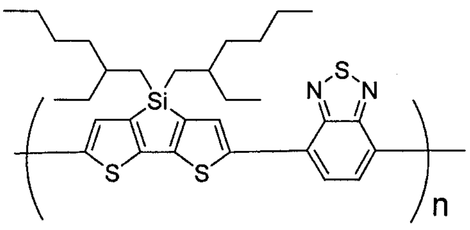

PSBTBT

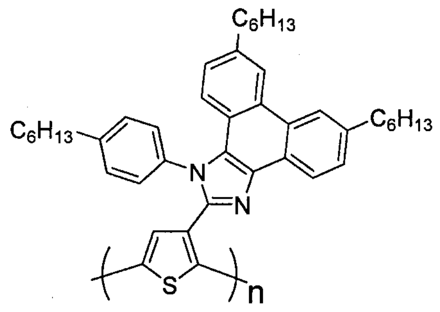

PHPIT

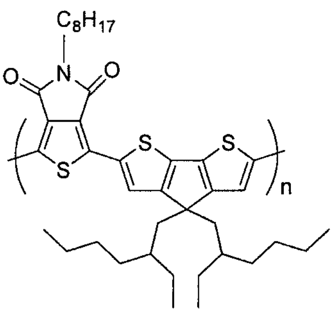

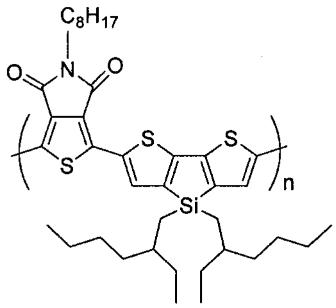

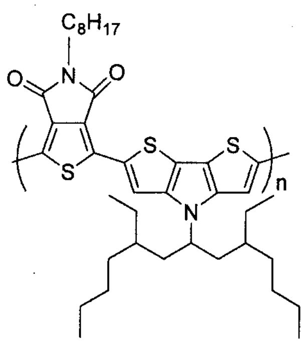

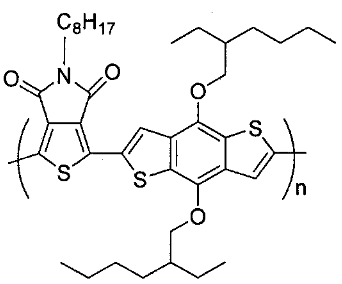

Among them, the p-type semiconductor compound is preferably: a condensed aromatic hydrocarbon such as naphthacene, pentacene or pyrene, a phthalocyanine compound and a metal complex thereof, or a porphyrin compound such as tetrabenzoporphyrin (BP) and a metal complex thereof, as the low-molecular organic semiconductor compound; and a conjugated polymer semiconductor such as polythiophene as the high-molecular organic semiconductor compound. Then p-type semiconductor compound used for the active layer 103 may be a kind of compound or a mixture of compounds.

At least one of the low-molecular organic semiconductor compound and the high-molecular organic semiconductor compound may have any self-assembled structure in a film state or may be in an amorphous state.

The HOMO (highest occupied molecular orbital) energy level of the p-type semiconductor compound is not particularly limited and can be determined depending on the kind of the n-type semiconductor compound below. In particular, when a fullerene compound is used as the n-type semiconductor compound, the HOMO energy level of the p-type semiconductor compound is generally -5.7 eV or more and more preferably -5.5 eV or more, and generally -4.6 eV or less and more preferably -4.8 eV or less. When the HOMO energy level of the p-type semiconductor compound is -5.7 eV or more, the properties as the p-type semiconductor improve, and the stability of the compound improves and the open voltage (Voc) also becomes high when the HOMO energy level of the p-type semiconductor compound is -4.6 eV or less.

The LUMO (lowest unoccupied molecular orbital) energy level of the p-type semiconductor compound is not particularly limited and can be determined depending on the kind of the n-type semiconductor compound below. In particular, when a fullerene compound is used as the n-type semiconductor compound, the LUMO energy level of the p-type semiconductor compound is generally -3.7 eV or more and preferably -3.6 eV or more. The LUMO energy level is generally -2.5 eV or less and preferably -2.7 eV or less. When the LUMO energy level of the p-type semiconductor is -2.5 eV or less, the band gap is adjusted and the energy of light with a long wavelength can be absorbed efficiently,

resulting in the improved short-circuit current density. When the LUMO energy level of the p-type semiconductor compound is -3.7 eV or more, the electrons are more likely to move to the n-type semiconductor compound, resulting in the improved short-circuit current density.

<4-2-2. n-Type semiconductor compound>

The n-type semiconductor compound is not particularly limited, but the following compounds are specifically mentioned: quinolinol derivative metal complexes represented by a fullerene compound and 8-hydroxyquinoline aluminum; condensed ring tetracarboxylic diimides such as naphthalenetetracarboxylic diimide or perylenetetracarboxylic diimide; complete fluorides of condensed polycyclic aromatic hydrocarbons such as a perylene diimide derivative, a terpyridine metal complex, a tropolone metal complex, a flavonol metal complex, a perinone derivative, a benzimidazole derivative, a benzoxazole derivative, a thiazole derivative, a benzothiazole derivative, a benzothiadiazole derivative, an oxadiazole derivative, a thiadiazole derivative, a triazole derivative, an aldazine derivative, a bisstyryl derivative, a pyrazine derivative, a phenanthroline derivative, a quinoxaline derivative, a benzoquinoline derivative, a bipyridine derivative, a borane derivative, anthracene, pyrene, naphthacene or pentacene; and a single-walled carbon nanotube and the like.

Among them, a fullerene compound, a borane derivative, a thiazole derivative, a benzothiazole derivative, a benzothiadiazole derivative, N-alkyl-substituted naphthalenetetracarboxylic diimide and an N-alkyl-substituted perylene diimide derivative are preferable; and a fullerene compound, an N-alkyl-substituted perylene diimide derivative and N-alkyl-substituted naphthalenetetracarboxylic diimide are more preferable. A kind of the above compounds may be used or a mixture of two or more thereof may be used. In addition, an n-type high-molecular semiconductor compound is also mentioned as the n-type semiconductor compound.

The LUMO energy level of the n-type semiconductor compound is not particularly limited, but the value relative to the vacuum level calculated by a cyclic voltammogram measurement method for example is generally -3.85 eV or more and preferably -3.80 eV or more. In order to move electrons efficiently from the p-type semiconductor compound to the n-type semiconductor compound, the correlation of the LUMO energy levels between the p-type semiconductor compound and the n-type semiconductor compound is important. Specifically, it is preferable that the LUMO energy level of the p-type semiconductor compound is higher than the LUMO energy level of the n-type semiconductor compound by a certain level, that is, the electron affinity of the n-type semiconductor compound is higher than the electron affinity of the p-type semiconductor compound by certain energy. Because the open voltage (Voc) depends on the difference between the HOMO energy level of the p-type semiconductor compound and the LUMO energy level of the n-type semiconductor compound, the Voc tends to increase when the LUMO of the n-type semiconductor compound is increased. On the other hand, the LUMO value is generally -1.0 eV or less, preferably -2.0 eV or less, more preferably -3.0 eV or less and further preferably -3.3 eV or less. By decreasing the LUMO energy level of the n-type semiconductor compound, electrons are more likely to move and the short-circuit current (Jsc) tends to increase.

As the method for calculating the LUMO energy level of the n-type semiconductor compound, a method for theoretically calculating the level and a method for actually measuring the level are mentioned. As the method for theoretically calculating the level, a semi-empirical molecular orbital method and a non-empirical molecular orbital method are mentioned. As the method for actually measuring the level, an ultraviolet-visible absorption spectral measurement method or a cyclic voltammogram measurement method is mentioned. Among them, a cyclic voltammogram measurement method is preferable.

The HOMO energy level of the n-type semiconductor compound is not particularly limited, but is generally -5.0 eV or less and preferably -5.5 eV or less. The level is generally -7.0 eV or more and preferably -6.6 eV or more. The HOMO energy level of the n-type semiconductor compound of -7.0 eV or more is preferable, because the light absorption of the n-type semiconductor compound can be also used for the power generation. The HOMO energy level of the n-type semiconductor compound of -5.0 eV or less is preferable for preventing holes from moving in the wrong direction.

The electron mobility of the n-type semiconductor compound is not particularly limited, but is generally $1.0\times10^{-6}$ $cm^2/Vs$ or more, preferably $1.0\times10^{-5}$ $cm^2/Vs$ or more, more preferably $5.0\times10^{-5}$ $cm^2/Vs$ or more and further preferably $1.0\times10^{-4}$ $cm^2/Vs$ or more. The electron mobility is generally $1.0\times10^{3}$ $cm^2/Vs$ or less, preferably $1.0\times10^{2}$ $cm^2/Vs$ or less and more preferably $5.0\times10^{1}$ $cm^2/Vs$ or less. The electron mobility of the n-type semiconductor compound of $1.0\times10^{-6}$ $cm^2/Vs$ or more is preferable because it may be possible to achieve the effects such as the improvement of the diffusion rate of electrons of the photoelectric conversion element, the improvement of the short-circuit current, and the improvement of the conversion efficiency. As the method for measuring the electron mobility, a field effect transistor (FET) method is mentioned and the electron mobility can be measured by methods described in a known document (JP-A-2010-045186).

The solubility of the n-type semiconductor compound in toluene at 25°C is generally 0.5% by mass or more, preferably 0.6% by mass or more and more preferably 0.7% by mass or more. The solubility is preferably 90% by mass or less in general, more preferably 80% by mass or less and further preferably 70% by mass or less. The solubility of

the n-type semiconductor compound in toluene at 25°C of 0.5% by mass or more is preferable, because the dispersion stability of the n-type semiconductor compound in a solution improves, and the cohesion, sedimentation, separation and the like are unlikely to occur.

Preferable examples of the n-type semiconductor compound are explained below.

<4-2-2-1. Fullerene compound>

As the fullerene compound, those having the partial structures represented by the general formulae (n1), (n2), (n3) and (n4) are mentioned as preferable examples.

[Chem. 16]

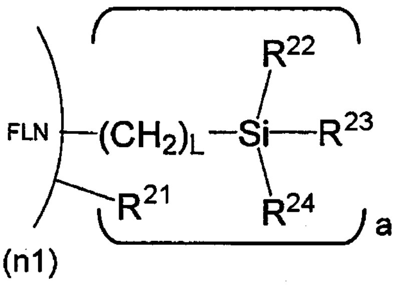

(n1)

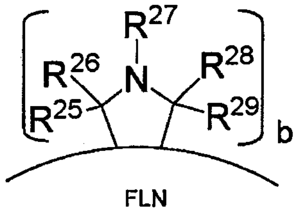

(n2)

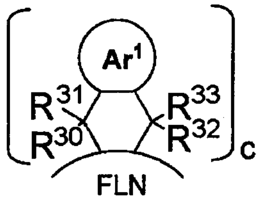

(n3)

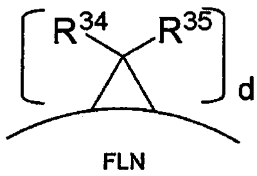

(n4)

In the above formulae, FLN means fullerene as the carbon cluster having a closed shell structure. The carbon number of the fullerene may be any even number of generally 60 to 130. As the fullerene, higher-order carbon clusters of for example $C_{60}$, $C_{70}$, $C_{76}$, $C_{78}$, $C_{82}$, $C_{84}$, $C_{90}$, $C_{94}$, $C_{96}$, and those having more carbon atoms, and the like are mentioned. Among them, $C_{60}$ or $C_{70}$ is preferable. As the fullerene, a part of the carbon-carbon bonds on the fullerene ring may be broken. Furthermore, a part of the carbon atoms forming the fullerene may be replaced with other atoms. The fullerene may encapsulate a metal atom, a non-metal atom, or an atom group of these atoms inside the fullerene cage.

a, b, c and d are integers. The total of a, b, c and d is generally 1 or more, and generally 5 or less and preferably 3 or less. The partial structures in (n1), (n2), (n3) and (n4) are bonded to the same five-membered ring or six-membered ring of the fullerene skeleton. In the general formula (n1), $-R^{21}$ and $-(CH_2)_L$ are bonded to two adjacent carbon atoms on the same five-membered ring or six-membered ring of the fullerene skeleton. In the general formula (n2), $-C(R^{25})(R^{26})-N(R^{27})-C(R^{28})(R^{29})-$ is bonded to a five-membered ring or six-membered ring of the fullerene skeleton at two adjacent carbon atoms on the ring and forms a five-membered ring. In the general formula (n3), $-C(R^{30})(R^{31})-C-C-C(R^{32})(R^{33})-$ is bonded to a five-membered ring or six-membered ring of the fullerene skeleton at two adjacent carbon atoms on the ring and forms a six-membered ring. In the general formula (n4), $-C(R^{34})(R^{35})-$ is bonded to a five-membered ring or six-membered ring of the fullerene skeleton at two adjacent carbon atoms on the ring and forms a three-membered ring. L is an integer of 1 to 8. L is preferably an integer of 1 to 4 and further preferably an integer of 1 or 2.

$R^{21}$ in the general formula (n1) is an alkyl group having 1 to 14 carbon atoms which may be substituted, an alkoxy group having 1 to 14 carbon atoms which may be substituted or an aromatic group which may be substituted.

The alkyl group is preferably an alkyl group having 1 to 10 carbon atoms; more preferably methyl group, ethyl group, n-propyl group, isopropyl group, n-butyl group or isobutyl group; and further preferably methyl group or ethyl group. The alkoxy group is preferably an alkoxy group having 1 to 10 carbon atoms, more preferably an alkoxy group having 1 to 6 carbon atoms, and particularly preferably methoxy group or ethoxy group. The aromatic group is preferably an aromatic hydrocarbon group having 6 to 20 carbon atoms or an aromatic heterocyclic group having 2 to 20 carbon atoms; more preferably phenyl group, thienyl group, furyl group or pyridyl group; and further preferably phenyl group or

thienyl group.

The substituent which the alkyl group, the alkoxy group and the aromatic group above may have is not particularly limited, but is preferably a halogen atom or a silyl group. The halogen atom is preferably fluorine atom. The silyl group is preferably a diarylalkyl silyl group, a dialkylaryl silyl group, a triaryl silyl group or a trialkyl silyl group, more preferably a dialkylaryl silyl group, and further preferably a dimethylaryl silyl group.

$R^{22}$ to $R^{24}$ in the general formula (n1) are independently hydrogen atom, an alkyl group having 1 to 14 carbon atoms which may be substituted or an aromatic group which may be substituted.

The alkyl group is preferably an alkyl group having 1 to 10 carbon atoms, and preferably methyl group, ethyl group, n-propyl group, isopropyl group, n-butyl group, isobutyl group, t-butyl group or n-hexyl group. The substituent which the alkyl group may have is preferably a halogen atom. The halogen atom is preferably fluorine atom. The alkyl group substituted with fluorine atom is preferably, perfluorooctyl group, perfluorohexyl group or perfluorobutyl group.

The aromatic group is preferably an aromatic hydrocarbon group having 6 to 20 carbon atoms or an aromatic heterocyclic group having 2 to 20 carbon atoms; more preferably phenyl group, thienyl group, furyl group or pyridyl group; and further preferably phenyl group or thienyl group. The substituent which the aromatic group may have is not particularly limited: but preferably fluorine atom, an alkyl group having 1 to 14 carbon atoms, a fluorinated alkyl group having 1 to 14 carbon atoms, an alkoxy group having 1 to 14 carbon atoms or an aromatic group having 3 to 10 carbon atoms; more preferably fluorine atom or an alkoxy group having 1 to 14 carbon atoms; and further preferably methoxy group, n-butoxy group or 2-ethylhexyloxy group. When the aromatic group is substituted, the number of the substituents is not limited but is preferably 1 to 3 and more preferably 1. When the aromatic group has more than one substituent, the substituents may be different but are preferably the same.

$R^{25}$ to $R^{29}$ in the general formula (n2) are independently hydrogen atom, an alkyl group having 1 to 14 carbon atoms which may be substituted or an aromatic group which may be substituted.

The alkyl group is preferably methyl group, ethyl group, n-propyl group, isopropyl group, n-butyl group, isobutyl group, n-hexyl group or octyl group, and more preferably methyl group. The substituent which the alkyl group may have is not particularly limited, but is preferably a halogen atom. The halogen atom is preferably fluorine atom. The alkyl group substituted with fluorine atom is preferably, perfluorooctyl group, perfluorohexyl group or perfluorobutyl group.

The aromatic group is preferably an aromatic hydrocarbon group having 6 to 20 carbon atoms or an aromatic heterocyclic group having 2 to 20 carbon atoms; more preferably phenyl group or pyridyl group; and further preferably phenyl group. The substituent which the aromatic group may have is not particularly limited, but is preferably fluorine atom, an alkyl group having 1 to 14 carbon atoms or an alkoxy group having 1 to 14 carbon atoms. The alkyl group may be substituted with fluorine atom. It is further preferably an alkoxy group having 1 to 14 carbon atoms and further preferably methoxy group. When the aromatic group is substituted, the number of the substituents is not limited but is preferably 1 to 3 and more preferably 1. The substituents may be different but are preferably the same.

$Ar^1$ in the general formula (n3) is an aromatic hydrocarbon group having 6 to 20 carbon atoms which may be substituted or an aromatic heterocyclic group having 2 to 20 carbon atoms; preferably phenyl group, naphthyl group, biphenyl group, thienyl group, furyl group, pyridyl group, pyrimidyl group, quinolyl group or quinoxalyl group; and further preferably phenyl group, thienyl group or furyl group.

The substituent is not limited: but is preferably fluorine atom, chlorine atom, hydroxyl group, cyano group, silyl group, boryl group, amino group which may be substituted with an alkyl group, an alkyl group having 1 to 14 carbon atoms, an alkoxy group having 1 to 14 carbon atoms, an alkylcarbonyl group having 2 to 14 carbon atoms, an alkylthio group having 1 to 14 carbon atoms, an alkenyl group having 2 to 14 carbon atoms, an alkynyl group having 2 to 14 carbon atoms, an ester group having 2 to 14 carbon atoms, an arylcarbonyl group having 3 to 20 carbon atoms, an arylthio group having 2 to 20 carbon atoms, an aryloxy group having 2 to 20 carbon atoms, an aromatic hydrocarbon group having 6 to 20 carbon atoms or a heterocyclic group having 2 to 20 carbon atoms; and more preferably fluorine atom, an alkyl group having 1 to 14 carbon atoms, an alkoxy group having 1 to 14 carbon atoms, an ester group having 2 to 14 carbon atoms, an alkylcarbonyl group having 2 to 14 carbon atoms or an arylcarbonyl group having 3 to 20 carbon atoms. The alkyl group having 1 to 14 carbon atoms may be substituted with one or two or more fluorine atoms.

The alkyl group having 1 to 14 carbon atoms is preferably methyl group, ethyl group or propyl group. The alkoxy group having 1 to 14 carbon atoms is preferably methoxy group, ethoxy group or propoxy group. The alkylcarbonyl group having 1 to 14 carbon atoms is preferably acetyl group. The ester group having 2 to 14 carbon atoms is preferably a methyl ester group or an n-butyl ester group. The arylcarbonyl group having 3 to 20 carbon atoms is preferably benzoyl group.

When $Ar^1$ is substituted, the number of the substituents is not limited, but is preferably 1 to 4 and more preferably 1 to 3. When there are more than one substituents, the kinds thereof may be different but are preferably the same.

$R^{30}$ to $R^{33}$ in the general formula (n3) are independently hydrogen atom, an alkyl group which may be substituted, amino group which may be substituted, an alkoxy group which may be substituted or an alkylthio group which may be substituted. $R^{30}$ or $R^{31}$ may be bonded to either $R^{32}$ or $R^{33}$ to form a ring. An example of the structure in which a ring is formed is the structure represented by the general formula (n5), which is a bicyclo structure in which an aromatic

group is condensed.

[Chem. 17]

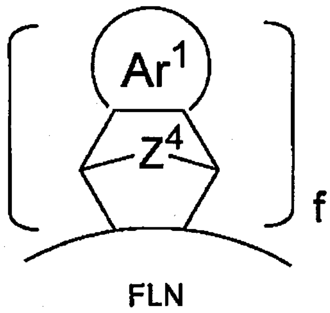

(n5)

In the general formula (n5), f is the same as c, and $Z^4$ is two hydrogen atoms, oxygen atom, sulfur atom, amino group, an alkylene group or an arylene group. The alkylene group preferably has 1 or 2 carbon atoms. The arylene group preferably has 5 to 12 carbon atoms, and an example thereof is phenylene group. The amino group may be substituted with an alkyl group having 1 to 6 carbon atoms such as methyl group or ethyl group. The alkylene group may be substituted with an alkoxy group having 1 to 6 carbon atoms such as methoxy group, an aliphatic hydrocarbon group having 1 to 5 carbon atoms, an aromatic hydrocarbon group having 6 to 20 carbon atoms or an aromatic heterocyclic group having 2 to 20 carbon atoms. The arylene group may be substituted with an alkoxy group having 1 to 6 carbon atoms such as methoxy group, an aliphatic hydrocarbon group having 1 to 5 carbon atoms, an aromatic hydrocarbon group having 6 to 20 carbon atoms or an aromatic heterocyclic group having 2 to 20 carbon atoms.

The structure shown in the formula (n5) is particularly preferably the structure represented by the following formula (n6) or formula (n7).

[Chem. 18]

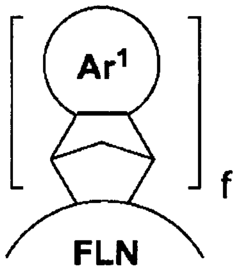

(n6)

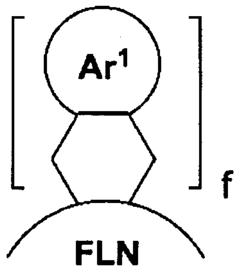

(n7)

$R^{34}$ and $R^{35}$ in the general formula (n4) are independently hydrogen atom, an alkoxycarbonyl group, an alkyl group having 1 to 14 carbon atoms which may be substituted or an aromatic group which may be substituted.

The alkoxy group forming the alkoxycarbonyl group is preferably an alkoxy group having 1 to 12 carbon atoms or a fluorinated alkoxy group having 1 to 12 carbon atoms; more preferably an alkoxy group having 1 to 12 carbon atoms; further preferably methoxy group, ethoxy group, n-propoxy group, isopropoxy group, n-butoxy group, isobutoxy group, n-hexoxy group, octoxy group, 2-propylpentoxy group, 2-ethylhexoxy group, cyclohexylmethoxy group or benzyloxy group; and particularly preferably methoxy group, ethoxy group, isopropoxy group, n-butoxy group, isobutoxy group or n-hexoxy group.

The alkyl group is preferably a linear alkyl group having 1 to 8 carbon atoms and more preferably n-propyl group. The substituent which the alkyl group may have is not particularly limited, but is preferably an alkoxycarbonyl group. The alkoxy group forming the alkoxycarbonyl group is preferably an alkoxy group having 1 to 14 carbon atoms or a fluorinated alkoxy group; more preferably a hydrocarbon group having 1 to 14 carbon atoms; further preferably methoxy group, ethoxy group, n-propoxy group, isopropoxy group, n-butoxy group, isobutoxy group, n-hexoxy group, octoxy group, 2-propylpentoxy group, 2-ethylhexoxy group, cyclohexylmethoxy group or benzyloxy group; and particularly

preferably methoxy group or n-butoxy group.

The aromatic group is preferably an aromatic hydrocarbon group having 6 to 20 carbon atoms or an aromatic heterocyclic group having 2 to 20 carbon atoms; preferably phenyl group, biphenyl group, thienyl group, furyl group or pyridyl group; and further preferably phenyl group or thienyl group. The substituent which the aromatic group may have is preferably an alkyl group having 1 to 14 carbon atoms, a fluorinated alkyl group having 1 to 14 carbon atoms or an alkoxy group having 1 to 14 carbon atoms; further preferably an alkoxy group having 1 to 14 carbon atoms; and particularly preferably methoxy group or 2-ethylhexyloxy group. When the aromatic group is substituted, the number of the substituents is not limited but is preferably 1 to 3 and more preferably 1. The substituents may be different or the same, but are preferably the same.

As the structure of the general formula (n4), those in which $R^{34}$ and $R^{35}$ are both an alkoxycarbonyl group, $R^{34}$ and $R^{35}$ are both an aromatic group, or $R^{34}$ is an aromatic group and $R^{35}$ is a 3-(alkoxycarbonyl)propyl group are preferable.

As the fullerene compound, a kind of the above compounds may be used or a mixture of two or more of the compounds may be used.

In order to form a film of the fullerene compound by a coating method, it is preferable that the fullerene compound itself is a liquid and can be coated, or the fullerene compound is highly soluble in a solvent and can be coated as a solution. As the preferable range of the solubility, the solubility in toluene at 25°C is generally 0.1% by mass or more, preferably 0.4% by mass or more and more preferably 0.7% by mass or more. The solubility of the fullerene compound of 0.1% by mass or more is preferable because the dispersion stability of the fullerene compound in a solution improves, and the cohesion, sedimentation, separation and the like are unlikely to occur.

The solvent in which the fullerene compound is dissolved is not particularly limited as long as it is a non-polar organic solvent, but a non-halogen solvent is preferable. Although it is possible to use a halogen solvent such as dichlorobenzene, it is required to use an alternative in view of the environmental burden and the like. Examples of the non-halogen solvent are non-halogen aromatic hydrocarbons. Among them, toluene, xylene, cyclohexylbenzene or the like is preferable.

(Production method of fullerene compound)

The method for producing the fullerene compound is not particularly limited, but fullerene compounds having the partial structure (n1) for example can be synthesized according to known documents such as WO2008/059771 and J. Am. Chem. Soc., 2008, 130(46), 15429-15436.

Fullerene compounds having the partial structure (n2) can be synthesized according to known documents such as J. Am. Chem. Soc. 1993, 115, 9798-9799; Chem. Mater. 2007, 19, 5363-5372; and Chem. Mater. 2007, 19, 5194-5199.

Fullerene compounds having the partial structure (n3) can be synthesized according to known documents such as Angew. Chem. Int. Ed. Engl. 1993, 32, 78-80; Tetrahedron Lett. 1997, 38, 285-288; WO2008/018931; and WO2009/086210.

Fullerene compounds having the partial structure (n4) can be synthesized according to known documents such as J. Chem. Soc., Perkin Trans. 1, 1997 1595; Thin Solid Films 489(2005)251-256; Adv. Funct. Mater. 2005, 15, 1979-1987; and J. Org. Chem. 1995, 60, 532-538.

<4-2-2-2. N-alkyl-substituted perylene diimide derivative>

The N-alkyl-substituted perylene diimide derivative is not particularly limited, but the compounds described in WO2008/063609, WO2009/115553, WO2009/098250, WO2009/000756 and WO2009/091670 are specifically mentioned. These compounds are preferable, because they have high electron mobility, can absorb visible light and thus can contribute to both charge transportation and power generation.

<4-2-2-3. Naphthalenetetracarboxylic diimide>

The naphthalenetetracarboxylic diimide is not particularly limited, but the compounds described in WO2008/063609, WO2007/146250 and WO2009/000756 are specifically mentioned. These compounds are preferable, because they have high electron mobility and high solubility and are excellent in the coating property.

<4-2-2-4. n-Type high-molecular semiconductor compound>

The n-type high-molecular semiconductor compound is not particularly limited, but n-type high-molecular semiconductor compounds containing as a structural unit at least one of a condensed ring tetracarboxylic diimide such as naphthalenetetracarboxylic diimide or perylenetetracarboxylic diimide, a perylene diimide derivative, a benzimidazole

derivative, a benzoxazole derivative, a thiazole derivative, a benzothiazole derivative, a benzothiadiazole derivative, an oxadiazole derivative, a thiadiazole derivative, a triazole derivative, a pyrazine derivative, a phenanthroline derivative, a quinoxaline derivative, a bipyridine derivative and a borane derivative, and the like are mentioned.

Among them, polymers containing as a structural unit at least one of a borane derivative, a thiazole derivative, a benzothiazole derivative, a benzothiadiazole derivative, N-alkyl-substituted naphthalenetetracarboxylic diimide and an N-alkyl-substituted perylene diimide derivative are preferable, and n-type high-molecular semiconductor compounds having as a structural unit at least one of an N-alkyl-substituted perylene diimide derivative and N-alkyl-substituted naphthalenetetracarboxylic diimide are more preferable. A kind of the n-type high-molecular semiconductor compounds may be used or a mixture of two or more of the compounds may be used.

As the n-type high-molecular semiconductor compound, the compounds described in WO2009/098253, WO2010/012710 and WO2009/098250 are specifically mentioned. These compounds are preferable, because they can absorb visible light and thus can contribute to power generation, and also because they have high viscosity and are excellent in the coating property.

<4-3. Base material (106)>

The photoelectric conversion element 107 generally has the base material 106 serving as a support. That is, the electrodes 101 and 105 and the active layer 103 are formed on the base material. However, the photoelectric conversion element of the invention does not necessarily have the base material 106.

The material of the base material 106 is not particularly limited as long as the effects of the invention are not greatly diminished. Preferable examples of the material of the base material 106 are inorganic materials such as quartz, glass, sapphire or titania; a flexible base material and the like. Although the flexible base material is not limited, the following materials are mentioned: polyolefins such as polyethylene terephthalate, polyethylene naphthalate, polyethersulfone, polyimide, nylon, polystyrene, polyvinyl alcohol, an ethylene vinyl alcohol copolymer, a fluorine resin film, vinyl chloride or polyethylene; organic materials such as cellulose, polyvinylidene chloride, aramid, polyphenylene sulfide, polyurethane, polycarbonate, polyarylate, polynorbornene or an epoxy resin; paper materials such as paper or synthetic paper; and composite materials, for example, a metal foil such as stainless steel, titanium or aluminum with a coated or laminated surface to achieve insulating properties; and the like.

As the glass, soda glass, blue sheet glass or non-alkaline glass is mentioned. Because the amount of ions eluted from the glass is low, non-alkaline glass is preferable among them.

As described above, the invention is particularly effective when a flexible base material which can be applied to a roll-to-roll method is used because the semiconductor layer containing a metal oxide can be produced by a low-temperature process.

The shape of the base material 106 is not limited and for example, a base material in a plate, film, sheet or another form can be used. The thickness of the base material 106 is not limited, but generally 5 $\mu$m or more and preferably 20 $\mu$m or more, and generally 20 mm or less and preferably 10 mm or less. The thickness of the base material of 5 $\mu$m or more is preferable because the possibility that the strength of the photoelectric conversion element is insufficient becomes lower. The thickness of the base material of 20 mm or less is preferable because the cost can be cut and the mass is not large. When the material of the base material 106 is glass, the thickness is generally 0.01 mm or more and preferably 0.1 mm or more, and generally 1 cm or less and preferably 0.5 cm or less. The thickness of the glass base material 106 of 0.01 mm or more is preferable because the mechanical strength increases and the base material is less likely to be broken. The thickness of the glass base material 106 of 0.5 cm or less is preferable because the mass is not large.

<4-4. Electrodes (101, 105)>

The electrodes 101 and 105 have a function of capturing the holes and electrons generated by light absorption. Accordingly, as the pair of electrodes, it is preferable to use the electrode 105 suitable for the hole capture (hereinafter sometimes referred to as the anode) and the electrode 101 suitable for the electron capture (hereinafter sometimes referred to as the cathode). It is sufficient that at least one of the pair of electrodes is translucent and both of them may be translucent. Translucent here means 40% or more of sunlight is transmitted. In addition, the transparent electrode preferably has a solar ray transmittance of 70% or more to allow light to pass through the transparent electrode and reach the active layer 103. The light transmittance can be measured with a general spectrophotometer.

The anode 105 is an electrode which is generally made of a conductive material having a higher work function than the cathode and has the function of smoothly extracting the holes generated in the active layer 103.

Examples of the material of the anode 105 are conductive metal oxides such as nickel oxide, tin oxide, indium oxide, indium tin oxide (ITO), indium-zinc oxide (IZO), titanium oxide or zinc oxide; and metals such as gold, platinum, silver, chromium or cobalt, or alloys thereof. These materials are preferable because of their high work functions and

they are preferable because a conductive high-molecular material represented by PEDOT:PSS obtained by doping a polythiophene derivative with polystyrene sulfonic acid can be laminated. When such a conductive high-molecular is laminated, because the work function of the conductive high-molecular material is high, a metal suitable for the cathode such as Al and Mg can be also used widely as well as the above materials with high work functions. PEDOT:PSS obtained by doping a polythiophene derivative with polystyrene sulfonic acid and a conductive high-molecular material obtained by doping polypyrrole, polyaniline or the like with iodine or the like can be also used as the material of the anode. When the anode 105 is a transparent electrode, it is preferable to use a translucent conductive metal oxide such as ITO, zinc oxide or tin oxide, and ITO is particularly preferable.

The thickness of the anode 105 is not particularly limited but is generally 10 nm or more, preferably 20 nm or more and further preferably 50 nm or more. The thickness is generally 10 μm or less, preferably 1 μm or less and further preferably 500 nm or less. When the thickness of the anode 105 is 10 nm or more, the sheet resistance can be kept low, while the light transmittance is not decreased and light can be converted into electricity efficiently when the thickness of the anode 105 is 10 μm or less. When the anode 105 is a transparent electrode, it is necessary to determine the thickness in such a way that both light transmittance and sheet resistance are appropriate.

The sheet resistance of the anode 105 is not particularly limited, but is generally 1 Ω/□ or more, and is 1000 Ω/□ or less, preferably 500 Ω/□ or less and further preferably 100 Ω/□ or less.

As the method for forming the anode 105, a vacuum film-forming method such as a vapor deposition method or a sputtering method, or a wet coating method in which the film if formed by coating an ink containing nanoparticles or a precursor is mentioned.

The cathode 101 is an electrode which is generally made of a conductive material having a higher work function than the anode and has the function of smoothly extracting the electrons generated in the active layer 103. The cathode 101 contacts the electron extraction layer 102.

Examples of the material of the cathode 101 are metals such as platinum, gold, silver, copper, iron, tin, zinc, aluminum, indium, chromium, lithium, sodium, potassium, cesium, calcium or magnesium, and alloys thereof; inorganic salts such as lithium fluoride or cesium fluoride; metal oxides such as nickel oxide, aluminum oxide, lithium oxide or cesium oxide, and the like. These materials are preferable because of their low work functions. As in the anode 105, also for the cathode 101, it is possible to use a material having a high work function suitable for the anode 105 by using an n-type semiconductor conductive material such as titania as the electron extraction layer 102. In view of the protection of the electrodes, preferable examples of the anode 105 material are metals such as platinum, gold, silver, copper, iron, tin, aluminum, calcium or indium, or alloys using these metals such as indium tin oxide.

The thickness of the cathode 101 is not particularly limited but is generally 10 nm or more, preferably 20 nm or more and more preferably 50 nm or more. The thickness is generally 10 μm or less, preferably 1 μm or less and more preferably 500 nm or less. When the thickness of the cathode 101 is 10 nm or more, the sheet resistance can be kept low, while the light transmittance is not decreased and light can be converted into electricity efficiently when the thickness of the cathode 101 is 10 μm or less. When the cathode 101 is a transparent electrode, it is necessary to determine the thickness in such a way that both light transmittance and sheet resistance are appropriate.

The sheet resistance of the cathode 101 is not particularly limited, but is generally 1000 Ω/□ or less, preferably 500 Ω/□ or less and further preferably 100 Ω/□ or less. Though the lower limit is not limited, the sheet resistance is generally 1 Ω/□ or more.

As the method for forming the cathode 101, a vacuum film-forming method such as a vapor deposition method or a sputtering method, a wet coating method in which the film if formed by coating an ink containing nanoparticles or a precursor, or the like is mentioned.

In addition, the anode 105 and the cathode 101 may have a laminate structure of two or more layers. By subjecting the anode 105 and the cathode 101 to surface treatment, the properties (electric properties, wetting properties and the like) may be improved.

After laminating the anode 105 and the cathode 101, it is preferable to heat the photoelectric conversion element generally at 50°C or higher and preferably 80°C or higher, and generally 300°C or lower, preferably 280°C or lower and more preferably 250°C or lower (this step is sometimes referred to as the annealing treatment step). The annealing treatment step at 50°C or higher is preferable, because this step achieves the effects of improving the adhesion of the layers of the photoelectric conversion element, for example, the adhesion of the electron extraction layer 102 and the cathode 101 and/or of the electron extraction layer 102 and the active layer 103. The improvement in the adhesion of the layers may contribute to the improvement of the thermal stability, durability and the like of the photoelectric conversion element. The temperature of the annealing treatment step of 300°C or lower is preferable because the possibility of the thermal decomposition of the organic compound in the active layer 103 is reduced. The annealing treatment step may include gradual heating steps within the above temperature range.

The heating time is generally one minute or longer and preferably three minutes or longer, and generally three hours or shorter and preferably one hour or shorter. The annealing treatment step is preferably stopped when the open voltage, short-circuit current and fill factor, which are the parameters of the solar cell properties, have reached certain

values. In addition, the annealing treatment step is preferably conducted under the normal pressure and in an inert gas atmosphere.

As the method for heating, the photoelectric conversion element may be placed on a heat source such as a hotplate or the photoelectric conversion element may be placed in a heating atmosphere such as an oven. Furthermore, the heating may be a batch-style or a continuous-style.

<4-5. Photoelectric conversion properties>

The photoelectric conversion properties of the photoelectric conversion element 107 can be determined as follows. The photoelectric conversion element 107 is irradiated with a light of AM 1.5 G with an intensity of 100 $mW/cm^2$ with a solar simulator to measure the current-voltage properties. From the measured current-voltage curve, photoelectric conversion properties such as photoelectric conversion efficiency (PCE), short-circuit current density (Jsc), open voltage (Voc), fill factor (FF), series resistance and shunt resistance can be obtained.

The photoelectric conversion efficiency of the photoelectric conversion element of the invention is not particularly limited, but is generally 1% or more, preferably 1.5% or more and more preferably 2% or more. The upper limit thereof is not particularly limited, and the higher, the better.

As the method for measuring the durability of the photoelectric conversion element, a method for measuring the maintenance ratio of the photoelectric conversion efficiency with regard to before and after exposing the photoelectric conversion element to the air is mentioned.

(Maintenance ratio) = (Photoelectric conversion efficiency N hours after air exposure)/(Photoelectric conversion efficiency soon before air exposure)

In order to put the photoelectric conversion element into practice, it is important that the production is simple and inexpensive, and it is also important that the photoelectric conversion efficiency is high and the durability is high. Taking these points into consideration, the maintenance ratio of the photoelectric conversion efficiency before and after exposing to the air for a week is preferably 60% or more and more preferably 80% or more, but the higher, the better.

<5. Solar cell of the invention>

The photoelectric conversion element 107 of the invention is preferably used as a solar cell element of a solar cell, especially a thin-film solar cell.

Fig. 2 is a cross-sectional figure schematically showing the structure of a thin-film solar cell as an embodiment of the invention. As shown in Fig. 2, the thin-film solar cell 14 of this embodiment has a weather-resistant protective film 1, an ultraviolet blocking film 2, a gas barrier film 3, a getter material film 4, a sealing material 5, a solar cell element 6, a sealing material 7, a getter material film 8, a gas barrier film 9 and a back sheet 10 in this order. Light is applied to the side on which the weather-resistant protective film 1 has been formed (the lower side in the figure) and the solar cell element 6 generates power. In this regard, when a highly-waterproof sheet such as a sheet obtained by attaching fluorine resin films on both sides of an aluminum foil is used as the back sheet 10 describe below, it is not necessary to use the getter material film 8 and/or the gas barrier film 9 depending on the use.

<5-1. Weather-resistant protective film (1)>

The weather-resistant protective film 1 is a film protecting the solar cell element 6 from the weather change. By covering the solar cell element 6 with the weather-resistant protective film 1, the solar cell element 6 and the like are protected from the weather change and the like and the power generation capacity is thus maintained high. Because the weather-resistant protective film 1 is the outermost layer of the thin-film solar cell 14, the weather-resistant protective film 1 preferably has the preferable properties as the material for covering the surface of the thin-film solar cell 14, such as weather resistance, heat resistance, transparency, water repellent property, pollution resistance, mechanical strength and/or the like, and has the properties of maintaining the properties under the exposure to the outside for a long time.

The weather-resistant protective film 1 preferably transmits visible light so that the light absorption of the solar cell element 6 is not prevented. For example, the transmittance of visible light (wavelength of 360 to 830 nm) is preferably 80% or more and the upper limit thereof is not limited. In addition, because the thin-film solar cell 14 is often heated by light, it is preferable that the weather-resistant protective film 1 is also heat-resistant. Thus, the melting point of the constituent material of the weather-resistant protective film 1 is generally 100°C or higher and 350°C or lower.

The material which constitutes the weather-resistant protective film 1 is any material as long as the solar cell

element 6 can be protected from the weather change. Examples of the material are a polyethylene resin, a polypropylene resin, a cyclic polyolefin resin, an AS (acrylonitrile-styrene) resin, an ABS (acrylonitrile-butadienestyrene) resin, a polyvinyl chloride rein, a fluorine resin, a polyester resin such as polyethylene terephthalate and polyethylene naphthalate, a phenolic resin, a polyacrylic resin, a polyamide resin such as various nylons, a polyimide resin, a polyamide-imide resin, a polyurethane resin, a cellulose resin, a silicon resin or a polycarbonate resin.

The weather-resistant protective film 1 may be made of one material or two or more materials. The weather-resistant protective film 1 may be a single-layer film or a laminate film of two or more films.

The thickness of the weather-resistant protective film 1 is not particularly restricted but is generally 10 μm or more and 200 μm or less.

The weather-resistant protective film 1 may be subjected to surface treatment such as at least one of corona treatment and plasma treatment in order to improve the adhesion to other films.

It is preferable to provide the weather-resistant protective film 1 as close as possible to the outermost layer or at the outermost layer in the thin-film solar cell 14. This is to protect as many constituent materials of the thin-film solar cell 14 as possible.

<5-2. Ultraviolet blocking film (2)>

The ultraviolet blocking film 2 is a film which prevents ultraviolet rays from being transmitted. By forming the ultraviolet blocking film 2 on the light-receiving part of the thin-film solar cell 14 and covering the light-receiving surface 6a of the solar cell element 6 with the ultraviolet blocking film 2, it is possible to protect the solar cell element 6, gas barrier films 3 and 9 if necessary, and the like from ultraviolet rays, and the power generation capacity can be maintained high.

As the degree of the ability to prevent the ultraviolet transmission which the ultraviolet blocking film 2 is required to have, the transmittance of an ultraviolet ray (for example, wavelength of 300 nm) is preferably 50% or less and the lower limit thereof is not limited. In addition, the ultraviolet blocking film 2 preferably transmits visible light in order that the light absorption of the solar cell element 6 is not prevented. For example, the transmittance of visible light (wavelength of 360 to 830 nm) is preferably 80% or more and the upper limit thereof is not limited.

Furthermore, because the thin-film solar cell 14 is often heated by light, it is preferable that the ultraviolet blocking film 2 is also heat-resistant. Thus, the melting point of the constituent material of the ultraviolet blocking film 2 is generally 100°C or higher and 350°C or lower.

It is also preferable that the ultraviolet blocking film 2 is highly flexible and excellent in the adhesion to neighboring films and can block water vapor and oxygen.

The material which constitutes the ultraviolet blocking film 2 is any material as long as the intensity of ultraviolet rays can be reduced. Examples of the material are a film obtained by forming an epoxy, acrylic, urethane or ester resin containing an ultraviolet absorber, and the like. In addition, it is also possible to use a film obtained by forming a layer of a resin in which an ultraviolet absorber is dispersed or dissolved (hereinafter referred to as "the ultraviolet-absorbing layer" in some cases) on a base material film.

As the ultraviolet absorber, for example, salicylic, benzophenone, benzotriazole and cyanoacrylate absorbers and the like can be used. A kind of the ultraviolet absorbers may be used or any combination of two or more kinds in any ratio may be used. As described above, as the ultraviolet-absorbing film, a film obtained by forming the ultraviolet-absorbing layer on a base material film can be also used. Such a film can be produced by coating a coating solution containing the ultraviolet absorber on a base material film and drying the layer.

The material of the base material film is not particularly limited, but an example is polyester because a film excellent in the balance of heat resistance and flexibility can be obtained.

Examples of specific commercial products for the ultraviolet blocking film 2 are Cut Ace (MKV Plastic Co., Ltd.) and the like. The ultraviolet blocking film 2 may be made of one material or may be made of two or more materials.

The ultraviolet blocking film 2 may be a single-layer film or a laminate film of two or more films. The thickness of the ultraviolet blocking film 2 is not particularly restricted but is generally 5 μm or more and 200 μm or less.

The ultraviolet blocking film 2 may be formed at a position covering at least a part of the light-receiving surface 6a of the solar cell element 6, but is preferably formed at a position covering the entire light-receiving surface 6a of the solar cell element 6. However, the ultraviolet blocking film 2 may be formed also at a position other than the position covering the light-receiving surface 6a of the solar cell element 6.

<5-3. Gas barrier film (3)>

The gas barrier film 3 is a film which prevents the permeation of water and oxygen. By covering the solar cell element 6 with the gas barrier film 3, the solar cell element 6 can be protected from water and oxygen and the power generation capacity can be maintained high.

As the degree of the moisture proof ability which the gas barrier film 3 is required to have varies depending on the kind of the solar cell element 6 and the like, but it is preferable that the water vapor permeability per unit area (1 $m^2$) per day is generally $1\times10^{-1}$ $g/m^2/day$ or less and the lower limit thereof is not limited.

The degree of the oxygen permeability required for the gas barrier film 3 varies depending on the kind of the solar cell element 6 or the like, but it is preferable that the oxygen permeability per unit area (1 $m^2$) per day is generally $1\times10^{-1}$ $cc/m^2/day/atm$ and the lower limit thereof is not limited.

Furthermore, the gas barrier film 3 preferably transmits visible light so that the light absorption of the solar cell element 6 is not prevented. For example, the transmittance of visible light (wavelength of 360 to 830 nm) is generally 60% or more and the upper limit thereof is not limited.

Furthermore, because the thin-film solar cell 14 is often heated by light, it is preferable that the gas barrier film 3 is also heat-resistant. Thus, the melting point of the constituent material of the gas barrier film 3 is generally 100°C or higher and 350°C or lower.

The specific structure of the gas barrier film 3 is any structure as long as the solar cell element 6 can be protected from water. However, the more the water vapor and oxygen which can permeate the gas barrier film 3 can be reduced, the more expensive film production becomes. Considering these points comprehensively, an appropriate film is preferably used.

Above all, examples of the preferable gas barrier film 3 are a base material film such as polyethylene terephthalate (PET) or polyethylene naphthalate (PEN) which is vacuum-deposited with $SiO_x$, and the like.

The gas barrier film 3 may be made of one material or may be made of two or more materials. Moreover, the gas barrier film 3 may be a single-layer film or a laminate film of two or more films.

The thickness of the gas barrier film 3 is not particularly restricted but is generally 5 μm or more and 200 μm or less.

The position at which the gas barrier film 3 is formed is not limited as long as the solar cell element 6 can be covered and protected from moisture and oxygen, but the gas barrier film 3 preferably covers the front surface of the solar cell element 6 (the surface of the light-receiving surface side, the lower surface in Fig. 2) and the back surface (the surface opposite to the light-receiving surface, the upper surface in Fig. 2). This is because, in the thin-film solar cell 14, its front surface and back surface are often formed larger than other surfaces. In this embodiment, the gas barrier film 3 covers the front surface of the solar cell element 6 and the gas barrier film 9 described below covers the back surface of the solar cell element 6. In this regard, when a highly-waterproof sheet such as a sheet obtained by attaching fluorine resin films on both sides of an aluminum foil is used as the back sheet 10 describe below, it is not necessary to use at least one of the getter material film 8 and the gas barrier film 9 depending on the use.

<5-4. Getter material film (4)>

The getter material film 4 is a film absorbing at least one of water and oxygen. By covering the solar cell element 6 with the getter material film 4, the solar cell element 6 and the like are protected from at least one of water and oxygen and the power generation capacity is thus maintained high. Here, unlike the gas barrier film 3 above, the getter material film 4 does not prevent the permeation of water but absorbs water. By using a film absorbing water, when the solar cell element 6 is covered with the gas barrier film 3 and the like, the water which slightly enters the space formed by the gas barrier films 3 and 9 is captured by the getter material film 4 and the influence of water on the solar cell element 6 can be excluded.

The degree of the water absorption property of the getter material film 4 is generally 0.1 $mg/cm^2$ or more and generally 10 $mg/cm^2$ or less, although the upper limit thereof is not limited. In addition, because the getter material film 4 absorbs oxygen, when the solar cell element 6 is covered with the gas barrier films 3 and 9 and the like, the oxygen which slightly enters the space formed by the gas barrier films 3 and 9 is captured by the getter material film 4 and the influence of oxygen on the solar cell element 6 can be excluded.

Moreover, the getter material film 4 preferably transmits visible light so that the light absorption of the solar cell element 6 is not prevented. For example, the transmittance of visible light (wavelength of 360 to 830 nm) is generally 60% or more and the upper limit thereof is not limited.

In addition, because the thin-film solar cell 14 is often heated by light, it is preferable that the getter material film 4 is also heat-resistant. Thus, the melting point of the constituent material of the getter material film 4 is generally 100°C or higher and 350°C or lower.

The material which constitutes the getter material film 4 is any material as long as at least one of water and oxygen can be absorbed. Examples of the material are, as the substance absorbing water, alkali metals, alkali earth metals or oxides of alkali earth metals; hydroxides of alkali metals or alkali earth metals; silica gel, a zeolite compound, sulfates such as magnesium sulfate, sodium sulfate or nickel sulfate; organometallic compounds such as an aluminum complex or aluminum oxide octylate and the like. Specifically, Ca, Sr, Ba or the like is mentioned as the alkali earth metals. As the oxides of alkali earth metals, CaO, SrO, BaO or the like is mentioned. In addition, Zr-Al-BaO, an aluminum

complex or the like is also mentioned. Examples of specific commercial products are OleDry (manufactured by Futaba Corporation) and the like.

As the substance absorbing oxygen, activated carbon, silica gel, activated alumina, molecular sieve, magnesium oxide, iron oxide and the like are mentioned. In addition, Fe, Mn and Zn, and inorganic salts such as sulfates, chlorides and nitrates of these metals are also mentioned.

In this regard, the getter material film 4 may be made of one material or may be made of two or more materials. Moreover, the getter material film 4 may be a single-layer film or a laminate film of two or more films.

The thickness of the getter material film 4 is not particularly restricted but is generally 5 μm or more and 200 μm or less.

The position of the getter material film 4 is not limited as long as it is placed in the space formed by the gas barrier films 3 and 9, but the getter material film 4 preferably covers the front surface of the solar cell element 6 (the surface of the light-receiving surface side, the lower surface in Fig. 2) and the back surface (the surface opposite to the light-receiving surface, the upper surface in Fig. 2). This is because, in the thin-film solar cell 14, its front surface and back surface are often formed larger than other surfaces and thus water and oxygen tend to enter through these surfaces. Thus, it is preferable to interpose the getter material film 4 between the gas barrier film 3 and the solar cell element 6. In this embodiment, the getter material film 4 covers the front surface of the solar cell element 6, the getter material film 8 described below covers the back surface of the solar cell element 6, and the getter material films 4 and 8 are interposed between the solar cell element 6 and the gas barrier film 3 and the solar cell element 6 and the gas barrier film 9, respectively. In this regard, when a highly-waterproof sheet such as a sheet obtained by attaching fluorine resin films on both sides of an aluminum foil is used as the back sheet 10 describe below, it is not necessary to use at least one of the getter material film 8 and the gas barrier film 9 depending on the use.

<5-5. Sealing material (5)>

The sealing material 5 is a film reinforcing the solar cell element 6. Because the solar cell element 6 is thin and thus is generally weak, the thin-film solar cell tends to be weak. However, the sealing material 5 can maintain the strength high.

In addition, the sealing material 5 preferably has high strength to secure the strength of the thin-film solar cell 14. The specific strength is difficult to define unconditionally because it relates to the strengths of the layers other than the sealing material 5 such as the weather-resistant protective film 1 and the back sheet 10; however, the sealing material 5 desirably has the strength with which the thin-film solar cell 14 as a whole has excellent bending workability and with which peeling at bent part is not caused.

Furthermore, the sealing material 5 preferably transmits visible light so that the light absorption of the solar cell element 6 is not prevented. For example, the transmittance of visible light (wavelength of 360 to 830 nm) is generally 60% or more and the upper limit thereof is not limited.

The thickness of the sealing material 5 is not particularly restricted but is generally 2 μm or more and 700 μm or less.

The T-shape peeling adhesion strength of the sealing material 5 to the substrate is generally 1 N/inch or more and generally 2000 N/inch or less. The T-shape peeling adhesion strength of 1 N/inch or more is preferable because the long-term durability of the module can be secured. The T-shape peeling adhesion strength of 2000 N/inch or less is preferable because the base material and the barrier film can be discarded separately from the adhesive when the solar cell is discarded. The T-shape peeling adhesion strength is measured by the method according to JIS K6854-3 (1999).

The material which constitutes the sealing material 5 is not particularly limited as long as it has the above properties, but it is possible to use sealing materials generally used for sealing an organic or inorganic solar cell, sealing an organic or inorganic LED element, sealing an electronic board or the like.

Specifically, a thermosetting resin composition or a thermoplastic resin composition and an active energy ray-setting resin composition are mentioned. The active energy ray-setting resin composition is for example a resin curable with ultraviolet rays, visible light, electron ray or the like. More specifically, an ethylenevinyl acetate copolymer (EVA) resin composition, a hydrocarbon resin composition, an epoxy resin composition, a polyester resin composition, an acrylic resin composition, an urethane resin composition, a silicon resin composition or the like is mentioned; and the thermosetting, thermoplastic and active energy ray-setting properties are exhibited depending on chemical modification of the main chain, side chain or terminals of each polymer, adjustment of the molecular weight, an additive or the like.

In addition, because the thin-film solar cell 14 is often heated by light, it is preferable that the sealing material 5 is also heat-resistant. Thus, the melting point of the constituent material of the sealing material 5 is generally 100°C or higher and 350°C or lower.

The density of the constituent material for the sealing material in the sealing material 5 is preferably 0.80 g/cm$^3$ or more and the upper limit thereof is not limited. The density can be measured and evaluated by the method according to JIS K7112 (1999).

The position at which the sealing material 5 is provided is not limited, but the sealing material 5 is generally provided in such a way that the solar cell element 6 is interposed. This is to surely protect the solar cell element 6. In this embodiment, the sealing material 5 and the sealing material 7 are provided on the front surface and the back surface of the solar cell element 6, respectively.

<5-6. Solar cell element (6)>

The solar cell element 6 is similar to the photoelectric conversion element 107 described above. That is, the thin-film solar cell 14 can be produced using the photoelectric conversion element 107.
Only one solar cell element 6 may be provided per thin-film solar cell 14, but two or more solar cell elements 6 are generally provided. The specific number of solar cell elements 6 can be determined arbitrarily. When more than one solar cell elements 6 are provided, the solar cell elements 6 are usually aligned in an array.
When more than one solar cell elements 6 are provided, the solar cell elements 6 are generally connected electronically to each other and the electricity generated from the group of connected solar cell elements 6 can be extracted from terminals (not shown in the Figs). In this regard, in order to increase the voltage, the solar cell elements are generally connected in series.
When the solar cell elements 6 are thus connected to each other, the distance between the solar cell elements 6 is preferably small, and the space between a solar cell element 6 and a solar cell element 6 is preferably small. This is to increase the light-receiving amount by increasing the light-receiving area of the solar cell elements 6, and increase the power generation amount of the thin-film solar cell 14.

<5-7. Sealing material (7)>

The sealing material 7 is a film similar to the sealing material 5 described above and the same film as the sealing material 7 can be used in the same way except for the position. Because the constituent materials placed closer to the back surface than the solar cell element 6 do not have to transmit visible light, those which do not transmit visible light can be also used.

<5-8. Getter material film (8)>

The getter material film 8 is a film similar to the getter material film 4 described above and the same film as the getter material film 4 can be used in the same way, if necessary, except for the position. Because the constituent materials placed closer to the back surface than the solar cell element 6 do not have to transmit visible light, those which do not transmit visible light can be also used.

<5-9. Gas barrier film (9)>

The gas barrier film 9 is a film similar to the gas barrier film 3 described above and the same film as the gas barrier film 9 can be used in the same way, if necessary, except for the position. Because the constituent materials placed closer to the back surface than the solar cell element 6 do not have to transmit visible light, those which do not transmit visible light can be also used.

<5-10. Back sheet (10)>

The back sheet 10 is a film similar to the weather-resistant protective film 1 described above and the same film as the weather-resistant protective film 1 can be used in the same way except for the position. In addition, when this back sheet 10 hardly allows the permeation of water and oxygen, the back sheet 10 can be used as a gas barrier layer. Because the constituent materials placed closer to the back surface than the solar cell element 6 do not have to transmit visible light, those which do not transmit visible light can be also used.

<5-11. Size and the like>

The thin-film solar cell 14 of this embodiment is generally a thin film part. By forming the thin-film solar cell 14 as a film part, the thin-film solar cell 14 can be easily attached to building materials, automobiles, interior decoration and the like. Because the thin-film solar cell 14 is light and does not break easily, a solar cell with high safety can be obtained. Because it can be attached to a curved surface, wide use for further applications is possible. The thin-film solar cell is thin and light and thus is preferable in view of the distribution such as the transport and the storage. In addition, because the thin-film solar cell is a film, the production by a roll-to-roll method is possible, resulting in a significant cost saving.

The specific size of the thin-film solar cell 14 is not limited but its thickness is generally 300 μm or more and 3000 μm or less.

<5-12. Production method>

The method for producing the thin-film solar cell 14 of this embodiment is not limited, but as the method for producing the solar cell of the embodiment shown in Fig. 2 for example, a method in which the laminate shown in Fig. 2 is formed and then a lamination sealing step is conducted is mentioned. The solar cell element of this embodiment is excellent in the heat resistance and thus is preferable because the deterioration caused by the lamination sealing step can be reduced.

The laminate shown in Fig. 2 can be formed using known techniques. The method of the lamination sealing step is not particularly limited as long as the effects of the invention are not diminished, but examples thereof are wet lamination, dry lamination, hot-melt lamination, extrusion lamination, co-extrusion lamination, extrusion coating, lamination with a light-curing adhesive and thermal lamination. Among them, a lamination method with a light-curing adhesive, which is a proven method for sealing an organic EL device, or hot-melt lamination or thermal lamination, which is a proven method in the field of solar cells, is preferable, and hot-melt lamination or thermal lamination is more preferable because a sealing material in a sheet form can be used.

The heating temperature for the lamination sealing step is generally 130°C or higher and preferably 140°C or higher, and generally 180°C or lower and preferably 170°C or lower. The heating time for the lamination sealing step is generally 10 minutes or longer and preferably 20 minutes or longer, and generally 100 minutes or shorter and preferably 90 minutes or shorter. The pressure for the lamination sealing step is generally 0.001 MPa or more and preferably 0.01 MPa or more, and generally 0.2 MPa or less and preferably 0.1 MPa or less. The pressure in this range can ensure the sealing, prevent the protrusion of the sealing materials 5 and 7 from the edges and the reduction in film thickness due to excess pressure, and secure the dimensional stability. The cell having two or more solar cell elements 6 connected in series or in parallel can be also produced in the same manner as described above.

<5-13. Applications>

The applications of the solar cell of the invention, especially the thin-film solar cell 14 described above, are not limited and the cell can be used for any application. Examples of the fields in which the thin-film solar cell of the invention is applied are a solar cell for a building material, a solar cell for an automobile, a solar cell for interior decoration, a solar cell for a railroad, a solar cell for a ship, a solar cell for an airplane, a solar cell for a spacecraft, a solar cell for home electronics, a solar cell for a mobile phone, a solar cell for a toy and the like.

The solar cell of the invention, especially the thin-film solar cell, may be used alone or may be used as a solar cell module after attaching one or more solar cells on a base material. For example, as schematically shown in Fig. 3, a solar cell module 13 having the thin-film solar cell 14 on the base material 12 may be prepared and this may be used by installing it in where it is used. That is, the solar cell module 13 can be produced using the thin-film solar cell 14. As a specific example, when a plate for a building material is used as the base material 12, by providing the thin-film solar cell 14 on the surface of the plate, a solar cell panel can be produced as the solar cell module 13.

The base material 12 is a support supporting the thin-film solar cell 14. Examples of the material forming the base material 12 are inorganic materials such as glass, sapphire and titania; organic materials such as polyethylene terephthalate, polyethylene naphthalate, polyethersulfone, polyimide, nylon, polystyrene, polyvinyl alcohol, an ethylene vinyl alcohol copolymer, a fluorine resin, vinyl chloride, polyethylene, cellulose, polyvinylidene chloride, aramid, polyphenylene sulfide, polyurethane, polycarbonate, polyarylate and polynorbornene; paper materials such as paper and synthetic paper; metals such as stainless steel, titanium and aluminum; composite materials, for example, a metal foil such as stainless steel, titanium and aluminum with a coated or laminated surface to achieve insulating properties; and the likes.

A kind of the materials of the base material may be used or any combination of two or more kinds in any ratio may be used. Furthermore, the mechanical strength can be reinforced by adding carbon fibers to these organic materials or paper materials. Examples of the base material 12 are ALPOLIC (registered trademark; manufactured by Mitsubishi Plastics, Inc.) and the like.

The shape of the base material 12 is not limited but a plate is generally used. Furthermore, the material, size and the like of the base material 12 may be determined arbitrarily depending on its use environment. The solar cell panel can be attached on the outer wall of a building and the like.

Examples

The embodiments of the invention are explained with Examples below, but the invention is not limited to these Examples as long as it does not go beyond its gist.

<Decomposition temperature (Td) of zinc compound>

TG-DTA6300 manufactured by SII NanoTechnology Inc. was used. By differential heat-mass simultaneous analysis, decomposition temperatures of zinc compounds in powder state were measured. The condition for the measurement is as follows.

Sample container: Sample container made of aluminum
Atmosphere: Air, 200 mL/minute
Rate of temperature increase: 10°C/minute
Temperature range: 25°C to 600°C

The decomposition temperatures measured were as follows.

Zinc diacrylate: 228°C
Zinc acetate dihydrate: 242°C (dehydration product 89°C)
Zinc acetylacetonate complex: 116°C

From the above results, it was found that the decomposition temperature of a zinc dicarboxylate is 200°C or higher and lower than 300°C, which is higher than that of a zinc acetylacetonate complex. Thus, it was found that a zinc dicarboxylate is not converted into zinc oxide or the like without a process to actively apply external stimuli such as water and heat.

<Example 1: Production of ink and semiconductor layer, measurement of thickness and roughness, and thin-film X-ray diffraction (XRD) measurement>

[Example 1-1]

Zinc diacrylate (manufacture by Nippon Shokubai Co., Ltd., 800 mg, 3.86 mmol) was dissolved in ethanol (manufactured by Wako Pure Chemical Industries, Ltd., 11.1 mL) and ethylene glycol (manufactured by Wako Pure Chemical Industries, Ltd., 0.4 mL) and thus a colorless transparent ink (S1) was prepared.

Then, a glass substrate on which an indium tin oxide (ITO) transparent conductive film with a thickness of 155 nm was formed was subjected to ultrasonic cleaning using acetone and then ultrasonic cleaning using isopropanol, and then subjected to nitrogen blow.

The prepared ink (S1) was dropped on the cleaned substrate and spin-coated using spin coater ACT-300DII (manufactured by Active Co., Ltd.) under uncontrolled air atmosphere (20 to 25°C, humidity of 30 to 35%) under the condition of 3000 rpm and 30 seconds. Then, heat treatment at 150°C for 10 minutes was conducted and thus a semiconductor layer was formed.

[Measurement of thickness and roughness]

The thickness of the obtained film was measured using stylus surface profiler Dektak 150 (manufactured by Ulvac Inc.) under the following measurement condition. The average of five measurement values was regarded as the result and shown in Table 1. In addition, under the same measurement condition, the average roughness (Ra) of the measurement distance of 1000 μm was measured. The average of five measurement values was regarded as the result and shown in Table 1.

Stylus pressure: 1 mg
Stylus size: Radius 12.5 μm
Measurement distance: 1000 μm
Measurement time: 60 seconds
Measurement mode: Standard

[Thin-film X-ray diffraction (XRD) measurement]

The thin-film X-ray diffraction (XRD) of the obtained film was measured under the following measurement condition. The result is shown in Fig. 5.

In this regard, in Fig. 5, the baselines of the spectra were shifted in order that the spectra can be distinguished from each other.

In addition, the thin-film X-ray diffraction (XRD) spectrum within 20° to 50° in the horizontal axis (20) direction was enlarged and the half-width was measured with setting the peak top at 34.3°. The result is shown in Fig. 6.

(Measurement condition)

Measurement device: RINT2000 manufactured by Rigaku Corporation
Optical system: Oblique-incidence X-ray diffraction optical system
Measurement condition: Out of plane method
X ray output: 50 kV, 250 mA (CuK$\alpha$)
Scan axis: 20
Incidence angle ($\theta$): 0.2°
Scan range (20): 2-60°
Scan speed: 3°/min

[Comparative Example 1-1]

Zinc acetate dihydrate (manufactured by Wako Pure Chemical Industries, Ltd., 1760 mg, 8.0 mmol) was dissolved in ethanol amine (manufactured by Sigma-Aldrich Co. LLC, 0.50 mL) and 2-methoxyethanol (manufactured by Sigma-Aldrich Co. LLC, 10 mL) and stirred at 60°C for an hour, and thus a colorless transparent ink (S2), which is a precursor solution of zinc oxide, was prepared. This ink (S2) was spin-coated in a similar way as in Example 1-1 and subjected to heat treatment under air atmosphere at 150°C for 10 minutes and thus a semiconductor layer was formed. In a similar way as in Example 1-1, the thickness, the average roughness (Ra) and the thin-film X-ray diffraction (XRD) were measured. The results are shown in Table 1 and Fig. 5.

[Comparative Example 1-2]

Zinc acetylacetonate complex (manufactured by Dojindo Laboratories, 400 mg, 1.42 mmol) was dissolved in ethanol (manufactured by Wako Pure Chemical Industries, Ltd., 10 mL) and thus a colorless transparent ink (S3) was prepared. This ink (S3) was spin-coated in a similar way as in Example 1-1 and subjected to heat treatment under air atmosphere at 150°C for 10 minutes and thus a semiconductor layer was formed. In a similar way as in Example 1-1, the thickness, the average roughness (Ra) and the thin-film X-ray diffraction (XRD) were measured. The results are shown in Table 1 and

Fig. 5.

[Comparative Example 1-3]

On a cleaned substrate, a semiconductor layer was formed under argon atmosphere (argon flow rate of 20 sccm) using a target of zinc oxide (ZnO) (manufactured by Kojundo Chemical Laboratory Co., Ltd., 99.99%) by RF sputtering method. In a similar way as in Example 1-1, the thickness, the average roughness (Ra) and the thin-film X-ray diffraction (XRD) were measured. The results are shown in Table 1 and Fig. 5.

In addition, the thin-film X-ray diffraction (XRD) spectrum within 20° to 50° in the horizontal axis (2$\theta$) direction was enlarged and the half-width was measured with setting the peak top at 34.6°. The result is shown in Fig. 7.

[Table 1]

| | Zinc compound | Classification | Thickness (Ash) [nm] | Average roughness (Ra) [nm] | Ra/Ash [%] | Half-width [°] |
|---|---|---|---|---|---|---|
| Example 1-1 | Zinc diacrylate | Wet | 40.5 | 2.8 | 6.9 | 2.67 |
| Comparative Example 1-1 | Zincacetate(zinc hydroxide) | Wet | 61.0 | 6.2 | 10.2 | - |

(continued)

| | Zinc compound | Classification | Thickness (Ash) [nm] | Average roughness (Ra) [nm] | Ra/Ash [%] | Half-width [°] |
|---|---|---|---|---|---|---|
| Comparative Example 1-2 | Zinc acetylacetonate complex | Wet | 49.8 | 45.1 | 90.6 | - |
| Comparative Example 1-3 | Zinc oxide sputtering target | Vacuum | 40.1 | 3.0 | 7.5 | 0.80 |

Example 1-1 and Comparative Examples 1-1 to 1-3 show that the semiconductor layer produced by the production method of the invention, which was a wet film-forming method though, had a roughness comparable to that of a vacuum film-forming method, which is said to result in a roughness smaller than that of a wet film-forming method.

In addition, while a polycrystalline zinc oxide-containing semiconductor layer with strong c-axis orientation was obtained by a vacuum film-forming method such as a sputtering method, a polycrystalline zinc oxide-containing semiconductor layer which did not extremely have a certain crystal orientation could be obtained in Example 1-1, in which a wide (002) peak overlapping with (100) and (101) peaks was measured.

From the above results, the semiconductor layer containing zinc oxide produced by the production method of the invention can produce a polycrystalline film with high evenness which does not extremely have a certain crystal orientation. This suggests the possibility of a film with both excellent semiconducting properties and high durability.

<Example 2: Production of ink and semiconductor layer, and evaluation of peel strength and hardness>

In each of Examples 2-1 to 2-28, Comparative Examples 2-1 to 2-16 and Reference Example 2-1, a semiconductor layer containing a metal oxide or a compound layer was formed as follows. In addition, the peel strength and the hardness of each formed semiconductor layer or compound layer were measured as follows.

[Production of semiconductor layer]

A glass substrate on which an indium tin oxide (ITO) transparent conductive film with a thickness of 155 nm was formed was subjected to ultrasonic cleaning using acetone and then ultrasonic cleaning using isopropanol, and then subjected to nitrogen blow. The ink (1 mL) prepared under each condition was dropped on the cleaned substrate and spin-coated using spin coater ACT-300DII (manufactured by Active Co., Ltd.) under uncontrolled air atmosphere (10 to 35°C, humidity of 10 to 80%) under the condition of 3000 rpm and 30 seconds. A film was formed by heating under each condition.

[Peel strength test]

The peel strength of the obtained film was evaluated by testing whether the film could be wiped off with Johnson's cotton buds (manufactured by Johnson & Johnson K.K. Consumer Company) or not. The measurement results are shown in Table 2.

[Hardness test]

The film hardness of the obtained film was evaluated by testing whether the film was shaven or not using stylus surface profiler Dektak 150 (manufactured by Ulvac Inc.) under the following measurement condition. The measurement results are shown in Table 2.

Stylus pressure: 1, 5, 10 or 15 mg
Stylus size: Radius 12.5 μm
Measurement distance: 1000 μm
Measurement time: 60 seconds
Measurement mode: Standard

[Example 2-1]

Zinc diacrylate (manufacture by Sigma-Aldrich Co. LLC, 800 mg, 3.86 mmol) was dissolved in ethanol (manufactured by Wako Pure Chemical Industries, Ltd., 10 mL) and thus a colorless transparent ink (S4) was prepared. Then, this ink (S4) was spin-coated as described above and subjected to heat treatment under air atmosphere at 150°C for 10 minutes and thus a semiconductor layer with a thickness of 41 nm was formed.

[Example 2-2]

The ink (S4) was prepared in a similar way as in Example 2-1. Then, this ink (S4) was spin-coated as described above and subjected to heat treatment under air atmosphere at 120°C for 10 minutes and thus a semiconductor layer with a thickness of 42 nm was formed.

[Example 2-3]

The ink (S4) was prepared in a similar way as in Example 2-1. Then, this ink (S4) was spin-coated as described above and subjected to heat treatment under air atmosphere at 100°C for 10 minutes and thus a semiconductor layer with a thickness of 47 nm was formed.

[Example 2-4]

The ink (S1) was prepared in a similar way as in Example 1-1.
Then, using precision humidity generator SRG1R manufactured by Shinyei Technology Co., Ltd. and a glove box manufactured by Miwa MFG Co., Ltd., an atmosphere with a relative humidity of 5% was produced from dry compressed air.
The ink (S1) was spin-coated as described above and subjected to heat treatment under the atmosphere with a relative humidity of 5% at 150°C for five minutes and thus a semiconductor layer with a thickness of 41 nm was formed.

[Example 2-5]

The ink (S1) was prepared in a similar way as in Example 1-1. Then, this ink (S1) was spin-coated as described above and subjected to heat treatment under an atmosphere with a relative humidity of 7%, which was produced in a similar way as in Example 2-4, at 180°C for three minutes and thus a semiconductor layer with a thickness of 41 nm was formed.

[Example 2-6]

The ink (S1) was prepared in a similar way as in Example 1-1. Then, this ink (S1) was spin-coated as described above and subjected to heat treatment under an atmosphere with a relative humidity of 50%, which was produced in a similar way as in Example 2-4, at 150°C for 10 minutes and thus a semiconductor layer with a thickness of 45 nm was formed.

[Example 2-7]

The ink (S1) was prepared in a similar way as in Example 1-1. Then, this ink (S1) was spin-coated as described above and subjected to heat treatment under an atmosphere with a relative humidity of 50%, which was produced in a similar way as in Example 2-4, at 80°C for 180 minutes and thus a semiconductor layer with a thickness of 50 nm was formed.

[Example 2-8]

The ink (S1) was prepared in a similar way as in Example 1-1. Then, using precision humidity generator SRG1R manufactured by Shinyei Technology Co., Ltd. and a glove box manufactured by Miwa MFG Co., Ltd., a nitrogen atmosphere with a relative humidity of 5% was produced from dry nitrogen.
The ink (S1) was spin-coated as described above and subjected to heat treatment under the nitrogen atmosphere with a relative humidity of 5% at 150°C for 10 minutes and thus a semiconductor layer with a thickness of 42 nm was formed.

[Example 2-9]

Zinc diacrylate (manufacture by Sigma-Aldrich Co. LLC, 800 mg, 3.86 mmol) and lithium acetate dihydrate (manufactured by Wako Pure Chemical Industries, Ltd., 19.7 mg, 0.19 mmol) were dissolved in ethanol (manufactured by Wako Pure Chemical Industries, Ltd., 10 mL) and thus a colorless transparent ink (S5) was prepared. Then, this ink (S5) was spin-coated as described above and subjected to heat treatment under air atmosphere at 150°C for 10 minutes and thus a semiconductor layer with a thickness of 41 nm was formed.

[Example 2-10]

Nanozinc 60 (manufactured by The Honjo Chemical Corporation, zinc oxide nanoparticle powder, 95 mg, 1.16 mmol) and acrylic acid (manufactured by Tokyo Chemical Industry Co., Ltd., 160 μL, 2.32 mmol) were dissolved in ethanol (manufactured by Wako Pure Chemical Industries, Ltd., 3 mL) and thus a colorless transparent ink (S6) was prepared. This ink (S6) was spin-coated as described above and subjected to heat treatment under air atmosphere at 150°C for 10 minutes and thus a semiconductor layer with a thickness of 43 nm was formed.

[Example 2-11]

Nanozinc 60 (manufactured by The Honjo Chemical Corporation, zinc oxide nanoparticle powder, 95 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S7) was prepared. This ink (S7) was spin-coated as described above and subjected to heat treatment under air atmosphere at 150°C for 10 minutes and thus a semiconductor layer with a thickness of 43 nm was formed.

[Example 2-12]

Nanozinc 60 (manufactured by The Honjo Chemical Corporation, zinc oxide nanoparticle powder, 95 mg, 1.16 mmol) and acrylic acid (manufactured by Tokyo Chemical Industry Co., Ltd., 800 μL, 11.6 mmol) were dissolved in ethanol (manufactured by Wako Pure Chemical Industries, Ltd., 3 mL) and thus a colorless transparent ink (S8) was prepared. This ink (S8) was spin-coated as described above and subjected to heat treatment under air atmosphere at 150°C for 10 minutes and thus a semiconductor layer with a thickness of 42 nm was formed.

[Example 2-13]

Nanozinc 100 (manufactured by The Honjo Chemical Corporation, zinc oxide nanoparticle powder, 95 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S9) was prepared. This ink (S9) was spin-coated as described above and subjected to heat treatment under air atmosphere at 150°C for 10 minutes and thus a semiconductor layer with a thickness of 46 nm was formed.

[Example 2-14]

ZINCOX SUPER F-2 (manufactured by HakusuiTech Co., Ltd., zinc oxide nanoparticle powder, 95 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S10) was prepared. This ink (S10) was spin-coated as described above and subjected to heat treatment under air atmosphere at 150°C for 10 minutes and thus a semiconductor layer with a thickness of 47 nm was formed.

[Example 2-15]

Pazet 23K (manufactured by HakusuiTech Co., Ltd., aluminum oxide-doped zinc oxide nanoparticle powder, 95 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a pale-green transparent ink (S11) was prepared. This ink (S11) was spin-coated as described above and subjected to heat treatment under air atmosphere at 150°C for 10 minutes and thus a semiconductor layer with a thickness of 40 nm was formed.

[Example 2-16]

Pazet GK40 (manufactured by HakusuiTech Co., Ltd., gallium oxide-doped zinc oxide nanoparticle powder, 95 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a pale-green transparent ink (S12) was prepared. This ink (S12) was spin-coated as described above and subjected to heat treatment under air atmosphere at 150°C for 10 minutes and thus a semiconductor layer with a thickness of 40 nm was formed.

[Example 2-17]

Zinc acetate dihydrate (manufactured by Wako Pure Chemical Industries, Ltd., 256 mg, 1.16 mmol) and acrylic acid (manufactured by Tokyo Chemical Industry Co., Ltd., 160 μL, 2.32 mmol) were dissolved in ethanol (manufactured by Wako Pure Chemical Industries, Ltd., 3 mL) and thus a colorless transparent ink (S13) was prepared. This ink (S13) was spin-coated as described above and subjected to heat treatment under air atmosphere at 150°C for 10 minutes and thus a semiconductor layer with a thickness of 46 nm was formed.

[Example 2-18]

Zinc acetate dihydrate (manufactured by Wako Pure Chemical Industries, Ltd., 256 mg, 1.16 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S14) was prepared. This ink (S14) was spin-coated as described above and subjected to heat treatment under air atmosphere at 150°C for 10 minutes and thus a semiconductor layer with a thickness of 45 nm was formed.

[Example 2-19]

Zinc acetate dihydrate (manufactured by Wako Pure Chemical Industries, Ltd., 256 mg, 1.16 mmol), lithium acetate dihydrate (manufactured by Wako Pure Chemical Industries, Ltd., 5.9 mg, 0.06 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S15) was prepared. This ink (S15) was spin-coated as described above and subjected to heat treatment under air atmosphere at 150°C for 10 minutes and thus a semiconductor layer with a thickness of 46 nm was formed.

[Example 2-20]

Zinc acetate dihydrate (manufactured by Wako Pure Chemical Industries, Ltd., 256 mg, 1.16 mmol), cesium carbonate (manufactured by Kojundo Chemical Laboratory Co., Ltd., 9.5 mg, 0.03 mmol) and acrylic acid (manufactured by Tokyo Chemical Industry Co., Ltd., 240 μL, 3.48 mmol) were dissolved in ethanol (manufactured by Wako Pure Chemical Industries, Ltd., 3 mL) and thus a colorless transparent ink (S16) was prepared. This ink (S16) was spin-coated as described above and subjected to heat treatment under air atmosphere at 150°C for 10 minutes and thus a semiconductor layer with a thickness of 44 nm was formed.

[Example 2-21]

Nanozinc 60 (manufactured by The Honjo Chemical Corporation, zinc oxide nanoparticle powder, 95 mg, 1.16 mmol), acrylic acid (manufactured by Tokyo Chemical Industry Co., Ltd.) 160 μL (2.32 mmol) and methacrylic acid (manufactured by Tokyo Chemical Industry Co., Ltd., 98 μL, 1.16 mmol) were dissolved in ethanol (manufactured by Wako Pure Chemical Industries, Ltd., 3 mL) and thus a colorless transparent ink (S 17) was prepared. This ink (S17) was spin-coated as described above and subjected to heat treatment under air atmosphere at 150°C for 10 minutes and thus a semiconductor layer with a thickness of 54 nm was formed.

[Example 2-22]

ZINCOX SUPER F-2 (manufactured by HakusuiTech Co., Ltd., zinc oxide nanoparticle powder, 162 mg, 2.00 mmol) and methacrylic acid (manufactured by Tokyo Chemical Industry Co., Ltd., 340 μL, 4.00 mmol) were dissolved in ethanol (manufactured by Wako Pure Chemical Industries, Ltd., 6.0 mL) and ethylene glycol (manufactured by Wako Pure Chemical Industries, Ltd., 0.23 mL) and thus a colorless transparent ink (S 18) was prepared. This ink (S18) was spin-coated as described above and subjected to heat treatment under air atmosphere at 150°C for 10 minutes and

thus a semiconductor layer with a thickness of 64 nm was formed.

[Example 2-23]

ZINCOX SUPER F-2 (manufactured by HakusuiTech Co., Ltd., zinc oxide nanoparticle powder, 162 mg, 2.00 mmol) and crotonic acid (manufactured by Kanto Chemical Co., Inc., 344 mg, 4.00 mmol) were dissolved in ethanol (manufactured by Wako Pure Chemical Industries, Ltd., 12.0 mL) and ethylene glycol (manufactured by Wako Pure Chemical Industries, Ltd., 0.46 mL) and thus a colorless transparent ink (S19) was prepared. This ink (S19) was spin-coated as described above and subjected to heat treatment under air atmosphere at 150°C for 10 minutes and thus a semiconductor layer with a thickness of 73 nm was formed.

[Example 2-24]

ZINCOX SUPER F-2 (manufactured by HakusuiTech Co., Ltd., zinc oxide nanoparticle powder, 162 mg, 2.00 mmol) and 2-hexenoic acid (manufactured by Wako Pure Chemical Industries, Ltd., 457 mg, 4.00 mmol) were dissolved in ethanol (manufactured by Wako Pure Chemical Industries, Ltd., 6.0 mL) and ethylene glycol (manufactured by Wako Pure Chemical Industries, Ltd., 0.23 mL) and thus a colorless transparent ink (S20) was prepared. This ink (S20) was spin-coated as described above and subjected to heat treatment under air atmosphere at 150°C for 10 minutes and thus a semiconductor layer with a thickness of 27 nm was formed.

[Example 2-25]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and acrylic acid (manufactured by Tokyo Chemical Industry Co., Ltd., 24 μL, 0.35 mmol) was added thereto. Thus, a white ink (S21) was prepared. This ink (S21) was spin-coated as described above and subjected to heat treatment under air atmosphere at 150°C for 10 minutes and thus a semiconductor layer with a thickness of 95 nm was formed.

[Example 2-26]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and acrylic acid (manufactured by Tokyo Chemical Industry Co., Ltd., 80 μL, 1.16 mmol) was added thereto. Thus, a white ink (S22) was prepared. This ink (S22) was spin-coated as described above and subjected to heat treatment under air atmosphere at 150°C for 10 minutes and thus a semiconductor layer with a thickness of 102 nm was formed.

[Example 2-27]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and acrylic acid (manufactured by Tokyo Chemical Industry Co., Ltd., 240 μL, 3.48 mmol) was added thereto. Thus, a colorless transparent ink (S23) was prepared. This ink (S23) was spin-coated as described above and subjected to heat treatment under air atmosphere at 150°C for 10 minutes and thus a semiconductor layer with a thickness of 128 nm was formed.

[Example 2-28]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and acrylic acid (manufactured by Tokyo Chemical Industry Co., Ltd., 800 μL, 11.6 mmol) was added thereto. Thus, a colorless transparent ink (S24) was prepared. This ink (S24) was spin-coated as described above and subjected to heat treatment under air atmosphere at 150°C for 10 minutes and thus a semiconductor layer with a thickness of 138 nm was formed.

[Comparative Example 2-1]

Ethanol (manufactured by Wako Pure Chemical Industries, Ltd., 3 mL) was added to Nanozinc 60 (manufactured by The Honjo Chemical Corporation, zinc oxide nanoparticle powder, 95 mg, 1.16 mmol), and thus a white heterogeneous ink (S25) in which Nanozinc 60 was scarcely dissolved was prepared. This ink (S25) was spin-coated as described above and subjected to heat treatment under air atmosphere at 150°C for 10 minutes and thus an uneven layer with a thickness of 221 nm was formed.

[Comparative Example 2-2]

Nanozinc 60 (manufactured by The Honjo Chemical Corporation, zinc oxide nanoparticle powder, 95 mg, 1.16 mmol) and 2-methoxyethoxy acetic acid (397 μL, 3.48 mmol) were dissolved in ethanol (manufactured by Wako Pure Chemical Industries, Ltd., 3 mL) and thus a colorless transparent ink (S26) was prepared. This ink (S26) was spin-coated as described above and subjected to heat treatment under air atmosphere at 150°C for 10 minutes and thus an uneven layer with a thickness of 61 nm was formed.

[Comparative Example 2-3]

Ethanol (manufactured by Wako Pure Chemical Industries, Ltd., 3 mL) was added to Nanozinc 60 (manufactured by The Honjo Chemical Corporation, zinc oxide nanoparticle powder, 95 mg, 1.16 mmol) and benzoic acid (426 mg, 3.48 mmol), and thus a white heterogeneous ink (S27) in which zinc benzoate was scarcely dissolved was prepared. This ink (S27) was spin-coated as described above and subjected to heat treatment under air atmosphere at 150°C for 10 minutes and thus an uneven layer with a thickness of 310 nm was formed.

[Comparative Example 2-4]

ZINCOX SUPER F-2 (manufactured by HakusuiTech Co., Ltd., zinc oxide nanoparticle powder, 162 mg, 2.00 mmol) and 3-butenoic acid (manufactured by Sigma-Aldrich Co. LLC, 340 μL, 4.00 mmol) were dissolved in ethanol (manufactured by Wako Pure Chemical Industries, Ltd., 24.0 mL) and ethylene glycol (manufactured by Wako Pure Chemical Industries, Ltd., 0.92 mL) and thus a colorless transparent ink (S28) was prepared. This ink (S28) was spin-coated as described above and subjected to heat treatment under air atmosphere at 150°C for 10 minutes and thus a relatively-even layer with a thickness of 38 nm was formed.

[Comparative Example 2-5]

Acrylic acid (manufactured by Tokyo Chemical Industry Co., Ltd., 24 μL, 0.35 mmol) was dissolved in ethanol (manufactured by Wako Pure Chemical Industries, Ltd., 10 mL) and thus a colorless transparent ink (S29) was prepared. This ink (S29) was spin-coated as described above and subjected to heat treatment under air atmosphere at 150°C for 10 minutes, however, a film was hardly formed on the substrate.

[Comparative Example 2-6]

The ink (S2) was prepared in a similar way as in Comparative Example 1-1. This ink (S2) was spin-coated as described above and subjected to heat treatment under air atmosphere at 150°C for 10 minutes and thus a relatively-even layer with a thickness of 60 nm was formed.

[Comparative Example 2-7]

Ethanol (manufactured by Wako Pure Chemical Industries, Ltd., 3 mL) was added to zinc acetate dihydrate (manufactured by Wako Pure Chemical Industries, Ltd., 256 mg, 1.16 mmol) and thus a white heterogeneous ink (S30) in which zinc acetate was scarcely dissolved was prepared. This ink (S30) was spin-coated as described above and subjected to heat treatment under air atmosphere at 150°C for 10 minutes and thus an uneven layer with a thickness of 300 nm was formed.

[Comparative Example 2-8]

The ink (S3) was prepared in a similar way as in Comparative Example 1-2. Then, this ink (S3) was spin-coated as described above and subjected to heat treatment under air atmosphere at 150°C for 10 minutes and thus a white

milky uneven layer with a thickness of 50 nm was formed.

[Comparative Example 2-9]

Ethanol (manufactured by Wako Pure Chemical Industries, Ltd., 12.0 mL) and ethylene glycol (manufactured by Wako Pure Chemical Industries, Ltd., 0.46 mL) were added to zinc formate dihydrate (manufactured by Kanto Chemical Co., Inc., 192 mg, 1 mmol), and thus a white heterogeneous ink (S31) in which zinc formate was scarcely dissolved was prepared. This ink (S31) was spin-coated as described above and subjected to heat treatment under air atmosphere at 150°C for 10 minutes and thus an uneven layer with a thickness of 135 nm was formed.

[Comparative Example 2-10]

Ethanol (manufactured by Wako Pure Chemical Industries, Ltd., 12.0 mL) and ethylene glycol (manufactured by Wako Pure Chemical Industries, Ltd., 0.46 mL) were added to zinc propionate (manufactured by Mitsuwa Chemicals Co., Ltd., 212 mg, 1 mmol), and thus a white heterogeneous ink (S32) in which zinc propionate was scarcely dissolved was prepared. This ink (S32) was spin-coated as described above and subjected to heat treatment under air atmosphere at 150°C for 10 minutes and thus a relatively-even layer with a thickness of 26 nm was formed.

[Comparative Example 2-11]

Ethanol (manufactured by Wako Pure Chemical Industries, Ltd., 12.0 mL) and ethylene glycol (manufactured by Wako Pure Chemical Industries, Ltd., 0.46 mL) were added to zinc stearate (manufactured by Wako Pure Chemical Industries, Ltd., 632 mg, 1 mmol), and thus a white heterogeneous ink (S33) in which zinc stearate was scarcely dissolved was prepared. This ink (S33) was spin-coated as described above and subjected to heat treatment under air atmosphere at 150°C for 10 minutes and thus an uneven layer with a thickness of 600 nm was formed.

[Comparative Example 2-12]

Ethanol (manufactured by Wako Pure Chemical Industries, Ltd., 12.0 mL) and ethylene glycol (manufactured by Wako Pure Chemical Industries, Ltd., 0.46 mL) were added to zinc undecylenate (manufactured by Sigma-Aldrich Co. LLC, 432 mg, 1 mmol), and thus a white heterogeneous ink (S34) in which zinc undecylenate was scarcely dissolved was prepared. This ink (S34) was spin-coated as described above and subjected to heat treatment under air atmosphere at 150°C for 10 minutes and thus an uneven layer with a thickness of 725 nm was formed.

[Comparative Example 2-13]

Ethanol (manufactured by Wako Pure Chemical Industries, Ltd., 12.0 mL) and ethylene glycol (manufactured by Wako Pure Chemical Industries, Ltd., 0.46 mL) were added to zinc oleate (manufactured by Kanto Chemical Co., Inc., 628 mg, 1 mmol), and thus a white heterogeneous ink (S35) in which zinc oleate was scarcely dissolved was prepared. This ink (S35) was spin-coated as described above and subjected to heat treatment under air atmosphere at 150°C for 10 minutes and thus an uneven layer with a thickness of 570 nm was formed.

[Comparative Example 2-14]

A white ink (S36) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.). This ink (S36) was spin-coated as described above and subjected to heat treatment under air atmosphere at 150°C for 10 minutes and thus a relatively-even layer with a thickness of 85 nm was formed.

[Comparative Example 2-15]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and 2-methoxyethoxy acetic acid (397 μL, 3.48 mmol) was added thereto. Thus, a colorless transparent ink (S37) was prepared. This ink (S37) was spin-coated as described above and subjected to heat treatment under air atmosphere at 150°C for 10 minutes and thus an uneven layer with a thickness of 362 nm was formed.

[Comparative Example 2-16]

A liquid (3 mL) was prepared by ten-fold dilution of an ethanol dispersion containing 40% by mass of zinc oxide with an average primary particle diameter of 35 nm (manufactured by Sigma-Aldrich Co. LLC) with ethanol (manufactured by Wako Pure Chemical Industries, Ltd.), and benzoic acid (426 mg, 3.48 mmol) was added thereto. Thus, a white heterogeneous ink (S38) in which zinc benzoate was scarcely dissolved was prepared. This ink (S38) was spin-coated as described above and subjected to heat treatment under air atmosphere at 150°C for 10 minutes and thus an uneven layer with a thickness of 232 nm was formed.

[Reference Example 2-1]

The ink (S4) was prepared in a similar way as in Example 2-1. Then, this ink (S4) was spin-coated as described above and subjected to heat treatment under air atmosphere at 80°C for 10 minutes and thus an uneven layer with a thickness of 65 nm was formed.

Table 2 and Table 3 below show the ink state visually observed, and the peel strength and the hardness of the electron extraction layer of each of Examples 2-1 to 2-28, Comparative Examples 2-1 to 2-16 and Reference Example 2-1. In the column "peel strength", "A" means that the film was not wiped off at all, "B" means that the film was partially wiped off, and "C" means that the film was wiped off completely. In the column "hardness", for example, the number "10" means that the film was not shaven at the stylus pressure of 10 mg or less but was shaven at the stylus pressure of 15 mg. The ">15" means that the film was not shaven even at the stylus pressure of 15 mg.

[Table 2]

| | Zinc compound | Carboxylic acid | Molar ratio of carboxylic acid to zinc compound (%) |
|---|---|---|---|
| Example 2-1 | Zinc diacrylate | (Acrylic acid) | 200 |
| Example 2-2 | Zinc diacrylate | (Acrylic acid) | 200 |
| Example 2-3 | Zinc diacrylate | (Acrylic acid) | 200 |
| Example 2-4 | Zinc diacrylate | (Acrylic acid) | 200 |
| Example 2-5 | Zinc diacrylate | (Acrylic acid) | 200 |
| Example 2-6 | Zinc diacrylate | (Acrylic acid) | 200 |
| Example 2-7 | Zinc diacrylate | (Acrylic acid) | 200 |
| Example 2-8 | Zinc diacrylate | (Acrylic acid) | 200 |
| Example 2-9 | Zinc diacrylate | (Acrylic acid) | 200 |
| Example 2-10 | Nanozinc 60 | Acrylic acid | 200 |
| Example 2-11 | Nanozinc 60 | Acrylic acid | 300 |
| Example 2-12 | Nanozinc 60 | Acrylic acid | 1000 |
| Example 2-13 | Nanozinc 100 | Acrylic acid | 300 |
| Example 2-14 | F-2 | Acrylic acid | 300 |
| Example 2-15 | Pazet 23K | Acrylic acid | 300 |
| Example 2-16 | Pazet GK40 | Acrylic acid | 300 |
| Example 2-17 | Zinc acetate | Acrylic acid | 200 |
| Example 2-18 | Zinc acetate | Acrylic acid | 300 |
| Example 2-19 | Zinc acetate | Acrylic acid | 300 |
| Example 2-20 | Zinc acetate | Acrylic acid | 300 |
| Example 2-21 | Nanozinc 60 | Acrylic acid/ methacrylic acid | 200/100 |
| Example 2-22 | F-2 | Methacrylic acid | 200 |
| Example 2-23 | F-2 | Crotonic acid | 200 |
| Example 2-24 | F-2 | 2-Hexenoic acid | 200 |
| Example 2-25 | Zinc oxide dispersion | Acrylic acid | 20 |
| Example 2-26 | Zinc oxide dispersion | Acrylic acid | 67 |
| Example 2-27 | Zinc oxide dispersion | Acrylic acid | 200 |
| Example 2-28 | Zinc oxide dispersion | Acrylic acid | 667 |

[Table 2 (continued)]

| | Additive compound | Ink | Atmosphere |
|---|---|---|---|
| Example 2-1 | - | Colorless transparent solution | Air |
| Example 2-2 | - | Colorless transparent solution | Air |
| Example 2-3 | - | Colorless transparent solution | Air |
| Example 2-4 | - | Colorless transparent solution | 5% RH |
| Example 2-5 | - | Colorless transparent solution | 7% RH |
| Example 2-6 | - | Colorless transparent solution | 50% RH |
| Example 2-7 | - | Colorless transparent solution | 50% RH |
| Example 2-8 | - | Colorless transparent solution | 5% RH nitrogen |
| Example 2-9 | Lithium acetate | Colorless transparent solution | Air |
| Example 2-10 | - | Colorless transparent solution | Air |
| Example 2-11 | - | Colorless transparent solution | Air |
| Example 2-12 | - | Colorless transparent solution | Air |
| Example 2-13 | - | Colorless transparent solution | Air |
| Example 2-14 | - | Colorless transparent solution | Air |
| Example 2-15 | (Aluminum oxide) | Pale-green transparent solution | Air |
| Example 2-16 | (Gallium oxide) | Pale-green transparent solution | Air |
| Example 2-17 | - | Colorless transparent solution | Air |
| Example 2-18 | - | Colorless transparent solution | Air |
| Example 2-19 | Lithium acetate | Colorless transparent solution | Air |
| Example 2-20 | Cesium carbonate | Colorless transparent solution | Air |
| Example 2-21 | - | Colorless transparent solution | Air |
| Example 2-22 | - | Colorless transparent solution | Air |
| Example 2-23 | - | Colorless transparent solution | Air |
| Example 2-24 | - | Colorless transparent solution | Air |
| Example 2-25 | - | White dispersion | Air |
| Example 2-26 | - | White dispersion | Air |
| Example 2-27 | - | Colorless transparent solution | Air |
| Example 2-28 | - | Colorless transparent solution | Air |

[Table 2 (continued)]

| | Heating temperature (°C) | Heating time (min) | Peel strength | Hardness (mg) |
|---|---|---|---|---|
| Example 2-1 | 150 | 10 | A | >15 |
| Example 2-2 | 120 | 10 | A | >15 |
| Example 2-3 | 100 | 10 | A | >15 |
| Example 2-4 | 150 | 5 | A | >15 |
| Example 2-5 | 180 | 3 | A | >15 |
| Example 2-6 | 150 | 10 | A | >15 |
| Example 2-7 | 80 | 180 | A | >15 |
| Example 2-8 | 150 | 10 | A | >15 |
| Example 2-9 | 150 | 10 | A | >15 |
| Example 2-10 | 150 | 10 | A | >15 |
| Example 2-11 | 150 | 10 | A | >15 |
| Example 2-12 | 150 | 10 | A | >15 |
| Example 2-13 | 150 | 10 | A | >15 |
| Example 2-14 | 150 | 10 | A | >15 |
| Example 2-15 | 150 | 10 | A | >15 |
| Example 2-16 | 150 | 10 | A | >15 |
| Example 2-17 | 150 | 10 | A | >15 |
| Example 2-18 | 150 | 10 | A | >15 |
| Example 2-19 | 150 | 10 | A | >15 |
| Example 2-20 | 150 | 10 | A | >15 |
| Example 2-21 | 150 | 10 | A | >15 |
| Example 2-22 | 150 | 10 | A | >15 |
| Example 2-23 | 150 | 10 | A | >15 |
| Example 2-24 | 150 | 10 | A | >15 |
| Example 2-25 | 150 | 10 | B | >15 |
| Example 2-26 | 150 | 10 | B | >15 |
| Example 2-27 | 150 | 10 | B | >15 |
| Example 2-28 | 150 | 10 | B | >15 |

[Table 3]

| | Zinc compound | Carboxylic acid | Molar ratio of carboxylic acid to zinc compound (%) | Additive compound |
|---|---|---|---|---|
| Comparative Example 2-1 | Nanozinc 60 | - | - | - |
| Comparative Example 2-2 | Nanozinc 60 | 2-Methoxyethoxy acetic acid | 300 | - |
| Comparative Example 2-3 | Nanozinc 60 | Benzoic acid | 300 | - |
| Comparative Example 2-4 | F-2 | 3-Butenoic acid | 200 | - |
| Comparative Example 2-5 | - | Acrylic acid | - | - |
| Comparative Example 2-6 | Zinc acetate (zinc hydroxide) | - | 200 | - |
| Comparative Example 2-7 | Zinc acetate | (Acetic acid) | 200 | - |
| Comparative Example 2-8 | Zinc acetylacetonate complex | - | - | - |
| Comparative Example 2-9 | Zinc formate | (Formic acid) | 200 | - |
| Comparative Example 2-10 | Zinc propionate | (Propionic acid) | 200 | - |
| Comparative Example 2-11 | Zinc stearate | (Stearic acid) | 200 | - |
| Comparative Example 2-12 | Zinc undecylenate | (Undecylenic acid) | 200 | - |
| Comparative Example 2-13 | Zinc oleate | (Oleic acid) | 200 | - |
| Comparative Example 2-14 | Zinc oxide dispersion | - | - | - |
| Comparative Example 2-15 | Zinc oxide dispersion | 2-Methoxyethoxy acetic acid | 200 | - |
| Comparative Example 2-16 | Zinc oxide dispersion | Benzoic acid | 200 | - |
| Reference Example 2-1 | Zinc diacrylate | (Acrylic acid) | 200 | - |

[Table 3 (continued)]

| | Ink | Atmosphere | Heating temperature (°C) | Heating time (min) | Peel strength | Hardness (mg) |
|---|---|---|---|---|---|---|
| Comparative Example 2-1 | White dispersion | Air | 150 | 10 | C | 1 |
| Comparative Example 2-2 | Colorless transparent solution | Air | 150 | 10 | C | 1 |
| Comparative Example 2-3 | White dispersion | Air | 150 | 10 | C | 10 |
| Comparative Example 2-4 | Colorless transparent solution | Air | 150 | 10 | B | 10 |
| Comparative Example 2-5 | Colorless transparent solution | Air | 150 | 10 | C | 1 |
| Comparative Example 2-6 | Colorless transparent solution | Air | 150 | 10 | B | 10 |
| Comparative Example 2-7 | White dispersion | Air | 150 | 10 | C | 1 |
| Comparative Example 2-8 | Colorless transparent solution | Air | 150 | 10 | B | 5 |
| Comparative Example 2-9 | White dispersion | Air | 150 | 10 | C | 5 |
| Comparative Example 2-10 | White dispersion | Air | 150 | 10 | B | 10 |
| Comparative Example 2-11 | White dispersion | Air | 150 | 10 | C | 1 |
| Comparative Example 2-12 | White dispersion | Air | 150 | 10 | C | 1 |
| Comparative Example 2-13 | White dispersion | Air | 150 | 10 | C | 1 |
| Comparative Example 2-14 | White dispersion | Air | 150 | 10 | C | 1 |
| Comparative Example 2-15 | Colorless transparent solution | Air | 150 | 10 | C | 1 |
| Comparative Example 2-16 | White dispersion | Air | 150 | 10 | C | 10 |
| Reference Example 2-1 | Colorless transparent solution | Air | 80 | 10 | B | 5 |

The above results show that the layers obtained in Examples 2-1 to 2-28 had higher peel strengths and higher hardness than the layers obtained in Comparative Examples 2-1 to 2-16.

In addition, it can be seen that Example 2-7, in which the semiconductor layer containing zinc oxide was produced by heat treatment at lower temperature (80°C) than in Examples 2-1 to 2-6 and Example 2-8 to Example 2-28, resulted in a semiconductor layer containing a metal oxide with sufficiently high peel strength and hardness as compared to Reference Example 2-1, by conducting heat treatment for a long time. Accordingly, it can be seen that, in the invention,

when the semiconductor layer containing a metal oxide should be produced at lower temperature, a semiconductor layer containing a metal oxide with high peel strength and film hardness can be produced by adjusting the heating time.

In addition, as shown in Examples 2-25 to 2-28, when an ink containing zinc diacrylate is prepared using zinc oxide and acrylic acid, a transparent ink can be prepared by using 200% by mol or more of acrylic acid relative to zinc oxide. This suggests that zinc diacrylate dissolves in a solvent easily even without an additive such as ethanolamine or acetylacetone as in a sol gel method, and thus an even film can be easily formed.

<Example 3: Production and evaluation of field effect transistor (FET)>

[Example 3-1]

On an n-type silicon (Si) substrate on which an oxide film with a thickness of 300 nm was formed (Sb-doped, resistivity of 0.02 Ω·cm or less, manufactured by Sumitomo Metal Industries, Ltd.), gold electrodes having a gap with a length (L) of 10 μm and a width (W) of 500 μm were formed by photolithography as the source electrode and the drain electrode. In addition, a part of the oxide film was shaved and used as the gate electrode.

The ink (S4) was prepared in a similar way as in Example 2-1. On the substrate described above, 0.3 mL of the ink (S4) was dropped under air atmosphere and spin-coated (spin coater MS-A100 manufactured by Mikasa Co., Ltd.) at 1000 rpm for 30 seconds. Then, heat treatment was conducted with a hotplate at 150°C for 10 minutes and thus an excellent semiconductor film with a thickness of about 40 nm was formed. An FET element on which a semiconductor film was formed was thus produced.

The FET properties of the produced FET element were evaluated using semiconductor parameter analyzer 4155C (manufactured by Agilent Technologies). Specifically, a voltage Vd (0 to 60 V) was applied between the source electrode and the drain electrode and a voltage Vg (-30 to 60 V) was applied between the source electrode and the gate electrode, and the current Id which was flowing through the semiconductor film was measured.

When Vt is the threshold voltage, Ci is the capacitance per unit area of the insulating film, L is the distance between the source electrode and the drain electrode, W is the width and μ is the electron mobility of the semiconductor film; their relation can be represented by the following equations.

$$\text{When } Vd<Vg-Vt,$$

$$Id=\mu Ci(W/L)[(Vg-Vt)Vd-(Vd^2/2)]$$

$$\text{When } Vd>Vg-Vt,$$

$$Id=(1/2)\mu Ci(W/L)(Vg-Vt)^2$$

The electron mobility μ can be calculated by either of the above two equations according to the current-voltage properties. In this Example, the electron mobility μ was calculated from the slope of the graph of $Id^{1/2}$ and Vd in accordance with the equation for the case of Vd>Vg-Vt (saturation current region).

The FET element produced as described above showed FET properties and the saturation hole mobility (the electron mobility in saturation region) was $5\times10^{-5}$ [$cm^2$/V·S]. Accordingly, it can be considered that the semiconductor film obtained by the method of this Example using the ink (S4) had semiconducting properties.

[Example 3-2]

The ink (S1) was prepared in a similar way as in Example 1-1. On the substrate described above, 0.3 mL of the ink (S1) was dropped under air atmosphere and spin-coated (spin coater MS-A100 manufactured by Mikasa Co., Ltd.) at 1000 rpm for 30 seconds. Then, heat treatment was conducted with a hotplate at 150°C for 10 minutes.

Next, by irradiating with a 600W UV irradiator manufactured by GS Yuasa International Ltd. for five minutes at 100 mJ/$cm^2$ (the illuminance was measured by UV intensity meter UIT-201+UVD-365PD manufactured by Ushio Inc.), an excellent semiconductor film with a thickness of about 43 nm was formed. An FET element on which a semiconductor film was formed was thus produced.

As a result of evaluation of the FET properties of the produced FET element in a similar way as in Example 3-1, its saturation hole mobility was $1\times10^{-3}$ [$cm^2$/V·S]. Accordingly, it can be considered that the semiconductor film obtained by the method of this Example using the ink (S1) had excellent semiconducting properties.

<Example 4: Production and evaluation of photoelectric conversion element>

[Example 4-1]

Regioregular poly-3-hexylthiophene (P3HT, manufactured by Rieke Metals, Inc.) and $C_{60}(Ind)_2$ (manufactured by Frontier Carbon Corporation) in a mass ratio of 1:0.95 were dissolved in o-xylene (manufactured by Wako Pure Chemical Industries, Ltd.) in a total concentration of 3.5% by mass. The obtained solution was stirred and mixed under nitrogen atmosphere at 80°C for an hour. The solution after stirring was filtered with a 0.45 μm polytetrafluoroethylene (PTFE) filter and a coating solution for an organic active layer was prepared.

[Chem. 19]

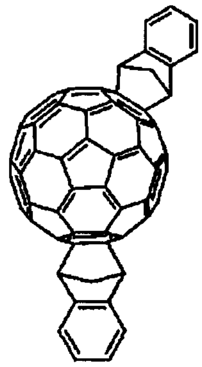

$C_{60}(Ind)_2$

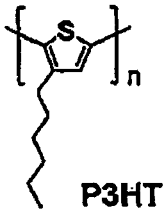

P3HT

Next, an electron extraction layer was formed on an indium tin oxide (ITO) transparent conductive film. The detail is as follows. In a similar way as in Example 2-1, zinc diacrylate (manufacture by Sigma-Aldrich Co. LLC, 800 mg, 3.86 mmol) was dissolved in ethanol (manufactured by Wako Pure Chemical Industries, Ltd., 10 mL) and thus a colorless transparent ink (S4) was prepared. Then, a glass substrate on which an indium tin oxide (ITO) transparent conductive film with a thickness of 155 nm was formed was subjected to ultrasonic cleaning using acetone and then ultrasonic cleaning using isopropanol, and then subjected to nitrogen blow. The ink (S4) (1 mL) was dropped on the cleaned substrate and spin-coated using spin coater ACT-300DII (manufactured by Active Co., Ltd.) under the condition of 3000 rpm and 30 seconds. Then, heat treatment at 150°C for 10 minutes was conducted under air atmosphere and thus an electron extraction layer with a thickness of 41 nm (corresponding to the semiconductor layer obtained in Example 2-1) was formed.

Subsequently, the coating solution for the organic active layer was spin-coated on the electron extraction layer using spin coater MS-A100 (manufactured by Mikasa Co., Ltd.) under nitrogen atmosphere and thus an organic active layer with a thickness of about 200 nm was formed.

An aqueous dispersion of poly(3,4-ethylenedioxythiophene)poly(styrenesulfonate) (manufactured by Heraeus Holding GmbH, product name "CLEVIOS (registered trademark) PVP AI4083") to which 1% by mass of a surfactant (manufactured by Nissin Chemical Industry Co., Ltd., Olfine EXP4036) was added was filtered with a 0.45 μm polyvinylidene fluoride (PVDF) filter. The obtained filtrate was spin-coated on the organic active layer using spin coater ACT-300DII (manufactured by Active Co., Ltd.) in the air and dried by heating in nitrogen at 150°C for 10 minutes, and thus a hole extraction layer with a thickness of about 100 nm was formed.

Furthermore, a silver electrode with a thickness of 100 nm was formed on the hole extraction layer by a resistance-heating vacuum vapor deposition method and heated using a hotplate at 120°C for five minutes, and thus a 5 mm-square bulk-heterojunction-type photoelectric conversion element was produced.

A solar simulator with an air mass (AM) of 1.5 G and an irradiance of 100 $mW/cm^2$ was used as the irradiation light source, and the current-voltage properties of the produced photoelectric conversion element were measured with attaching a metal mask of 4 by 4 mm square with Model 2400 SourceMeter (manufactured by Keithley Instruments, Inc.). The measurement results of the open voltage Voc [V], the short-circuit current density Jsc [$mA/cm^2$], the form factor FF and the photoelectric conversion efficiency PCE [%] are shown in Table 3.

Here, the open voltage Voc means the voltage value (V) at the current value=0 ($mA/cm^2$) and the short-circuit current density Jsc means the current density ($mA/cm^2$) at the voltage value=0 (V). The form factor (FF) is a factor of the internal resistance and represented by the following equation when Pmax is the maximum power point.

$$FF = Pmax/(Voc \times Jsc)$$

In addition, the photoelectric conversion efficiency PCE is given by the following equation when Pin means the incident energy.

$$PCE = Pmax/Pin \times 100$$
$$= Voc \times Jsc \times FF/Pin \times 100$$

[Example 4-2]

A 5 mm-square bulk-heterojunction-type photoelectric conversion element was produced in a similar way as in Example 4-1 except that the semiconductor layer obtained in Example 2-2 was used as the electron extraction layer instead of the semiconductor layer obtained in Example 2-1, and the current-voltage properties were measured. The measurement results are shown in Fig. 4.

[Example 4-3]

A 5 mm-square bulk-heterojunction-type photoelectric conversion element was produced in a similar way as in Example 4-1 except that the semiconductor layer obtained in Example 2-3 was used as the electron extraction layer instead of the semiconductor layer obtained in Example 2-1, and the current-voltage properties were measured. The measurement results are shown in Fig. 4.

[Example 4-4]

A 5 mm-square bulk-heterojunction-type photoelectric conversion element was produced in a similar way as in Example 4-1 except that the semiconductor layer obtained in Example 2-4 was used as the electron extraction layer instead of the semiconductor layer obtained in Example 2-1, and the current-voltage properties were measured. The measurement results are shown in Fig. 4.

[Example 4-5]

A 5 mm-square bulk-heterojunction-type photoelectric conversion element was produced in a similar way as in Example 4-1 except that the semiconductor layer obtained in Example 2-5 was used as the electron extraction layer instead of the semiconductor layer obtained in Example 2-1, and the current-voltage properties were measured. The measurement results are shown in Fig. 4.

[Example 4-6]

A 5 mm-square bulk-heterojunction-type photoelectric conversion element was produced in a similar way as in Example 4-1 except that the semiconductor layer obtained in Example 2-6 was used as the electron extraction layer instead of the semiconductor layer obtained in Example 2-1, and the current-voltage properties were measured. The measurement results are shown in Fig. 4.

[Example 4-7]

A 5 mm-square bulk-heterojunction-type photoelectric conversion element was produced in a similar way as in Example 4-1 except that the semiconductor layer obtained in Example 2-7 was used as the electron extraction layer instead of the semiconductor layer obtained in Example 2-1, and the current-voltage properties were measured. The measurement results are shown in Fig. 4.

[Example 4-8]

A 5 mm-square bulk-heterojunction-type photoelectric conversion element was produced in a similar way as in Example 4-1 except that the semiconductor layer obtained in Example 2-8 was used as the electron extraction layer instead of the semiconductor layer obtained in Example 2-1, and the current-voltage properties were measured. The

measurement results are shown in Fig. 4.

[Example 4-9]

A 5 mm-square bulk-heterojunction-type photoelectric conversion element was produced in a similar way as in Example 4-1 except that the semiconductor layer obtained in Example 2-9 was used as the electron extraction layer instead of the semiconductor layer obtained in Example 2-1, and the current-voltage properties were measured. The measurement results are shown in Fig. 4.

[Example 4-10]

A 5 mm-square bulk-heterojunction-type photoelectric conversion element was produced in a similar way as in Example 4-1 except that the semiconductor layer obtained in Example 2-10 was used as the electron extraction layer instead of the semiconductor layer obtained in Example 2-1, and the current-voltage properties were measured. The measurement results are shown in Fig. 4.

[Example 4-11]

A 5 mm-square bulk-heterojunction-type photoelectric conversion element was produced in a similar way as in Example 4-1 except that the semiconductor layer obtained in Example 2-11 was used as the electron extraction layer instead of the semiconductor layer obtained in Example 2-1, and the current-voltage properties were measured. The measurement results are shown in Fig. 4.

[Example 4-12]

A 5 mm-square bulk-heterojunction-type photoelectric conversion element was produced in a similar way as in Example 4-1 except that the semiconductor layer obtained in Example 2-12 was used as the electron extraction layer instead of the semiconductor layer obtained in Example 2-1, and the current-voltage properties were measured. The measurement results are shown in Fig. 4.

[Example 4-13]

A 5 mm-square bulk-heterojunction-type photoelectric conversion element was produced in a similar way as in Example 4-1 except that the semiconductor layer obtained in Example 2-13 was used as the electron extraction layer instead of the semiconductor layer obtained in Example 2-1, and the current-voltage properties were measured. The measurement results are shown in Fig. 4.

[Example 4-14]

A 5 mm-square bulk-heterojunction-type photoelectric conversion element was produced in a similar way as in Example 4-1 except that the semiconductor layer obtained in Example 2-14 was used as the electron extraction layer instead of the semiconductor layer obtained in Example 2-1, and the current-voltage properties were measured. The measurement results are shown in Fig. 4.

[Example 4-15]

A 5 mm-square bulk-heterojunction-type photoelectric conversion element was produced in a similar way as in Example 4-1 except that the semiconductor layer obtained in Example 2-15 was used as the electron extraction layer instead of the semiconductor layer obtained in Example 2-1, and the current-voltage properties were measured. The measurement results are shown in Fig. 4.

[Example 4-16]

A 5 mm-square bulk-heterojunction-type photoelectric conversion element was produced in a similar way as in Example 4-1 except that the semiconductor layer obtained in Example 2-16 was used as the electron extraction layer instead of the semiconductor layer obtained in Example 2-1, and the current-voltage properties were measured. The measurement results are shown in Fig. 4.

[Example 4-17]

A 5 mm-square bulk-heterojunction-type photoelectric conversion element was produced in a similar way as in Example 4-1 except that the semiconductor layer obtained in Example 2-17 was used as the electron extraction layer instead of the semiconductor layer obtained in Example 2-1, and the current-voltage properties were measured. The measurement results are shown in Fig. 4.

[Example 4-18]

A 5 mm-square bulk-heterojunction-type photoelectric conversion element was produced in a similar way as in Example 4-1 except that the semiconductor layer obtained in Example 2-18 was used as the electron extraction layer instead of the semiconductor layer obtained in Example 2-1, and the current-voltage properties were measured. The measurement results are shown in Fig. 4.

[Example 4-19]

A 5 mm-square bulk-heterojunction-type photoelectric conversion element was produced in a similar way as in Example 4-1 except that the semiconductor layer obtained in Example 2-19 was used as the electron extraction layer instead of the semiconductor layer obtained in Example 2-1, and the current-voltage properties were measured. The measurement results are shown in Fig. 4.

[Example 4-20]

A 5 mm-square bulk-heterojunction-type photoelectric conversion element was produced in a similar way as in Example 4-1 except that the semiconductor layer obtained in Example 2-20 was used as the electron extraction layer instead of the semiconductor layer obtained in Example 2-1, and the current-voltage properties were measured. The measurement results are shown in Fig. 4.

[Example 4-21]

A 5 mm-square bulk-heterojunction-type photoelectric conversion element was produced in a similar way as in Example 4-1 except that the semiconductor layer obtained in Example 2-21 was used as the electron extraction layer instead of the semiconductor layer obtained in Example 2-1, and the current-voltage properties were measured. The measurement results are shown in Fig. 4.

[Example 4-22]

A 5 mm-square bulk-heterojunction-type photoelectric conversion element was produced in a similar way as in Example 4-1 except that the semiconductor layer obtained in Example 2-22 was used as the electron extraction layer instead of the semiconductor layer obtained in Example 2-1, and the current-voltage properties were measured. The measurement results are shown in Fig. 4.

[Example 4-23]

A 5 mm-square bulk-heterojunction-type photoelectric conversion element was produced in a similar way as in Example 4-1 except that the semiconductor layer obtained in Example 2-23 was used as the electron extraction layer instead of the semiconductor layer obtained in Example 2-1, and the current-voltage properties were measured. The measurement results are shown in Fig. 4.

[Example 4-24]

A 5 mm-square bulk-heterojunction-type photoelectric conversion element was produced in a similar way as in Example 4-1 except that the semiconductor layer obtained in Example 2-24 was used as the electron extraction layer instead of the semiconductor layer obtained in Example 2-1, and the current-voltage properties were measured. The measurement results are shown in Fig. 4.

[Example 4-25]

A 5 mm-square bulk-heterojunction-type photoelectric conversion element was produced in a similar way as in Example 4-1 except that the semiconductor layer obtained in Example 2-25 was used as the electron extraction layer instead of the semiconductor layer obtained in Example 2-1, and the current-voltage properties were measured. The measurement results are shown in Fig. 4.

[Example 4-26]

A 5 mm-square bulk-heterojunction-type photoelectric conversion element was produced in a similar way as in Example 4-1 except that the semiconductor layer obtained in Example 2-26 was used as the electron extraction layer instead of the semiconductor layer obtained in Example 2-1, and the current-voltage properties were measured. The measurement results are shown in Fig. 4.

[Example 4-27]

A 5 mm-square bulk-heterojunction-type photoelectric conversion element was produced in a similar way as in Example 4-1 except that the semiconductor layer obtained in Example 2-27 was used as the electron extraction layer instead of the semiconductor layer obtained in Example 2-1, and the current-voltage properties were measured. The measurement results are shown in Fig. 4.

[Example 4-28]

A 5 mm-square bulk-heterojunction-type photoelectric conversion element was produced in a similar way as in Example 4-1 except that the semiconductor layer obtained in Example 2-28 was used as the electron extraction layer instead of the semiconductor layer obtained in Example 2-1, and the current-voltage properties were measured. The measurement results are shown in Fig. 4.

[Comparative Example 4-1]

A 5 mm-square bulk-heterojunction-type photoelectric conversion element was produced in a similar way as in Example 4-1 except that the layer obtained in Comparative Example 2-1 was used as the electron extraction layer instead of the semiconductor layer obtained in Example 2-1, and the current-voltage properties were measured. The measurement results are shown in Fig. 5. Four elements were produced in Comparative Example 4-1, but the open voltages (Voc) were remarkably low in all the four elements.

[Comparative Example 4-2]

A 5 mm-square bulk-heterojunction-type photoelectric conversion element was produced in a similar way as in Example 3-1 except that the layer obtained in Comparative Example 2-2 was used as the electron extraction layer instead of the semiconductor layer obtained in Example 2-1 in Example 4-1, and the current-voltage properties were measured. The measurement results are shown in Fig. 5. Four elements were produced in Comparative Example 4-2, but the open voltages (Voc) were remarkably low in all the four elements.

[Comparative Example 4-3]

A 5 mm-square bulk-heterojunction-type photoelectric conversion element was produced in a similar way as in Example 3-1 except that the layer obtained in Comparative Example 2-3 was used as the electron extraction layer instead of the semiconductor layer obtained in Example 2-1 in Example 4-1, and the current-voltage properties were measured. The measurement results are shown in Fig. 5. Four elements were produced in Comparative Example 4-3, but the open voltages (Voc) were remarkably low in all the four elements.

[Comparative Example 4-4]

A 5 mm-square bulk-heterojunction-type photoelectric conversion element was produced in a similar way as in Example 4-1 except that the layer obtained in Comparative Example 2-4 was used as the electron extraction layer instead of the semiconductor layer obtained in Example 2-1, and the current-voltage properties were measured. The measurement results are shown in Fig. 5.

[Comparative Example 4-5]

A 5 mm-square bulk-heterojunction-type photoelectric conversion element was produced in a similar way as in Example 4-1 except that the layer obtained in Comparative Example 2-5 was used as the electron extraction layer instead of the semiconductor layer obtained in Example 2-1, and the current-voltage properties were measured. The measurement results are shown in Fig. 5. Four elements were produced in Comparative Example 4-5, but the open voltages (Voc) were remarkably low in all the four elements.

[Comparative Example 4-6]

A 5 mm-square bulk-heterojunction-type photoelectric conversion element was produced in a similar way as in Example 4-1 except that the layer obtained in Comparative Example 2-6 was used as the electron extraction layer instead of the semiconductor layer obtained in Example 2-1, and the current-voltage properties were measured. The measurement results are shown in Fig. 5.

[Comparative Example 4-7]

A 5 mm-square bulk-heterojunction-type photoelectric conversion element was produced in a similar way as in Example 4-1 except that the layer obtained in Comparative Example 2-7 was used as the electron extraction layer instead of the semiconductor layer obtained in Example 2-1, and the current-voltage properties were measured. The measurement results are shown in Fig. 5. Four elements were produced in Comparative Example 4-7, but the open voltages (Voc) were remarkably low in all the four elements.

[Comparative Example 4-8]

A 5 mm-square bulk-heterojunction-type photoelectric conversion element was produced in a similar way as in Example 4-1 except that the layer obtained in Comparative Example 2-8 was used as the electron extraction layer instead of the semiconductor layer obtained in Example 2-1, and the current-voltage properties were measured. The measurement results are shown in Fig. 5.

[Comparative Example 4-9]

A 5 mm-square bulk-heterojunction-type photoelectric conversion element was produced in a similar way as in Example 4-1 except that the layer obtained in Comparative Example 2-9 was used as the electron extraction layer instead of the semiconductor layer obtained in Example 2-1, and the current-voltage properties were measured. The measurement results are shown in Fig. 5. Four elements were produced in Comparative Example 4-9, but the open voltages (Voc) were remarkably low in all the four elements.

[Comparative Example 4-10]

A 5 mm-square bulk-heterojunction-type photoelectric conversion element was produced in a similar way as in Example 4-1 except that the layer obtained in Comparative Example 2-10 was used as the electron extraction layer instead of the semiconductor layer obtained in Example 2-1, and the current-voltage properties were measured. The measurement results are shown in Fig. 5.

[Comparative Example 4-11]

A 5 mm-square bulk-heterojunction-type photoelectric conversion element was produced in a similar way as in Example 4-1 except that the layer obtained in Comparative Example 2-11 was used as the electron extraction layer instead of the semiconductor layer obtained in Example 2-1, and the current-voltage properties were measured. The measurement results are shown in Fig. 5. Four elements were produced in Comparative Example 4-11, but the open voltages (Voc) were remarkably low in all the four elements.

[Comparative Example 4-12]

A 5 mm-square bulk-heterojunction-type photoelectric conversion element was produced in a similar way as in Example 4-1 except that the layer obtained in Comparative Example 2-12 was used as the electron extraction layer instead of the semiconductor layer obtained in Example 2-1, and the current-voltage properties were measured. The

measurement results are shown in Fig. 5. Four elements were produced in Comparative Example 4-12, but the open voltages (Voc) were remarkably low in all the four elements.

[Comparative Example 4-13]

A 5 mm-square bulk-heterojunction-type photoelectric conversion element was produced in a similar way as in Example 4-1 except that the layer obtained in Comparative Example 2-13 was used as the electron extraction layer instead of the semiconductor layer obtained in Example 2-1, and the current-voltage properties were measured. The measurement results are shown in Fig. 5. Four elements were produced in Comparative Example 4-13, but the open voltages (Voc) were remarkably low in all the four elements.

[Comparative Example 4-14]

A 5 mm-square bulk-heterojunction-type photoelectric conversion element was produced in a similar way as in Example 4-1 except that the layer obtained in Comparative Example 2-14 was used as the electron extraction layer instead of the semiconductor layer obtained in Example 2-1, and the current-voltage properties were measured. The measurement results are shown in Fig. 5.

[Comparative Example 4-15]

A 5 mm-square bulk-heterojunction-type photoelectric conversion element was produced in a similar way as in Example 4-1 except that the layer obtained in Comparative Example 2-15 was used as the electron extraction layer instead of the semiconductor layer obtained in Example 2-1, and the current-voltage properties were measured. The measurement results are shown in Fig. 5.

[Comparative Example 4-16]

A 5 mm-square bulk-heterojunction-type photoelectric conversion element was produced in a similar way as in Example 4-1 except that the layer obtained in Comparative Example 2-16 was used as the electron extraction layer instead of the semiconductor layer obtained in Example 2-1, and the current-voltage properties were measured. The measurement results are shown in Fig. 5. Four elements were produced in Comparative Example 4-16, but the open voltages (Voc) were remarkably low in all the four elements.

[Comparative Example 4-17]

A 5 mm-square bulk-heterojunction-type photoelectric conversion element was produced in a similar way as in Example 4-1 except that the electron extraction layer was not used, and the current-voltage properties were measured. The measurement results are shown in Fig. 5. Four elements were produced in Comparative Example 4-17, but the open voltages (Voc) were remarkably low in all the four elements.

[Reference Example 4-1]

A 5 mm-square bulk-heterojunction-type photoelectric conversion element was produced in a similar way as in Example 4-1 except that the layer obtained in Reference Example 2-1 was used as the electron extraction layer instead of the semiconductor layer obtained in Example 2-1, and the current-voltage properties were measured. The measurement results are shown in Fig. 5.

[Table 4]]

| | Zinc compound | Carboxylic acid | Molar ratio of carboxylic acid to zinc compound (%) |
|---|---|---|---|
| Example 4-1 | Zinc diacrylate | (Acrylic acid) | 200 |
| Example 4-2 | Zinc diacrylate | (Acrylic acid) | 200 |
| Example 4-3 | Zinc diacrylate | (Acrylic acid) | 200 |
| Example 4-4 | Zinc diacrylate | (Acrylic acid) | 200 |
| Example 4-5 | Zinc diacrylate | (Acrylic acid) | 200 |
| Example 4-6 | Zinc diacrylate | (Acrylic acid) | 200 |
| Example 4-7 | Zinc diacrylate | (Acrylic acid) | 200 |
| Example 4-8 | Zinc diacrylate | (Acrylic acid) | 200 |
| Example 4-9 | Zinc diacrylate | (Acrylic acid) | 200 |
| Example 4-10 | Nanozinc 60 | Acrylic acid | 200 |
| Example 4-11 | Nanozinc 60 | Acrylic acid | 300 |
| Example 4-12 | Nanozinc 60 | Acrylic acid | 1000 |
| Example 4-13 | Nanozinc 100 | Acrylic acid | 300 |
| Example 4-14 | F-2 | Acrylic acid | 300 |
| Example 4-15 | Pazet 23K | Acrylic acid | 300 |
| Example 4-16 | Pazet GK40 | Acrylic acid | 300 |
| Example 4-17 | Zinc acetate | Acrylic acid | 200 |
| Example 4-18 | Zinc acetate | Acrylic acid | 300 |
| Example 4-19 | Zinc acetate | Acrylic acid | 300 |
| Example 4-20 | Zinc acetate | Acrylic acid | 300 |
| Example 4-21 | Nanozinc 60 | Acrylic acid/ methacrylic acid | 200/100 |
| Example 4-22 | F-2 | Methacrylic acid | 200 |
| Example 4-23 | F-2 | Crotonic acid | 200 |
| Example 4-24 | F-2 | 2-Hexenoic acid | 200 |
| Example 4-25 | Zinc oxide dispersion | Acrylic acid | 20 |
| Example 4-26 | Zinc oxide dispersion | Acrylic acid | 67 |
| Example 4-27 | Zinc oxide dispersion | Acrylic acid | 200 |
| Example 4-28 | Zinc oxide dispersion | Acrylic acid | 667 |

[Table 4 (continued)]

| | Additive compound | Atmo-sphere | Heating temper-ature (°C) | Heating time (min) | Voc [V] | Jsc [mA/ $cm^2$] | FF | PCE [%] |
|---|---|---|---|---|---|---|---|---|
| Example 4-1 | - | Air | 150 | 10 | 0.806 | 8.78 | 0.68 | 4.78 |
| Example 4-2 | - | Air | 120 | 10 | 0.806 | 8.93 | 0.67 | 4.83 |
| Example 4-3 | - | Air | 100 | 10 | 0.803 | 8.70 | 0.67 | 4.69 |
| Example 4-4 | - | 5% RH | 150 | 5 | 0.811 | 8.90 | 0.66 | 4.75 |
| Example 4-5 | - | 7% RH | 180 | 3 | 0.807 | 8.57 | 0.65 | 4.47 |
| Example 4-6 | - | 50% RH | 150 | 10 | 0.793 | 8.39 | 0.67 | 4.44 |
| Example 4-7 | - | 50% RH | 80 | 180 | 0.799 | 8.56 | 0.67 | 4.57 |
| Example 4-8 | - | 5% RH nitrogen | 150 | 10 | 0.814 | 8.13 | 0.66 | 4.34 |
| Example 4-9 | Lithium acetate | Air | 150 | 10 | 0.834 | 9.02 | 0.68 | 5.09 |
| Example 4-10 | - | Air | 150 | 10 | 0.786 | 8.83 | 0.65 | 4.50 |
| Example 4-11 | - | Air | 150 | 10 | 0.792 | 8.83 | 0.65 | 4.58 |
| Example 4-12 | - | Air | 150 | 10 | 0.794 | 8.64 | 0.66 | 4.50 |
| Example 4-13 | - | Air | 150 | 10 | 0.790 | 8.73 | 0.66 | 4.53 |
| Example 4-14 | (Aluminum oxide) | Air | 150 | 10 | 0.791 | 8.67 | 0.66 | 4.53 |
| Example 4-15 | (Gallium oxide) | Air | 150 | 10 | 0.792 | 8.88 | 0.66 | 4.62 |
| Example 4-16 | - | Air | 150 | 10 | 0.794 | 8.72 | 0.65 | 4.53 |
| Example 4-17 | - | Air | 150 | 10 | 0.795 | 8.87 | 0.64 | 4.54 |
| Example 4-18 | - | Air | 150 | 10 | 0.787 | 8.64 | 0.63 | 4.31 |
| Example 4-19 | Lithium acetate | Air | 150 | 10 | 0.821 | 8.93 | 0.65 | 4.78 |
| Example 4-20 | Cesium carbonate | Air | 150 | 10 | 0.789 | 8.94 | 0.67 | 4.72 |
| Example 4-21 | - | Air | 150 | 10 | 0.791 | 8.39 | 0.64 | 4.23 |
| Example 4-22 | - | Air | 150 | 10 | 0.817 | 8.69 | 0.67 | 4.74 |
| Example 4-23 | - | Air | 150 | 10 | 0.798 | 8.61 | 0.67 | 4.59 |
| Example 4-24 | - | Air | 150 | 10 | 0.808 | 8.55 | 0.62 | 4.28 |
| Example 4-25 | - | Air | 150 | 10 | 0.813 | 8.49 | 0.67 | 4.64 |
| Example 4-26 | - | Air | 150 | 10 | 0.808 | 8.25 | 0.66 | 4.40 |
| Example 4-27 | - | Air | 150 | 10 | 0.810 | 9.03 | 0.68 | 4.95 |
| Example 4-28 | - | Air | 150 | 10 | 0.804 | 8.56 | 0.66 | 4.57 |

[Table 5]

| | Zinc compound | Carboxylic acid | Molar ratio of carboxylic acid to zinc compound (%) | Additive compound |
|---|---|---|---|---|
| Comparative Example 4-1 | Nanozinc 60 | - | - | - |
| Comparative Example 4-2 | Nanozinc 60 | 2-Methoxyethoxy acetic acid | 300 | - |
| Comparative Example 4-3 | Nanozinc 60 | Benzoic acid | 300 | - |
| Comparative Example 4-4 | F-2 | 3-Butenoic acid | 200 | - |
| Comparative Example 4-5 | - | Acrylic acid | - | - |
| Comparative Example 4-6 | Zinc acetate (zinc hydroxide) | - | 200 | - |
| Comparative Example 4-7 | Zinc acetate | (Acetic acid) | 200 | |
| Comparative Example 4-8 | Zinc acetylacetonate complex | - | - | |
| Comparative Example 4-9 | Zinc formate | (Formic acid) | 200 | - |
| Comparative Example 4-10 | Zinc propionate | (Propionic acid) | 200 | - |
| Comparative Example 4-11 | Zinc stearate | (Stearic acid) | 200 | - |
| Comparative Example 4-12 | Zinc undecylenate | (Undecylenic acid) | 200 | - |
| Comparative Example 4-13 | Zinc oleate | (Oleic acid) | 200 | - |
| Comparative Example 4-14 | Zinc oxide dispersion | - | - | - |
| Comparative Example 4-15 | Zinc oxide dispersion | 2-Methoxyethoxy acetic acid | 200 | - |
| Comparative Example 4-16 | Zinc oxide dispersion | Benzoic acid | 200 | - |
| Comparative Example 4-17 | - | - | - | - |
| Reference Example 4-1 | Zinc diacrylate | (Acrylic acid) | 200 | - |

[Table 5 (continued)]

| | Atmo-sphere | Heating temperature (°C) | Heating time (min) | Voc [V] | Jsc [mA/cm$^2$] | FF | PCE [%] |
|---|---|---|---|---|---|---|---|
| Comparative Example 4-1 | Air | 150 | 10 | 0.004 | 1.41 | 0.00 | 0.00 |
| Comparative Example 4-2 | Air | 150 | 10 | 0.013 | 2.76 | 0.16 | 0.01 |
| Comparative Example 4-3 | Air | 150 | 10 | 0.001 | 0.43 | 0.00 | 0.00 |
| Comparative Example 4-4 | Air | 150 | 10 | 0.770 | 7.99 | 0.55 | 3.38 |
| Comparative Example 4-5 | Air | 150 | 10 | 0.073 | 4.80 | 0.26 | 0.09 |
| Comparative Example 4-6 | Air | 150 | 10 | 0.212 | 4.91 | 0.31 | 0.75 |
| Comparative Example 4-7 | Air | 150 | 10 | 0.000 | 0.10 | 0.00 | 0.00 |
| Comparative Example 4-8 | Air | 150 | 10 | 0.610 | 6.72 | 0.40 | 1.66 |
| Comparative Example 4-9 | Air | 150 | 10 | 0.064 | 3.81 | 0.26 | 0.06 |
| Comparative Example 4-10 | Air | 150 | 10 | 0.547 | 7.12 | 0.40 | 1.55 |
| Comparative Example 4-11 | Air | 150 | 10 | 0.056 | 1.20 | 0.23 | 0.02 |
| Comparative Example 4-12 | Air | 150 | 10 | 0.000 | 0.11 | 0.00 | 0.00 |
| Comparative Example 4-13 | Air | 150 | 10 | 0.000 | 0.35 | 0.00 | 0.00 |
| Comparative Example 4-14 | Air | 150 | 10 | 0.817 | 7.84 | 0.65 | 4.19 |
| Comparative Example 4-15 | Air | 150 | 10 | 0.438 | 6.13 | 0.34 | 0.92 |
| Comparative Example 4-16 | Air | 150 | 10 | 0.056 | 3.39 | 0.22 | 0.05 |
| Comparative Example 4-17 | - | - | - | 0.075 | 4.65 | 0.26 | 0.09 |
| Reference Example 4-1 | Air | 80 | 10 | 0.017 | 0.00 | 0.24 | 0.00 |

As shown above, it was found that the photoelectric conversion elements obtained in Examples 4-1 to 4-28 all had high conversion efficiencies.

Furthermore, when the electron extraction layers were produced using inks which did not contain the metal

salt of unsaturated carboxylic acid of the invention as in Comparative Examples 4-1 to 4-3, 4-7, 4-9 and 4-11 to 4-13, the photoelectric conversion efficiencies of the obtained photoelectric conversion elements were remarkably low and it was thought that the electrodes were almost short-circuited. On the other hand, such short-circuit was not observed in the photoelectric conversion elements of Examples 4-1 to 4-28. Thus, it can be understood that the photoelectric conversion element using the electron extraction layer containing the semiconductor layer of the invention is easily produced.

In addition, the photoelectric conversion elements of Examples 4-1 to 4-28 showed high values for all the parameters, than the photoelectric conversion elements having electron extraction layers formed from metal compounds other than the metal salt of unsaturated carboxylic acid of the invention as in Comparative Examples 4-2 to 4-4 and 4-6 to 4-13, also because more even and harder layers were used as the electron extraction layers.

Comparative Example 4-4 showed a high efficiency among the Comparative Examples. This suggests the possibility of the two-stage change, that is, a part of zinc 3-butenoate was isomerized by the heat, then changed into zinc crotonate corresponding to zinc 2-butenoate and then changed into zinc oxide.

The photoelectric conversion elements obtained in Examples 4-9, 4-19 and 4-20, in which lithium acetate or cesium carbonate was used as the additive compound, showed the same or higher values for all the parameters as compared to the photoelectric conversion element obtained in Example 4-1 or 4-18, in which no additive compound was used. In particular, when lithium acetate was used as the additive compound, the open voltages (Voc) increased. This is thought to be due to the doping effect of lithium.

It was found that, while a high conversion efficiency was not achieved in Reference Example 4-1, in which heating was conducted at 80°C for 10 minutes for producing the electron extraction layer; high conversion efficiencies could be obtained by adjusting the heating treatment temperature or the heating time as shown in Examples 4-1 to 4-9.

Although the invention is explained above in detail and referring to specific embodiments, it is obvious to one skilled in the art that various changes and modifications can be added without deviating from the spirit and scope of the invention. This application is based on a Japanese patent application filed on June 1, 2012 (patent application No. 2012-126227) and a Japanese patent application filed on September 27, 2012 (patent application No. 2012-214659), and their contents are incorporated herewith as reference.

Reference Signs List

101: Cathode (electrode)
102: Electron extraction layer
103: Active layer
104: Hole extraction layer
105: Anode (electrode)
106: Base material
107: Photoelectric conversion element
1: Weather-resistant protective film
2: Ultraviolet blocking film
3,9: Gas barrier films
4, 8: Getter material films
5, 7: Sealing materials
6: Solar cell element
10: Back sheet
12: Base material
13: Solar cell module
14: Thin-film solar cell
51: Semiconductor layer
52: Insulator layer
53, 54: Source electrode and drain electrode
55: Gate electrode
56: Base material

## Claims

1. A method for producing a semiconductor layer containing a metal oxide, which comprises: coating an ink containing a metal salt of unsaturated carboxylic acid represented by the formula (I) on a base material; and conducting a heat

treatment after the coating.

[Chem. 1]

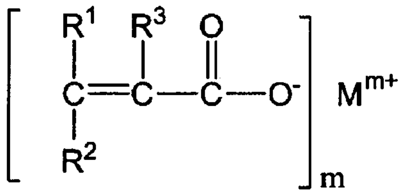

(I)

(In the formula (I), $R^1$, $R^2$ and $R^3$ are each independently hydrogen atom or an arbitrary substituent, M is an m-valent metal atom, and m is an integer of 2 to 5, and m "$CR^1R^2=CR^3$-COO-"s may be the same as or different from each other.)

**2.** The method for producing a semiconductor layer containing a metal oxide according to claim 1, wherein the number of the carbon atoms forming the metal salt of unsaturated carboxylic acid is 3 to 12.

**3.** The method for producing a semiconductor layer containing a metal oxide according to claim 1 or claim 2, wherein the boiling point of the unsaturated carboxylic acid constituting the metal salt of unsaturated carboxylic acid is 139°C or higher and lower than 300°C.

**4.** The method for producing a semiconductor layer containing a metal oxide according to any one of claims 1 to 3, wherein $R^1$, $R^2$ and $R^3$ in the formula (I) are each independently hydrogen atom or an alkyl group which may be substituted.

**5.** The method for producing a semiconductor layer containing a metal oxide according to any one of claims 1 to 4, wherein $R^1$, $R^2$ and $R^3$ in the formula (I) are each hydrogen atom.

**6.** The method for producing a semiconductor layer containing a metal oxide according to any one of claims 1 to 5, wherein M in the formula (I) is a transition metal atom selected from the elements in group 4 in the periodic table, or a metal atom selected from the elements in group 12 in the periodic table, the elements in group 13 in the periodic table and the elements in group 14 in the periodic table.

**7.** The method for producing a semiconductor layer containing a metal oxide according to any one of claims 1 to 6, wherein M in the formula (I) is zinc atom.

**8.** The method for producing a semiconductor layer containing a metal oxide according to any one of claims 1 to 7, wherein the heat treatment is conducted at 100°C or higher and lower than 300°C.

**9.** The method for producing a semiconductor layer containing a metal oxide according to any one of claims 1 to 8, wherein the base material is a resin base material.

**10.** The method for producing a semiconductor layer containing a metal oxide according to any one of claims 1 to 9, wherein the heat treatment step is conducted under an atmosphere in which the humidity is more than 1% and 80% or less when the temperature is set at 25°C.

**11.** An electronic device which comprises the semiconductor layer containing a metal oxide obtained by the production method described in any one of claims 1 to 10.

**12.** A field effect transistor which comprises the semiconductor layer containing a metal oxide obtained by the production method described in any one of claims 1 to 10.

**13.** A photoelectric conversion element which comprises the semiconductor layer containing a metal oxide obtained by the production method described in any one of claims 1 to 10.

**14.** A photoelectric conversion element for a solar cell, which comprises the semiconductor layer containing a metal oxide obtained by the production method described in any one of claims 1 to 10.

**15.** A photoelectric conversion element which comprises at least a pair of electrodes, an active layer interposed between the electrodes, and a buffer layer interposed between the active layer and one of the electrodes, wherein the buffer layer contains the semiconductor layer containing a metal oxide obtained by the production method described in any one of claims 1 to 10.

**16.** The photoelectric conversion element according to claim 15, wherein the buffer layer is an electron extraction layer.

**17.** A solar cell which comprises the photoelectric conversion element described in any one of claims 13 to 16.

**18.** A solar cell module which comprises the solar cell described in claim 17.

**19.** A semiconductor layer containing zinc oxide, which has an average roughness relative to the thickness of less than 10%, and a half-width of the 20 peak corresponding to the (002) plane in a thin-film X-ray diffraction (XRD) method (an out of plane measurement) of 1° or more.

[Fig. 1]

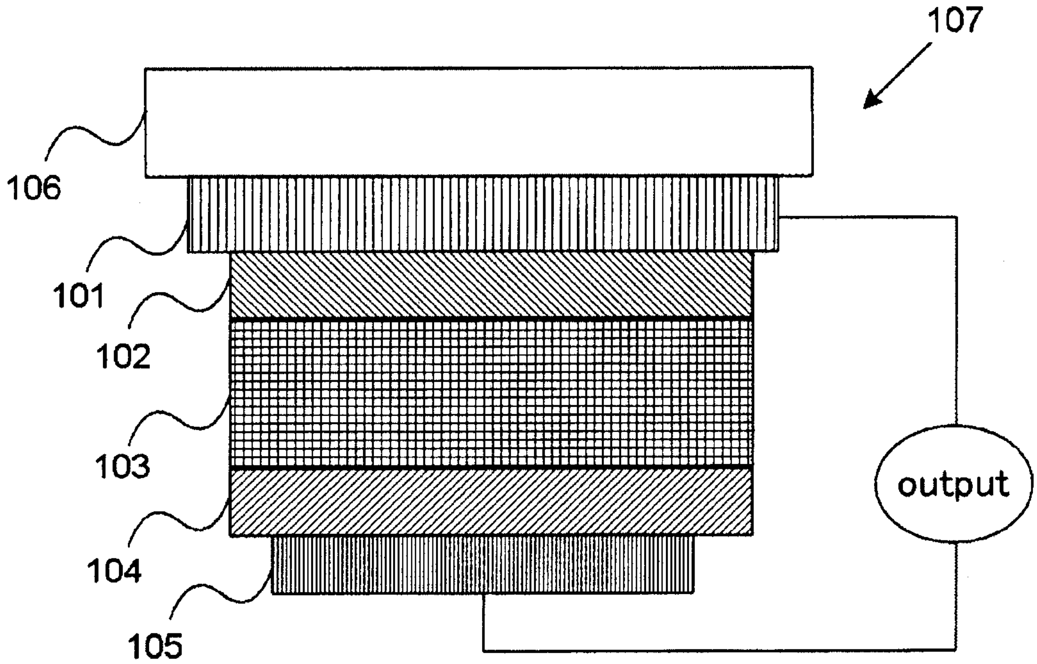


[Fig. 2]

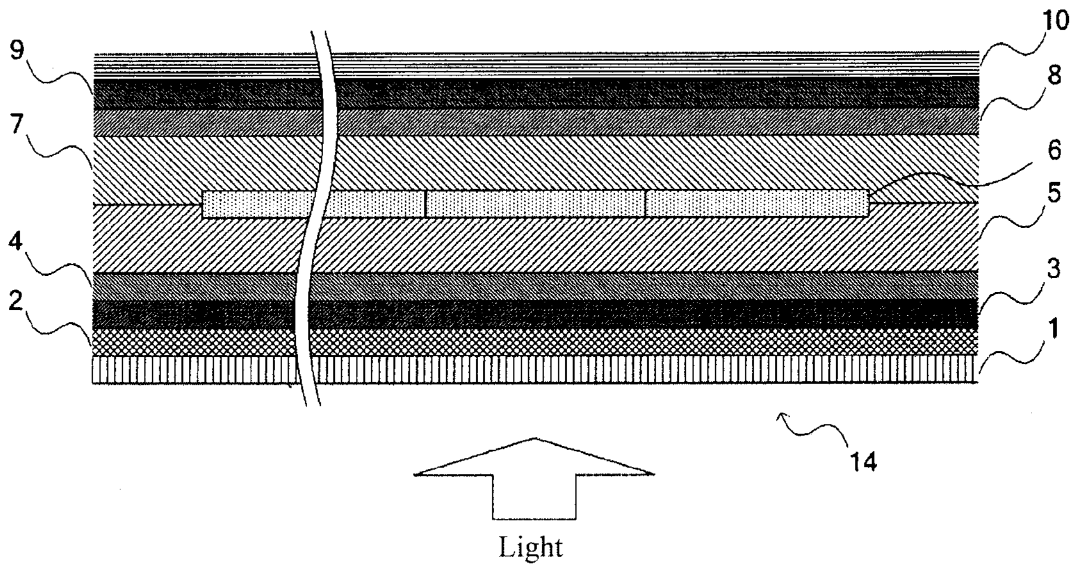

[Fig. 3]

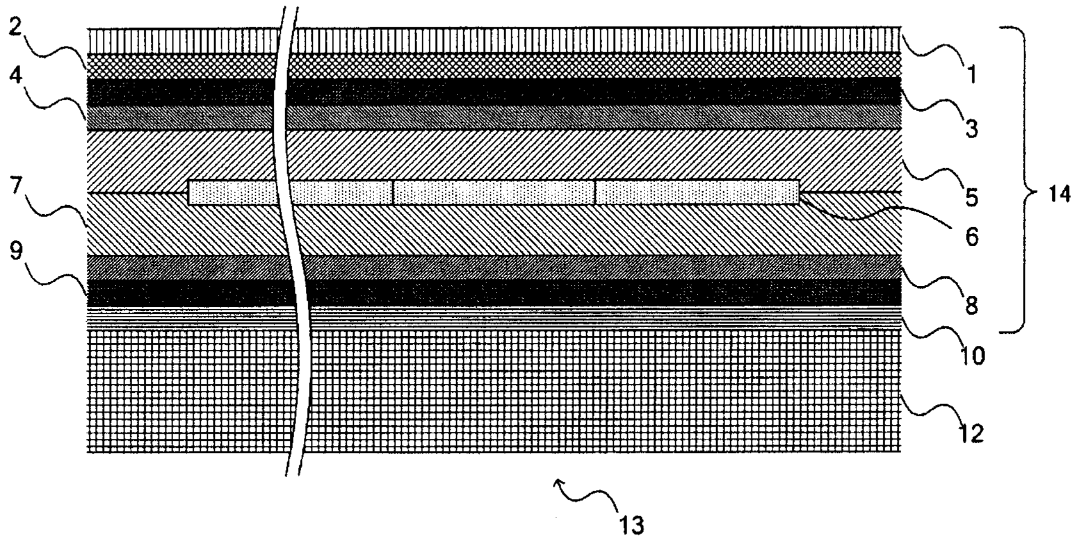

[Fig. 4]

(A)

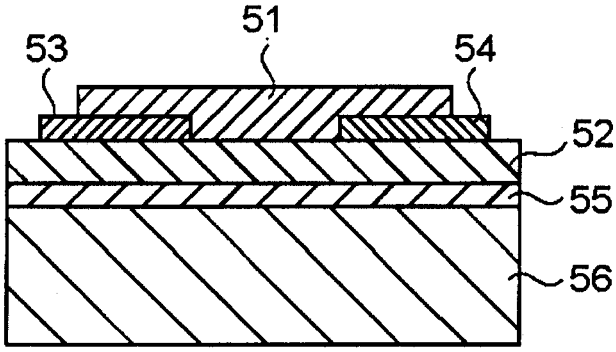


(B)

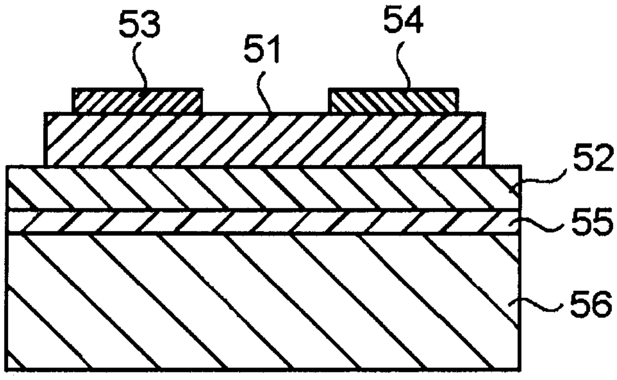


(C)

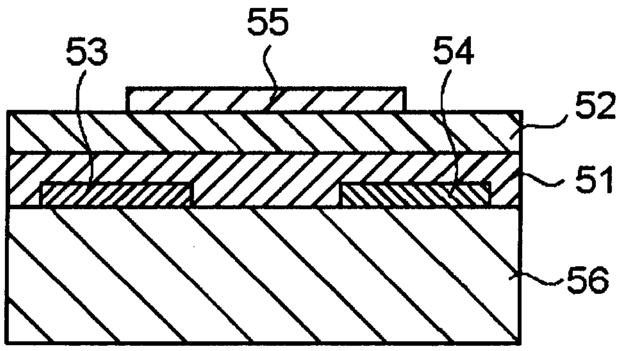


(D)

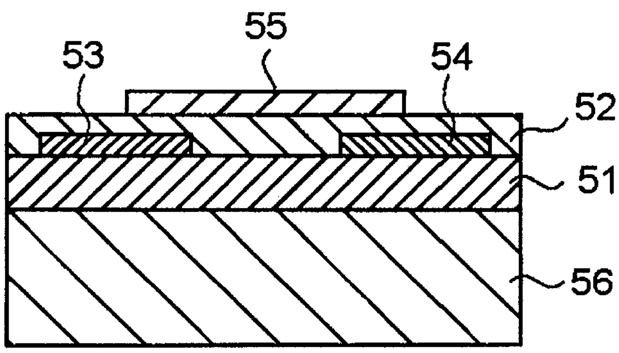

[Fig. 5]

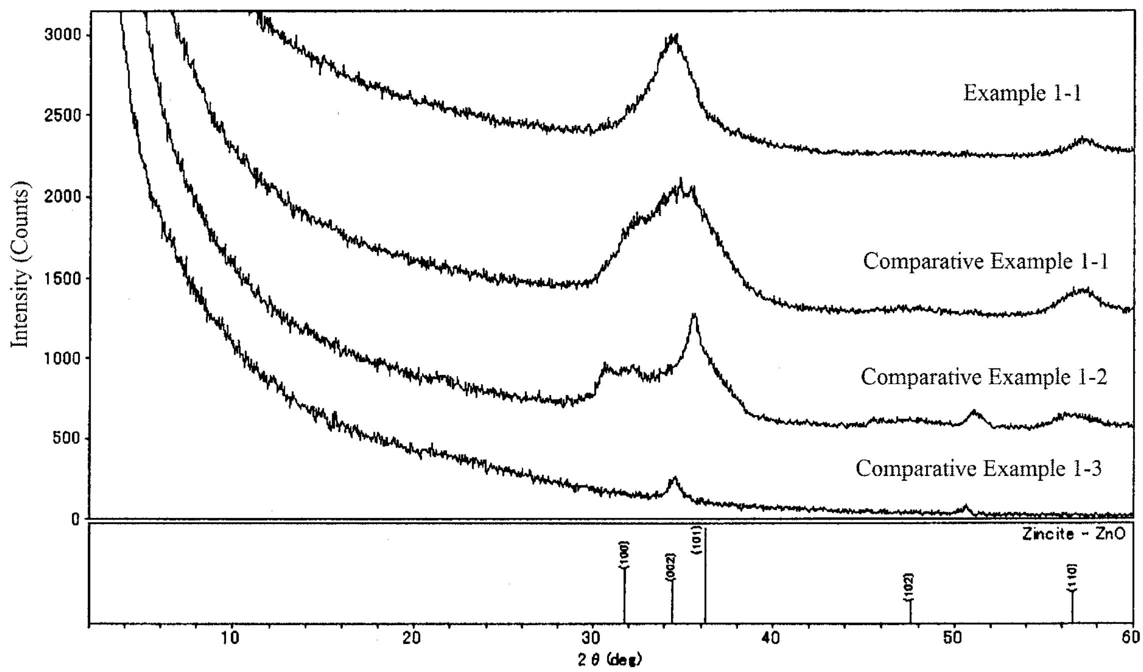
Example 1-1
Comparative Example 1-1
Comparative Example 1-2
Comparative Example 1-3
Intensity (Counts)
Zincite - ZnO
(100)
(002)
(101)
(102)
(110)
2θ (deg)

[Fig. 6]

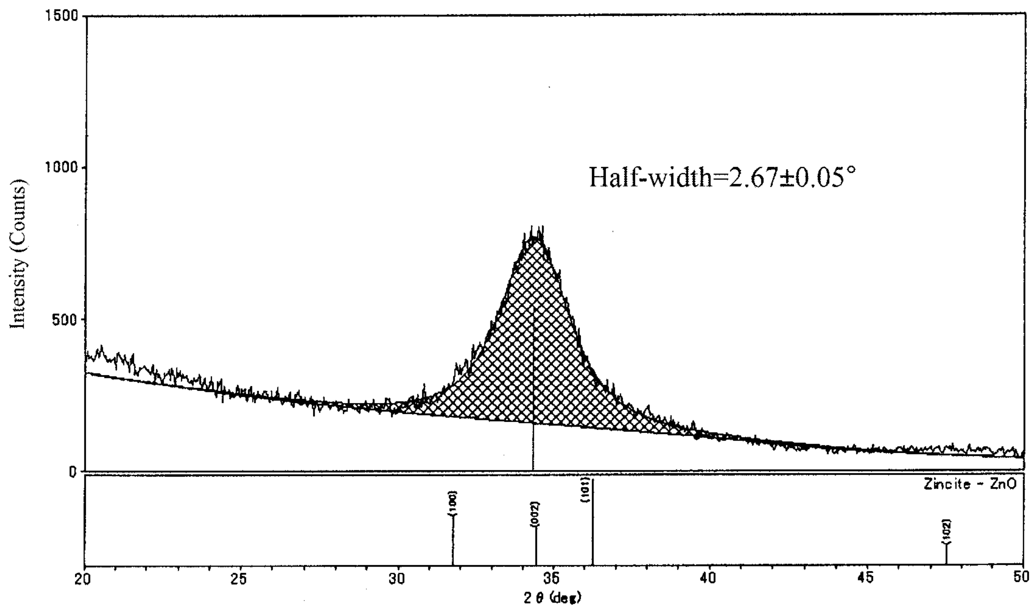
Half-width=2.67±0.05°
Intensity (Counts)
Zincite - ZnO
(100)
(002)
(101)
(102)
2θ (deg)

[Fig. 7]

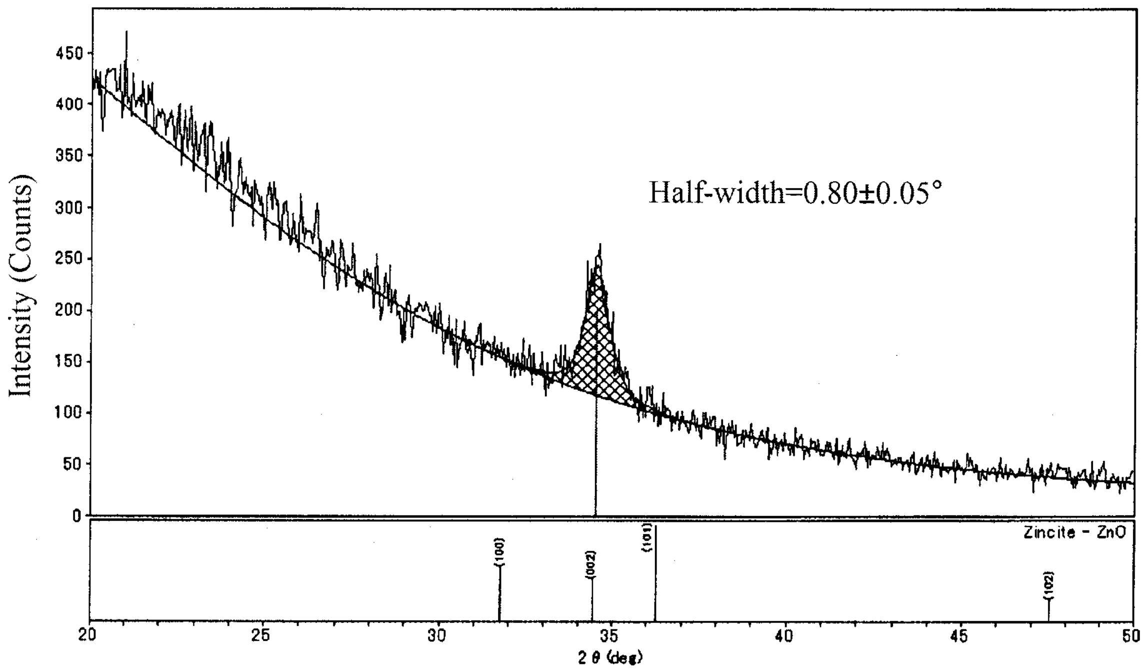
Intensity (Counts)
450
400
350
300
250
200
150
100
50
0
Half-width=0.80±0.05°
(100)
(002)
(101)
(102)
Zincite - ZnO
20
25
30
35
40
45
50
2θ (deg)

## INTERNATIONAL SEARCH REPORT

International application No. PCT/JP2013/065078

A. CLASSIFICATION OF SUBJECT MATTER
*H01L21/368*(2006.01)i, *H01L21/336*(2006.01)i, *H01L29/786*(2006.01)i, *H01L51/42*(2006.01)i

According to International Patent Classification (IPC) or to both national classification and IPC

B. FIELDS SEARCHED

Minimum documentation searched (classification system followed by classification symbols)
H01L21/368, H01L21/336, H01L29/786, H01L51/42

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2006-089293 A (NOF Corp.), 06 April 2006 (06.04.2006), paragraphs [0002] to [0044] (Family: none) | 1-4,6-9,19<br>10-18<br>5 |
| X<br>Y<br>A | JP 2007-149570 A (Nippon Kayaku Co., Ltd.), 14 June 2007 (14.06.2007), paragraphs [0004], [0076], [0077] (Family: none) | 1-8,11,13,14,17,18<br>10<br>9,12,15,16,19 |
| Y | WO 2012/053542 A1 (Tosoh Finechem Corp.), 26 April 2012 (26.04.2012), paragraphs [0170] to [0172] & CN 103153865 A | 10 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 August, 2013 (08.08.13) | 27 August, 2013 (27.08.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2013/065078

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2010-525560 A (Evonik Degussa GmbH), 22 July 2010 (22.07.2010), paragraphs [0049] to [0051]; fig. 1 & WO 2008/128821 A1 & KR 10-2010-0002258 A & CN 101675506 A & HK 1139789 A | 11,12 |
| Y | JP 2012-64645 A (Mitsubishi Chemical Corp.), 29 March 2012 (29.03.2012), paragraphs [0041] to [0046]; fig. 1, 2 (Family: none) | 13-18 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008071585 A
- WO 2012046326 A
- JP 2010001395 A
- JP 2007324587 A
- JP 2010045186 A
- WO 2008059771 A
- WO 2008018931 A
- WO 2009086210 A
- WO 2008063609 A
- WO 2009115553 A
- WO 2009098250 A
- WO 2009000756 A
- WO 2009091670 A
- WO 2007146250 A
- WO 2009098253 A
- WO 2010012710 A
- JP 2012126227 A
- JP 2012214659 A


### Non-patent literature cited in the description


- *IEEE Electron Device Letters,* 2010, vol. 31, 311
- *Appl. Phys. Lett.,* 2008, vol. 92, 253301
- *Sol. Energy Mater. Sol. Cells,* 2010, vol. 94, 2018
- *Org. Electronics,* 2012, vol. 13, 1136
- *J. Mater. Res.,* 2004, vol. 19, 651
- Handbook for Physicochemical Experiment. Kagaku-Dojin Publishing Company, INC, 1993
- *Applied Physics,* 2012, vol. 81, 728
- *JIS K5600-5-4,* 1999
- **S. M. SZE.** Physics of Semiconductor Devices. Wiley Interscience, 1981
- Handbook of Conducting Polymers. 2007
- *Materials Science and Engineering,* 2001, vol. 32, 1-40
- *Pure Appl. Chem.,* 2002, vol. 74, 2031-3044
- Handbook of THIOPHENE-BASED MATERIALS. 2009
- *J. Am. Chem. Soc.,* 2008, vol. 130 (46), 15429-15436
- *J. Am. Chem. Soc.,* 1993, vol. 115, 9798-9799
- *Chem. Mater.,* 2007, vol. 19, 5363-5372
- *Chem. Mater.,* 2007, vol. 19, 5194-5199
- *Angew. Chem. Int. Ed. Engl.,* 1993, vol. 32, 78-80
- *Tetrahedron Lett.,* 1997, vol. 38, 285-288
- *J. Chem. Soc., Perkin Trans. 1,* 1997, 1595
- *Thin Solid Films,* 2005, vol. 489, 251-256
- *Adv. Funct. Mater.,* 2005, vol. 15, 1979-1987
- *J. Org. Chem.,* 1995, vol. 60, 532-538
- *JIS K6854-3,* 1999